(19) Europäisches Patentamt
European Patent Office
Office européen des brevets

(11) EP 1 153 952 A1

(12) **EUROPEAN PATENT APPLICATION**
published in accordance with Art. 158(3) EPC

(43) Date of publication:
**14.11.2001 Bulletin 2001/46**

(21) Application number: **00981684.4**

(22) Date of filing: **13.12.2000**

(51) Int Cl.7: **C08G 59/62**, C08G 59/40, C08L 63/00, G02F 1/1339

(86) International application number:
**PCT/JP00/08814**

(87) International publication number:
**WO 01/44342 (21.06.2001 Gazette 2001/25)**

(84) Designated Contracting States:
**AT BE CH CY DE DK ES FI FR GB GR IE IT LI LU MC NL PT SE TR**

(30) Priority: **14.12.1999 JP 35384699**
**16.06.2000 JP 2000180661**

(71) Applicant: **Mitsui Chemicals, Inc.**
**Tokyo 100-6070 (JP)**

(72) Inventors:
- **KITAMURA, Tadashi**
**Hiratsuka-shi, Kanagawa 259-1212 (JP)**
- **MAEDA, Sunao**
**Ichihara-shi, Chiba 299-0125 (JP)**

(74) Representative: **Nicholls, Kathryn Margaret et al**
**MEWBURN ELLIS**
**York House**
**23 Kingsway**
**London WC2B 6HP (GB)**

(54) **SEALING AGENT FOR LIQUID-CRYSTAL DISPLAY CELL, COMPOSITION FOR SEALING AGENT FOR LIQUID-CRYSTAL DISPLAY CELL, AND LIQUID-CRYSTAL DISPLAY ELEMENT**

(57) A sealant for a liquid crystal display cell which has a water absorption coefficient of 2 mass % or less, and a composition for a liquid crystal display cell sealant comprising an epoxy resin (1), a curing agent (2) comprising at least one selected from polyphenol compounds, polyphenol resins and esterified products thereof and a curing accelerator (3) comprising at least one selected from alkylurea derivatives and phosphazene compounds. A liquid crystal display element produced by using the composition is capable of securing long time display (quality) stability under high temperature and high humidity.

EP 1 153 952 A1

**Description**

Technical Field

The present invention relates to a sealant for a liquid crystal display cell, a composition for a liquid crystal display cell sealant, a liquid crystal display element and a production process for the same.

Background Art

In recent years, a liquid crystal display panel having characteristics of a light weight and a thin size has come to be widely used as display panels for various devices including a personal computer. A situation for using it has become severe, and large-sized, homogeneous, high quality liquid crystal elements have been desired.
A composition for a liquid crystal display cell sealant means a thermosetting resin composition used for forming a cell which is prepared by charging liquid crystal between transparent glass substrates or transparent plastic substrates suitably provided with a transparent electrode and an alignment layer which are important as members for constituting a liquid crystal display cell and sealing it off so that it does not leak outsides. Further, a sealant for a liquid crystal display cell means a cured matter of a composition for a liquid crystal display cell sealant.
Proposed are, for example, single liquid type thermosetting compositions for a liquid crystal display cell sealant comprising an epoxy resin as a main component and a dihydrazide base curing agent and suitably containing a solvent. These compositions satisfy fundamental performances for sealing characteristics of a liquid crystal cell, that is, an adhesive sealing property under a normal state, a heat resistance, an electric insulating property and a property not to stain liquid crystal, but the current situation is that strongly required is a high quality and high durability composition for a liquid crystal display cell sealant which makes it possible to further elevate a display quality of a liquid crystal display element under high temperature and high humidity. That is, required in recent years is a liquid crystal display element which is excellent particularly in high quality and high durability. In addition thereto, a composition for a liquid crystal display cell sealant which can meet a production process for a liquid crystal display element by a single layer hot press adhesion system is eagerly desired to be developed from a standpoint of securing reliability of a liquid crystal display element.
In this case, the high quality means that display is of high definition and free of disturbance and that a display function is secured up to the vicinity of the sealed edge. Further, the durability means that a display function of the above display element can be secured for a long period of time even under a severe environment.
Under such social background as described above, a subject to be solved is to investigate physical properties which are indispensable to a sealant for a liquid crystal display cell which makes it possible to produce a higher quality and higher durability liquid crystal display element than ever and to provided a novel composition for a liquid crystal display cell sealant. More specifically, it is to provide a composition for a sealant which makes it possible to produce a liquid crystal display panel maintaining stably the function of a liquid crystal display element for long time even under a high temperature and high humidity environment and which can meet a hot press adhesion system of a vacuum single layer type or a normal single layer type as well as a multistage hot press system, particularly to provide a novel composition for a liquid crystal display cell sealant in which a concentration of free ions originating in the composition is small and a cured matter thereof is rich in a steam gas barrier property (low moisture permeability) though it is a matter of course that a cured matter of the composition for a sealant has a low water-absorbing property and which has high rigidity and high toughness and is excellent in adhesion-sealing durability, a property not to stain liquid crystal and particularly dimension stability and to provide a production process for a liquid crystal display element using the above composition for a liquid crystal display cell sealant, and this requires investigation of the physical properties which are essential for a high durability sealant for a liquid crystal display cell.

Disclosure of the Invention

Intensive investigations repeated by the present inventors have resulted in finding that the subjects described above can be achieved by an epoxy resin composition comprising an epoxy resin, a specific curing agent, a specific curing accelerator, if necessary, a specific rubber-like polymer fine particle, an inorganic filler, a silane coupling agent, and further if necessary, a specific solvent, a specific high softening point-acryl polymer fine particle, a specific conductive bead and a specific gap-forming controller each in an amount falling in a specific range. Thus, the present invention has been completed.
That is, the present invention comprises the following items (1) to (21):

(1) A sealant for a liquid crystal display cell comprising a cured matter of a composition for a liquid crystal display cell sealant, wherein the above cured matter has a water absorption coefficient of 2 mass % or less.

(2) The sealant for a liquid crystal display cell as described in the above item (1), wherein the moisture permeability in passing through the cured film having a thickness of 100 μm at80°C is 200 g/m$^2$·24 hours or less.

(3) The sealant for a liquid crystal display cell as described in the above item (1) or (2), wherein the liquid crystal brought into contact with the sealant at 145°C for one hour in a proportion of one mass part of the liquid crystal to 0.1 mass part of the sealant has a specific resistance value which is 250 times or less as large as a specific resistance value of the liquid crystal before brought into contact therewith.

(4) The sealant for a liquid crystal display cell as described in any of the above items (1) to (3), which comprises a cured matter of an epoxy resin, is cured with a curing agent comprising at least one selected from polyphenol compounds, polyphenol resins and esterified products thereof.

(5) The sealant for a liquid crystal display cell as described in the above item (4), wherein a curing accelerator comprising at least one selected from alkylurea derivatives and phosphazene compounds is used.

(6) A composition for a liquid crystal display cell sealant comprising an epoxy resin (1), a curing agent (2) comprising at least one selected from polyphenol compounds, polyphenol resins and esterified products thereof and a curing accelerator (3) comprising at least one selected from alkylurea derivatives and phosphazene compounds.

(7) The composition for a liquid crystal display cell sealant as described in the above item (6), comprising 20 to 88.9 mass parts of the epoxy resin (1), 10 to 50 mass parts of the curing agent (2) comprising at least one selected from polyphenol compounds, polyphenol resins and esterified products thereof and 0.1 to 20 mass parts of the curing accelerator (3) comprising at least one selected from alkylurea derivatives and phosphazene compounds.

(8) The composition for a liquid crystal display cell sealant as described in the above item (6) or (7), wherein an aqueous solution obtained by admixing the composition with the same mass of purified water as that of the composition has an ionic conductivity of 10 mS/m or less.

(9) The composition for a liquid crystal display cell sealant as described in the above item (6) or (7), wherein a cured matter of the composition has a water absorption coefficient of 2 mass % or less.

(10) The composition for a liquid crystal display cell sealant as described in the above item (6) or (7), wherein a moisture permeability in passing through a cured film of the composition having a thickness of 100 μm at 80°C is 200 g/m$^2$·24 hours or less.

(11) The composition for a liquid crystal display cell sealant as described in the above item (6) or (7), wherein the liquid crystal brought into contact with the sealant at 145°C for one hour in a proportion of one mass part of the liquid crystal to 0.1 mass part of the sealant has a specific resistance value which is 250 times or less as large as a specific resistance value of the liquid crystal before brought into contact therewith.

(12) The composition for a liquid crystal display cell sealant as described in the above item (6) or (7), further comprising a rubber-like polymer fine particle which has a softening point of 0°C or lower and in which primary particles thereof have an average particle diameter of 5 μm or less in a proportion of 1 to 25 mass % based on the composition for a liquid crystal display cell sealant.

(13) The composition for a liquid crystal display cell sealant as described in the above item (6) or (7), wherein the curing agent is at least one selected from phenol novolak resins, phenol aralkyl resins, naphthol novolak resins, naphthol aralkyl resins, alicyclic compound-modified phenol novolak resins, alicyclic compound-modified naphthol novolak resins, polycyclic aromatic compound-modified novolak resins, phenol monomers, polyvinylphenols, vinylphenol copolymers, polyisopropenylphenols, polyisopropenylphenol copolymers, esterified phenol novolak resins, esterified phenol aralkyl resins, esterified naphthol novolak resins, esterified naphthol aralkyl resins, esterified alicyclic compound-modified phenol novolak resins, esterified alicyclic compound-modified naphthol novolak resins, esterified polycyclic aromatic compound-modified novolak resins, esterified polyphenol monomers, esterified polyvinylphenols, esterified vinylphenol copolymers, esterified polyisopropenylphenols and esterified polyisopropenylphenol copolymers.

(14) The composition for a liquid crystal display cell sealant as described in the above item (6) or (7), wherein the alkylurea derivative is at least one selected from 3-(p-chlorophenyl)-1,1-dimethylurea, 3-(o,p-dichlorophenyl)-1,1-dimethylurea, 2,4-[bis(1,1-dimethylurea)]toluene and 2,6-[bis(1,1-dimethylurea)]toluene.

(15) The composition for a liquid crystal display cell sealant as described in the above item (6) or (7), wherein the phosphazene compound is at least one compound represented by Formula (12):

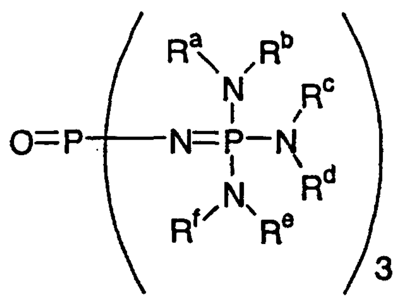

(12)

wherein $R^a$ to $R^f$ each represent a hydrogen atom, a linear, branched or cyclic alkyl group having 1 to 10 carbon atoms or an aryl or aralkyl group having 6 to 10 carbon atoms, and all of them may be the same or different.
(16) A composition for a liquid crystal display cell sealant further comprising 1 to 15 mass parts of a conductive bead based on 100 mass parts of the composition as described in the above item (6) or (7).
(17) A liquid crystal display element prepared by using the sealant for a liquid crystal display cell as described in any of the above items (1) to (5).
(18) A liquid crystal display element obtained by using the composition for a liquid crystal display cell sealant as described any of in the above items (6) to (16).
(19) A production process for a liquid crystal display element comprising any of TN liquid crystal, STN liquid crystal, ferrodielectric liquid crystal and anti-ferrodielectric liquid crystal, comprising the steps of:

printing or dispenser-coating the composition for a liquid crystal display cell sealant as described in any of the above items (6) to (16) on a bonding and sealing part of a glass-made or plastic-made substrate for a liquid crystal cell and precuring it at a temperature of 50 to 120°C,
then adjusting the position and superposing the other paired substrate thereon to temporarily fix them,
subjecting the paired substrates to hot cramping treatment at 80 to 200°C to bond and fix the above paired substrates in a homogeneous thickness falling in a range of 1 to 7 μm to form a liquid crystal display cell, and
then charging a liquid crystal material into the above cell and sealing the injection port with a photocuring type liquid crystal sealant composition or a two-liquid type liquid crystal sealant composition.

(20) A production process for a liquid crystal display element comprising any of TN liquid crystal, STN liquid crystal, ferrodielectric liquid crystal and anti-ferrodielectric liquid crystal, comprising the steps of:

printing or dispenser-coating the composition for a liquid crystal display cell sealant as described in any of the above items (6) to (16) on a bonding and sealing part of a glass-made or plastic-made substrate for a liquid crystal cell and precuring it at a temperature of 50 to 120°C,
then putting dropwise the liquid crystal thereon and superposing the other paired substrate thereon so that air is not shut therein and adjusting the position to temporarily fix them,
subjecting the paired substrates to hot cramping treatment at 80 to 150°C to bond and fix the above paired substrates in a homogeneous thickness falling in a range of 1 to 7 μm, and
then sealing the respiratory port with a photocuring type liquid crystal sealant composition or a two-liquid type liquid crystal sealant composition.

(21) A liquid crystal display element obtained by the production process for a liquid crystal display element as described in the above item (19) or (20).

Best Mode for Carrying Out the Invention

The sealant for a liquid crystal display cell of the present invention is a sealant for a liquid crystal display element and is (a) a sealant for a liquid crystal display cell in which a cured matter thereof has a water absorption coefficient of 2 mass % or less.
In this case, the water absorption coefficient is represented by a rate of weight increase observed after dipping the sealant for a liquid crystal display cell in boiling water for 30 minutes.
The sealant for a liquid crystal display cell of the present invention has preferably, in addition to the property (a) described above, the property (b) that the moisture permeability in passing through the above sealant for a liquid crystal display cell having a thickness of 100 μm at 80°C is 200 g/m$^2$·24 hours or less. The above moisture permeability

per 100 μm is determined by the following conversion equation:

moisture permeability = measured moisture permeability × [(film thickness (μm) of the specimen)/100]

More preferably, (c) the liquid crystal brought into contact with the sealant at 145°C for one hour in a proportion of one mass part of the liquid crystal to 0.1 mass part of the sealant has a specific resistance value which is 250 times or less as larger as a specific resistance value of the liquid crystal before brought into contact therewith.

That is, the sealant for a liquid crystal display cell of the present invention has the property (a) described above and is preferably a sealant for a liquid crystal display cell in which at least one property selected from the properties (b) and (c) is secured together therewith.

It is very important in the sealant for a liquid crystal display cell of the present invention that the cured matter thereof has a water absorption coefficient of 2 mass % or less after dipping in boiling water for 30 minutes. This makes it possible to allow the resulting liquid crystal display element to maintain the display quality in a high level for a long period of time even if used under a severe environment of high temperature and high humidity.

To be more specific, the property (a) described above is one of essential properties which the sealant for a liquid crystal display cell that makes it possible to produce a liquid crystal display element having high quality and high durability has to be provided with. Similarly, the composition for a liquid crystal display cell sealant of the present invention is preferably provided with the property (a) described above as a property of a cured matter thereof.

In the sealant for a liquid crystal display cell of the present invention, the above cured matter has preferably a water absorption coefficient of less 1.7 mass %, more preferably less than 1.3 mass % and particularly preferably less than 0.6 mass % after dipping in boiling water for 30 minutes.

Further, in the sealant for a liquid crystal display cell of the present invention, in addition to the property (a) described above, (b) the moisture permeability at 80°C represented by a permeating amount of moisture passing through the cured film having a thickness of 100 μm for 24 hours under an environment of 80°C and 95 % relative humidity is more preferably 200 $g/m^2 \cdot 24$ hours or less. This makes it possible to allow the resulting liquid crystal display element to secure display quality and an effect of inhibiting a reduction in the response speed under a high temperature and high humidity environment. The moisture permeability at 80°C is more preferably 100 $g/m^2 \cdot 24$ hours or less, particularly preferably 50 $g/m^2 \cdot 24$ hours or less.

Further, in the sealant for a liquid crystal display cell of the present invention, in addition to the property (a) or the properties (a) and (b) described above, (c) the liquid crystal brought into contact with the sealant at 145°C for one hour in a proportion of one mass part of the liquid crystal to 0.1 mass part of the sealant has a specific resistance value which is 250 times or less as large as a specific resistance value of the liquid crystal before brought into contact therewith. This makes it possible to secure display reliability of the resulting liquid crystal display element for a long period of time. It is more preferably 100 times or less, further preferably 50 times or less.

It has been found in the present invention that preferred as the sealant for a liquid crystal display cell satisfying such properties is an epoxy resin cured with a curing agent comprising at least one selected from polyphenol compounds, polyphenol resins and esterified products thereof and in addition thereto, cured by using a curing accelerator comprising at least one selected from alkylurea derivatives and phosphazene compounds. This makes it possible to produce the liquid crystal display element which has high quality and high durability.

Further, the sealant for a liquid crystal display cell of the present invention is particularly preferably a sealant for a liquid crystal display cell having at least one or two or more properties selected from the following properties (d) to (g) in combination with the properties (a) to (c) described above:

(d) the glass transition temperature (Tg) is 85°C or higher,
(e) the linear expansion coefficient at 0 to 80°C which is determined by means of a thermomechanical analyzer (TMA) is $9 \times 10^{-5}$ mm/mm/°C or less,
(f) the shore hardness D at 20°C is 70 or more and
(g) the storage elastic coefficient at 100 to 150°C which is determined by measuring the dynamic viscoelasticity falls in a range of $1 \times 10^5$ to $1 \times 10^8$ Pa.

These characteristics shall be explained in detail.

The glass transition temperature (Tg) determined by means of the thermomechanical analyzer (TMA) is preferably 85°C or higher, and this secures and elevates the stability of display quality of the resulting liquid crystal display element in a high temperature range exceeding 60°C for a long period of time and therefore is preferred. The Tg is more preferably 90°C or higher, and the Tg falls particularly preferably in a range of 100 to 180°C.

If the linear expansion coefficient at 0 to 80°C determined by means of the thermomechanical analyzer (TMA) is $9 \times 10^{-5}$ mm/mm/°C or less, dimensional stability, that is, gap width stability of the resulting liquid crystal display

element can be secured, and therefore that is preferred. It is more preferably less than $7 \times 10^{-5}$ mm/mm/° C, particularly preferably less than $5 \times 10^{-5}$ mm/mm/°C.

Further, the storage elastic coefficient at 100 to 150°C which is determined by measuring the dynamic viscoelasticity falls preferably in a range of $1 \times 10^5$ to $1 \times 10^8$ Pa. If the above storage elastic coefficient is $1 \times 10^5$ Pa or more, seal rigidity of the resulting liquid crystal display element can be secured when exposed to, for example, a high temperature of 60 to 80°C, and therefore it is preferred. On the other hand, if it is set to less than $1 \times 10^8$ Pa, the sealing layer is rich in toughness, and the resulting liquid crystal display element is excellent in high durability.

Further, in the sealant for a liquid crystal display cell of the present invention, the cured matter has preferably a 20°C shore hardness D of 70 or more. This makes it possible to allow the resulting liquid crystal display cell to secure shear adhesive force at a high level.

The properties shown in (d) to (g) described above can be achieved by further adding, if necessary, an inorganic filler and a rubber-like polymer fine particle with the amount ratio thereof changing, to the epoxy resin, the curing agent comprising at least one selected from polyphenol compounds, polyphenol resins and esterified products thereof and a curing accelerator comprising at least one selected from alkylurea derivatives and phosphazene compounds.

Next, the composition for a liquid crystal display cell sealant of the present invention is a composition for a liquid crystal display cell sealant comprising an epoxy resin (1), a curing agent (2) comprising at least one selected from polyphenol compounds, polyphenol resins and esterified products thereof and a curing accelerator (3) comprising at least one selected from alkylurea derivatives and phosphazene compounds. Further, addition of, if necessary, an inorganic filler, a silane coupling agent, a rubber-like polymer fine polymer and a solvent has made it possible to increase properties related to a cured matter of a thermosetting composition for a liquid crystal display cell sealant which have not so far been achieved, that is, the functions such as a water absorption coefficient of 2 mass % or less and a moisture permeability of 200 $g/m^2 \cdot 24$ hours or less at as well as characteristics required fundamentally for a sealant composition for a display cell having high quality and high durability, such as a primary adhesion sealing property, a property not to stain liquid crystal and a balance between toughness and heat resistant rigidity.

The cured matter of the composition for a liquid crystal display cell sealant of the present invention has a water absorption coefficient of 2 mass % or less, preferably less than 1.7 mass % after dipped in boiling water for 30 minutes. This makes it possible to allow the resulting liquid crystal display element to maintain display quality in a high level for a long period of time even if used under a severe environment of high temperature and high humidity. The above cured matter has preferably a water absorption coefficient of less than 1.3 mass %, particularly preferably less than 0.6 mass % after dipped in boiling water for 30 minutes.

Further, in the composition for a liquid crystal display cell sealant of the present invention, the moisture permeability at 80°C represented by a permeating amount of water vapor passing through the cured film having a thickness of 100 μm for 24 hours under an environment of 80°C and 95 % relative humidity is more preferably 200 $g/m^2 \cdot 24$ hours or less. This makes it possible to secure the display quality and an effect of inhibiting a reduction in the response speed under a high temperature and high humidity environment. The moisture permeability at 80°C is more preferably 100 $g/m^2 \cdot 24$ hours or less, particularly preferably 50 $g/m^2 \cdot 24$ hours or less.

Further, in the composition for a liquid crystal display cell sealant of the present invention, an aqueous solution obtained by admixing the composition with the same mass of purified water has preferably an ionic conductivity of 10 mS/m or less. The ionic conductivity set to 10 mS/m or less makes it possible to maintain a display function of the liquid crystal display element finally obtained over a long period of time. It is more preferably 2 mS/m or less, particularly preferably 0.2 mS/m or less.

In combination with the requisites described above, in the composition for a liquid crystal display cell sealant of the present invention, the liquid crystal brought into contact with the sealant at 145°C for one hour in a proportion of one mass part of the liquid crystal to 0.1 mass part of a cured matter of the above composition has preferably a specific resistance value which is 250 times or less as large as a specific resistance value (a specific resistance value after treated the liquid crystal alone at 145°C for one hour) of the original liquid crystal. This makes it possible to secure display reliability of the resulting liquid crystal display element and therefore is preferred. It is more preferably 100 times or less, further preferably 50 times or less.

In the composition for a liquid crystal display cell sealant of the present invention, preferred is the resin composition in which a glass transition temperature (Tg) of a cured matter thereof determined by means of TMA (thermomechanical analyzer) is 85°C or higher, and this secures and elevates further more the stability of display quality of the finally obtained liquid crystal display element at a high temperature range exceeding 60°C for a long period of time and therefore is preferred. The Tg is more preferably 90°C or higher, and the Tg falls particularly preferably in a range of 100 to 180°C.

In the composition for a liquid crystal display cell sealant of the present invention, if the cured matter has a linear expansion coefficient of $9 \times 10^{-5}$ mm/mm/°C or less at 0 to 80°C which is determined by means of the thermomechanical analyzer (TMA), dimensional stability, that is, gap width stability of the resulting liquid crystal display element can be secured, and therefore that is preferred. It is more preferably less than $7 \times 10^{-5}$ mm/mm/°C, particularly pref-

erably less than $5 \times 10^{-5}$ mm/mm/°C.

Further, in the composition for a liquid crystal display cell sealant of the present invention, an exothermic initiation temperature determined from a thermogram obtained by differential scanning calorimetry (DSC) in which 10 mg of the uncured composition is heated at a constant rate of 5°C/minute falls preferably in a range of 50 to 130°C. If the above exothermic initiation temperature is 50°C or higher, the viscosity stability can be secured in handling the resulting composition for a liquid crystal display cell sealant in the vicinity of room temperature, and the temperature controlled to lower than 130°C can secure the quick curing property at a low temperature in applying to a single layer hot press adhesion system.

Further, in the composition for a liquid crystal display cell sealant of the present invention, a maximum exothermic peak temperature determined from a thermogram obtained by differential scanning calorimetry (DSC) in which 10 mg of the uncured composition is heated at a constant rate of 5°C/minute is preferably 100 to 180°C. If the above exothermic peak temperature is 100°C or higher, the quick curing property at a low temperature can be secured in applying to a single layer hot press adhesion system, and if it is lower than 180°C, the production conditions of the liquid crystal display element can be prevented from becoming severer than needed.

Further, in the composition for a liquid crystal display cell sealant of the present invention, the cured matter has very preferably a 20°C shore hardness D of 70 or more. This makes it possible to allow the resulting liquid crystal display cell to secure shear adhesive force at a high level and therefore is preferred.

Further, in the composition for a liquid crystal display cell sealant of the present invention, the storage elastic coefficient at 100 to 150°C which is determined by measuring a dynamic viscoelasticity of the cured matter falls preferably in a range of $1 \times 10^5$ to $1 \times 10^8$ Pa. If the above storage elastic coefficient is $1 \times 10^5$ Pa or more, seal rigidity of the resulting liquid crystal display element can be secured when exposed to a high temperature of, for example, 60 to 80°C. On the other hand, if it is controlled to less than $1 \times 10^8$ Pa, the sealing layer is rich in toughness, and the resulting liquid crystal display element is excellent in high durability.

In the properties related to the composition for a liquid crystal display cell sealant described above, the properties such as Tg, a shore hardness D, an elastic coefficient and a linear expansion coefficient can be achieved by further adding, if necessary, an inorganic filler and a rubber-like polymer fine particle with the amount ratio thereof changing, to the epoxy resin, the curing agent comprising at least one selected from polyphenol compounds, polyphenol resins and esterified products thereof and the curing accelerator comprising at least one selected from alkylurea derivatives and phosphazene compounds.

Though specifically be restricted, for example, Tg depends strongly on the kind and the amount ratio of the epoxy resin, the kind and the amount ratio of the curing agent described above and the curing conditions. The shore hardness D depends strongly on the kind and the amount ratio of the epoxy resin, the kind and the amount ratio of the curing agent described above, the curing conditions and the amount ratio of the filler. The elastic modulus depends strongly on the kind and the amount ratio of the epoxy resin, the kind and the amount ratio of the curing agent described above, the amount ratio of the rubber and the curing conditions. The linear expansion coefficient depends strongly on the amount ratio of the inorganic filler and the curing conditions. Taking the facts described above into consideration, the above properties of the composition for a liquid crystal display cell sealant of the present invention can be achieved by selecting or settling the amount ratios and the curing conditions so that they fall in the preferred ranges respectively.

Further, in the composition for a liquid crystal display cell sealant of the present invention, a so-called B stage-reduced composition obtained after heat treating at 80°C for 20 minutes, the above composition coated in a thickness of 50 µm has a viscosity falling preferably in a range of 5 to 1000 Pa·s by an E type viscometer at 90°C. This allows the above composition to function as a sealant capable of sufficiently meeting various single layer type hot press adhesion systems which are supposed to exhibit high productivity as well as a multistage hot press adhesion system, and therefore such a viscosity is preferred. To be more specific, a viscosity of over 5 Pa·s by an E type viscometer in the B stage-reduced composition can inhibit through-bubbles from being produced in single layer type hot press adhesion. On the other hand, the viscosity controlled to 1000 Pa·s or less by an E type viscometer at 90°C makes it possible to control the desired gap in single layer type hot press adhesion and such a viscosity therefore is preferred. The viscosity by an E type viscometer at 90°C falls more preferably in a range of 10 to 500 Pa·s, particularly preferably 20 to 100 Pa·s.

In order to satisfy the characteristics described above, the composition for a liquid crystal display cell sealant of the present invention is preferably an epoxy resin composition prepared by blending the curing agent comprising at least one selected from polyphenol compounds, polyphenol resins and esterified products thereof so that an active phenolic hydroxyl group of the curing agent and/or an ester-modified group thereof fall in a range of 0.5 to 1.2 equivalent, preferably 0.7 to 1.1 equivalent and particularly preferably 0.85 to 1 equivalent per one equivalent of an epoxy group of the epoxy resin and adding the curing accelerator comprising at least one selected from alkylurea derivatives and phosphazene compounds in a range of 0.1 to 20 mass %, preferably 0.1 to 10 mass %.

The most preferred composition for a liquid crystal display cell sealant of the present invention includes a composition prepared by adding the rubber-like polymer fine particle which has a softening point of 0°C or lower and

in which primary particles thereof have an average particle diameter of 5 µm or less in a proportion of 1 to 25 mass % based on the composition for a liquid crystal display cell sealant. This makes it possible to produce a liquid crystal display element having high quality and high durability in a good yield and secure profitability and high productivity. Further, not only the resulting liquid crystal display element is excellent in a balance between heat resistance and cold resistance but also the liquid crystal display element which is excellent in sealing reliability against an impact can be provided.

More preferred embodiment of the composition for a liquid crystal display cell sealant of the present invention is an epoxy resin composition comprising:

(1) 20 to 88.9 mass % of the epoxy resin,
(2) 10 to 50 mass % of the curing agent comprising at least one selected from polyphenol compounds, polyphenol resins and esterified products thereof (hereinafter generally call merely a polyphenol curing agent),
(3) 0.1 to 10 mass % of the curing accelerator comprising at least one selected from alkylurea derivatives and phosphazene compounds and
(4) 1 to 25 mass % of the rubber-like polymer fine particle which has a softening point of 0°C or lower and in which primary particles thereof have an average particle diameter of 5 µm or less.

More preferably, included is a composition for a liquid crystal display cell sealant comprising:

(1) 20 to 83.8 mass % of the epoxy resin,
(2) 10 to 45 mass % of the polyphenol curing agent,
(3) 0.1 to 5 mass % of the curing accelerator comprising at least one selected from alkylurea derivatives and phosphazene compounds,
(4) 1 to 15 mass % of the rubber-like polymer fine particle which has a softening point of 0°C or lower and in which primary particles thereof have an average particle diameter of 5 µm or less,
(5) 5 to 45 mass % of the inorganic filler and
(6) 0.1 to 5 mass % of the silane coupling agent.

Further, included as well in the composition for a liquid crystal display cell sealant of the present invention is a composition for a liquid crystal display cell sealant which further comprises suitably, if necessary, as long as the working effects thereof are not damaged, (7) a solvent which is compatible with the epoxy resin and which has a boiling point falling in a range of 150 to 220°C and is inactive to an epoxy group, (8) a high softening point-acryl polymer fine particle (hereinafter referred to as merely a high softening point-polymer fine particle) which has a softening point of 50°C or higher and in which primary particles thereof have an average particle diameter of 2 µm or less, (9) a gap-forming controller, (10) a conductive bead and (11) a wax, a leveling agent, a pigment, a dye, a plasticizer, a defoaming agent and other additives.

The components of the composition for a liquid crystal display cell sealant of the present invention shall specifically be explained below in order.

(1) Epoxy resin

The epoxy resin (1) used for the present invention shall not specifically be restricted, and used therefor is a mixture of a monofunctional epoxy resin and a multifunctional epoxy resin or a multifunctional epoxy resin alone or a mixture thereof. Used is, for example, at least one selected from the group of a cresol novolak type epoxy resin, a bisphenol A type epoxy resin, a bisphenol F type epoxy resin, a triphenolmethane type epoxy resin and a triphenolethane type epoxy resin. The mixture may be a mixture of the same kind or different kinds of the resins.

The epoxy resin is preferably an epoxy resin having 1.7 or more epoxy groups, more preferably 1.9 or more epoxy groups and particularly preferably 2.0 or more and 6 or less epoxy groups on a mass average in a molecule. The epoxy group set to 1.7 or more groups elevates the heat resistance.

In the epoxy resin (1) of a single resin or a mixture of plural kinds of resins , an ionic conductivity of an aqueous solution obtained by admixing the epoxy resin with the same mass of purified water is controlled preferably to 10 mS/m or less, more preferably 5 mS/m or less, further preferably 2 mS/m or less and particularly preferably within a measuring limit, whereby a free ion can be inhibited from being transferred into a liquid crystal phase in bringing the cured matter of the composition for a liquid crystal display cell sealant of the present invention into contact with the liquid crystal. When using two or more kinds of the epoxy resins of different kinds, the requisite described above may be satisfied for the sum of the contents of free ions contained in the mixture.

In the epoxy resin (1), preferably 300 ppm or less is a hydrolytic chlorine concentration in the epoxy resin, which is determined by converting a chlorine ion concentration in water obtained by subjecting the epoxy resin to

extracting in boiling water for 24 hours. If the hydrolytic chlorine concentration is 300 ppm or less, a chlorine ion can be inhibited from being transferred into a liquid crystal phase in bringing the cured matter of the composition for a liquid crystal display cell sealant of the present invention into contact with the liquid crystal. It is more preferably 100 ppm or less, further preferably 50 ppm or less and most preferably within a detection limit of a chlorine ion.

When using two or more kinds of the epoxy resins of different kinds, the requisite described above may be satisfied for the sum of the contents of free chlorine ions contained in the mixture.

The epoxy resin (1) is preferably a mixture of (1-1) an epoxy resin which is liquid at room temperature (25°C) and (1-2) an epoxy resin which is solid at room temperature. More preferably, the above mixture becomes a liquid at 0 to 120°C.

The epoxy resin (1) is a resin having a polystyrene-reduced mass average molecular weight falling preferably in a range of 7000 or less, more preferably 150 to 3000 and most preferably 350 to 2000, which is determined by means of a gel permeation chromatography (hereinafter referred to merely as GPC).

If the polystyrene-reduced mass average molecular weight determined by means of GPC is 7000 or less, a viscosity obtained by an E type viscometer of the composition for a liquid crystal display cell sealant at hot state after B stage-reduced can be controlled to 1000 Pa·s or less, and applicability thereof to a single layer hot press adhesion system can be secured. Accordingly, such a molecular weight is preferred. Further, the polystyrene-reduced mass average molecular weight controlled to 150 or more makes it possible to allow a Tg aptitude of the resulting cured matter to be compatible with a B stage-reduced aptitude, and therefore such a molecular weight is preferred.

The epoxy resin (1) has a content of 20 to 88.9 mass %, preferably 20 to 83.8 mass % based on the composition for a liquid crystal display cell sealant.

In the epoxy resin (1) described below, allowed to be used is a resin which is refined or highly purified in advance by a known hydrolytic chlorine-reducing method and/or a refining method of removing free ions as a principal purpose so that the requisites described above can be satisfied. The known refining method shall not specifically be restricted and includes, for example, a water washing-solvent extraction refining method, a ultrafiltration method and a distillation refining method.

A method for determining the kind and amount of the epoxy resin (1) contained in the composition for a liquid crystal display cell sealant of the present invention shall not specifically be restricted and includes a conventional method in which the resin is subjected to extraction with a solvent and the extract obtained is fractionated and determined by means of GPC and in which the respective fractions are identified and determined by means of NMR (nuclear magnetic resonance spectrum). A method for determining the kind and amount of the epoxy resin (1) contained in the sealant for a liquid crystal display cell which is a cured matter of the above composition shall not specifically be restricted and can be carried out in suitable combination of, for example, an infrared absorption method, a thermal decomposition chromatographic fractionation method, a wet decomposition chromatographic fractionation method, a thermal decomposition gas chromatographic method, a thermal decomposition-mass spectral method and a solid NMR method.

<Monofunctional epoxy resin>

The monofunctional epoxy resin used in the present invention includes, for example, aliphatic monoglycidyl ether compounds, alicyclic monoglycidyl ether compounds, aromatic monoglycidyl ether compounds, aliphatic monoglycidyl ester compounds, aromatic monoglycidyl ester compounds, alicyclic monoglycidyl ester compounds, nitrogen-containing monoglycidyl ether compounds, monoglycidylpropylpolysiloxane compounds and monoglycidylalkanes. It is a matter of course that monofunctional epoxy resins other than these resins may be used.

(Aliphatic monoglycidyl ether compound)

Included are, for example, aliphatic monoglycidyl ether compounds obtained by a reaction of polyoxyalkylene monoalkyl ethers having an alkyl group or alkenyl group having 1 to 6 carbon atoms with epichlorohydrin and aliphatic monoglycidyl ether compounds obtained by a reaction of aliphatic alcohols with epichlorohydrin.

The polyoxyalkylene monoalkyl ethers having an alkyl group or alkenyl group having 1 to 6 carbon atoms include ethylene glycol monoalkyl ethers, diethylene glycol monoalkyl ethers, triethylene glycol monoalkyl ethers, polyethylene glycol monoalkyl ethers, propylene glycol monoalkyl ethers, dipropylene glycol monoalkyl ethers, tripropylene glycol monoalkyl ethers and polypropylene glycol monoalkyl ethers.

The aliphatic alcohols include, for example, n-butanol, isobutanol, n-octanol, 2-ethylhexyl alcohol, dimethylolpropane monoalkyl ethers, methylolpropane dialkyl ethers, glycerin dialkyl ethers, dimethylolpropane monoalkyl esters, trimethylolpropane dialkyl esters and glycerin dialkyl esters.

(Alicyclic monoglycidyl ether compound)

Included are, for example, alicyclic monoglycidyl ether compounds obtained by a reaction of alicyclic alcohols having a saturated cyclic alkane group having 6 to 9 carbon atoms with epichlorohydrin.
The alicyclic alcohols used for the reaction include cyclohexanol and the like.

(Aromatic monoglycidyl ether compound)

Included are, for example, aromatic monoglycidyl ether compounds obtained by a reaction of aromatic alcohols with epichlorohydrin.
The aromatic alcohols used for the reaction include phenol, methylphenol, ethylphenol, n-propylphenol, isopropylphenol, n-butylphenol, benzyl alcohol, t-butylphenol, xylenol and naphthol.

(Aliphatic or aromatic monoglycidyl ester compound)

Included are, for example, aliphatic monoglycidyl ester compounds or aromatic monoglycidyl ester compounds obtained by a reaction of aliphatic dicarboxylic acid monoalkyl esters or aromatic dicarboxylic acid monoalkyl esters with epichlorohydrin.

<Multifunctional epoxy resin>

The multifunctional epoxy resin is an epoxy resin having usually 2 to 6 epoxy groups on a mass average in a molecule, but epoxy resins having more epoxy groups can be used as well as long as the effects of the present invention are not damaged. The multifunctional epoxy resin includes, for example, aliphatic polyglycidyl ether compounds, aromatic polyglycidyl ether compounds, trisphenol type polyglycidyl ether compounds, hydroquinone type polyglycidyl ether compounds, resorcinol type polyglycidyl ether compounds, aliphatic polyglycidyl ester compounds, aromatic polyglycidyl ester compounds, aliphatic polyglycidyl etherester compounds, aromatic polyglycidyl etherester compounds, alicyclic polyglycidyl ether compounds, aliphatic polyglycidyl amine compounds, aromatic polyglycidyl amine compounds, hydantoin type polyglycidyl compounds, biphenyl type polyglycidyl compounds, novolak type polyglycidyl ether compounds and epoxidized diene polymers.
It goes without saying that multifunctional epoxy resins other than these compounds can be used as well.

(Aliphatic polyglycidyl ether compound)

Included are, for example, aliphatic polyglycidyl ether compounds obtained by a reaction of polyoxyalkylene glycols or polyhydric alcohols with epichlorohydrin.
The polyoxyalkylene glycols used for the reaction include, for example, ethylene glycol, diethylene glycol, triethylene glycol, polyethylene glycol, propylene glycol, dipropylene glycol, tripropylene glycol and polypropylene glycol.
The polyhydric alcohols used for the reaction include dimethylolpropane, trimethylolpropane, spiroglycol and glycerin.

(Aromatic polyglycidyl ether compound)

Included are, for example, aromatic polyglycidyl ether compounds obtained by a reaction of aromatic diols with epichlorohydrin.
The aromatic diols used for the reaction include, for example, bisphenol A, bisphenol S, bisphenol F and bisphenol AD.

(Trisphenol type polyglycidyl ether compound)

Included are, for example, trisphenol type polyglycidyl ether compounds obtained by a reaction of trisphenols with epichlorohydrin.
The trisphenols used for the reaction include 4,4',4"-methylidenetrisphenol, 4,4',4"-methylidenetris(2-methylphenol), 4,4'-[(2-hydroxyphenyl)methylene]bis-[2,3,6-trimethylphenol], 4,4',4"-ethylidenetrisphenol, 4,4'-[(2-hydroxyphenyl)methylene]bis[2-methylphenol], 4,4'-[(2-hydroxyphenyl)ethylene]bis[2-methylphenol], 4,4'-[(4-hydroxyphenyl)methylene]bis[2-methylphenol], 4,4'-[(4-hydroxyphenyl)ethylene]bis[2-methylphenol], 4,4'-[(2-hydroxyphenyl)methylene]bis[2,6-dimethylphenol], 4,4'-[(2-hydroxyphenyl)ethylene]bis[2,6-dimethylphenol], 4,4'-[(4-hydroxyphenyl)methylene]bis[2,6-dimethylphenol], 4,4'-[(4-hydroxyphenyl)ethylene]bis[2,6-dimethylphenol], 4,4'-[(2-hydroxyphenyl)methylene]bis[3,5-dimethylphenol], 4,4'-[(2-hydroxyphenyl)ethylene]bis[3,5-dimethylphenol], 4,4'-[(3-hydroxyphenyl)methylene]bis[2,3,6-trimethyl-phenol], 4,4'-[(4-hydroxyphenyl)methylene]bis[2,3,6-trimethylphenol], 4,4'-[(2-hydroxyphenyl) methylene]bis-[2-cyclohexyl-5-methylphenol], 4,4'-[(3-hydroxyphenyl)-methylene]bis-[2-cyclohexyl-5-methylphenol], 4,4'-[(4-hydroxyphenyl)methylene]bis[2-cyclohexyl-5-methylphenol], 4,4'-[1-[4-[1-(4-hydroxyphenyl)-1-methylethyl] phenol-ethylidene]bisphenol, 4,4'-[(3,4-dihydroxyphenyl)-methylene]bis[2-methylphenol], 4,4'-[(3,4-dihydroxyphenyl) methylene]bis[2,6-dimethylphenol], 4,4'-[(3,4-dihydroxyphenyl)methylene]bis[2,3,6-trimethylphenol] and 4-[bis(3-cyclohexyl-4-hydroxy-6-methylphenyl)methyl]-1,2-benzenediol.

(Hydroquinone type polyglycidyl ether compound)

Included are, for example, hydroquinone type polyglycidyl ether compounds obtained by a reaction of hydroquinone with epichlorohydrin.

(Resorcinol type polyglycidyl ether compound)

Included are, for example, resorcinol type polyglycidyl ether compounds obtained by a reaction of resorcinol with epichlorohydrin.

(Aliphatic polyglycidyl ester compound)

Included are, for example, aliphatic polyglycidyl ester compounds obtained by a reaction of aliphatic dicarboxylic acids represented by adipic acid with epichlorohydrin.

(Aromatic polyglycidyl ester compound)

Included are, for example, aromatic polyglycidyl ester compounds obtained by a reaction of aromatic dicarboxylic acids with epichlorohydrin.
The aromatic dicarboxylic acids used for the reaction include, for example, isophthalic acid, terephthalic acid and pyromellitic acid.

(Aliphatic or aromatic polyglycidyl etherester compound)

Included are aliphatic polyglycidyl etherester compounds or aromatic polyglycidyl etherester compounds obtained by a reaction of hydroxydicarboxylic acid compounds with epichlorohydrin.

(Alicyclic polyglycidyl ether compound)

Included are, for example, alicyclic polyglycidyl ether compounds represented by dicyclopentadiene type polyglycidyl ether compounds.

(Aliphatic polyglycidyl amine compound)

Included are, for example, aliphatic polyglycidyl amine compounds obtained by a reaction of aliphatic diamines represented by ethylenediamine and the like with epichlorohydrin.

(Aromatic polyglycidyl amine compound)

Included are, for example, aromatic polyglycidyl amine compounds obtained by a reaction of aromatic amines represented by diaminodiphenylmethane, aniline and metaxylilenediamine with epichlorohydrin.

(Hydantoin type polyglycidyl compound)

Included are, for example, hydantoin type polyglycidyl compounds obtained by a reaction of hydantoin and derivatives thereof with epichlorohydrin.

(Novolak type polyglycidyl ether compound)

Included are, for example, novolak type polyglycidyl ether compounds obtained by a reaction of epichlorohydrin with novolak resins derived from formaldehyde and aromatic alcohols represented by phenol, cresol and naphthol.
Further, included in representative examples thereof are, for example, modified novolak type polyglycidyl ether compounds obtained by a reaction of epichlorohydrin with modified aralkyl resins which are derived from phenol and/or naphthol and p-xylylenedichloride and in which a phenol nucleus and/or naphthol nucleus and a paraxylene nucleus are bonded through a methylene bond.

(Epoxidized diene polymer)

Included are, for example, epoxidized polybutadiene and epoxidized polyisoprene.

(2) Polyphenol curing agent

The polyphenol curing agent (2) used in the composition for a liquid crystal display cell sealant of the present invention is a curing agent comprising a polyphenol compound, a polyphenol resin and esterified compounds thereof.
In the polyphenol curing agent (2), a curing agent having an ionic conductivity of 2 mS/m or less in an aqueous solution prepared by mixing the curing agent with purified water of a large mass ten times the mass of the curing agent is selected and used. This can prevent free ions from moving unnecessarily to a liquid crystal phase when a cured matter of the composition for a liquid crystal display cell sealant of the present invention is brought into contact with the liquid crystal. The ionic conductivity is controlled preferably to 1 mS/m or less, more preferably 0.2 mS/m or less. Selected and used, though not specifically be restricted, is the curing agent (2) having a softening point of 30°C or higher, preferably 75°C or higher and more preferably 75°C or higher and lower than 180°C which is determined by a ring and ball method prescribed in JIS K7234. Use of the polyphenol curing agent having a high softening point makes it possible to elevate hardness, Tg, an elastic modulus and heat resistance of the resulting sealant for a liquid crystal display cell, and therefore it is preferred. The curing agent has a polystyrene-reduced mass average molecular weight falling in a range of 300 to 10000, preferably 500 to 7500 which is determined by GPC.
In the composition for a liquid crystal display cell sealant of the present invention, with respect to a preferred blending equivalent ratio of the polyphenol curing agent, an active phenolic hydroxyl group of the polyphenol curing agent and/or an ester-modified group thereof fall, as described above, in a range of 0.5 to 1.2 equivalent, preferably 0.7 to 1.1 equivalent and particularly preferably 0.85 to 1 equivalent per equivalent of epoxy group in the epoxy resin. The ratio of 0.5 equivalent or more and less than 1.2 equivalent makes it possible to produce a liquid crystal display element having high quality and high durability by using the the resulting composition for a liquid crystal display cell sealant or the sealant for a liquid crystal display cell which is the cured matter thereof.
The polyphenol curing agent (2) shall not specifically be restricted and is represented by, for example, the following (2-1-a) to (2-12-a) and/or (2-1-b) to (2-12-b):

(2-1-a) phenol novolak resin
(2-2-a) phenol aralkyl resin
(2-3-a) naphthol novolak resin
(2-4-a) naphthol aralkyl resin
(2-5-a) alicyclic compound-modified phenol novolak resin
(2-6-a) alicyclic compound-modified naphthol novolak resin
(2-7-a) polycyclic aromatic compound-modified novolak resin
(2-8-a) polyphenol monomer
(2-9-a) polyvinylphenol
(2-10-a) vinylphenol copolymer
(2-11-a) polyisopropenylphenol
(2-12-a) polyisopropenylphenol copolymer
(2-1-b) esterified phenol novolak resin
(2-2-b) esterified phenol aralkyl resin
(2-3-b) esterified naphthol novolak resin
(2-4-b) esterified naphthol aralkyl resin
(2-5-b) esterified alicyclic compound-modified phenol novolak resin
(2-6-b) esterified alicyclic compound-modified naphthol novolak resin
(2-7-b) esterified polycyclic aromatic compound-modified novolak resin
(2-8-b) esterified polyphenol monomer

(2-9-b) esterified polyvinylphenol
(2-10-b) esterified vinylphenol copolymer
(2-11-b) esterified polyisopropenylphenol
(2-12-b) esterified polyisopropenylphenol copolymer

The polyphenol curing agent is at least one or two or more selected from (2-1-a) to (2-12-a) and/or (2-1-b) to (2-12-b), preferably at least one or two or more selected from (2-1-a) to (2-7-a) and/or (2-1-b) to (2-7-b). Given as more preferred polyphenol curing agent are at least one or two or more selected from (2-1-a) to (2-2-a) and/or (2-1-b) to (2-2-b), particularly preferably at least one selected from (2-1-b) to (2-2-b).

(2-1-a) the phenol novolak resin and (2-1-b) esterified phenol novolak resin thereof;

They are represented by the following chemical formula (1):

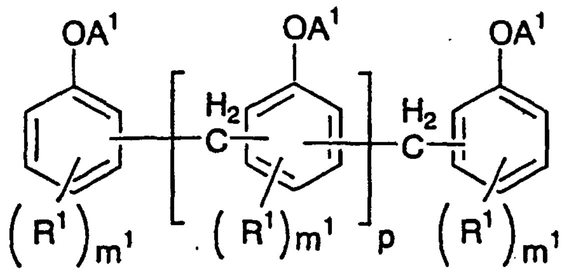

(1)

wherein $A^1$ represents a hydrogen atom, an aromatic acyl group or an aliphatic acyl group; $R^1$ represents a hydrogen atom, a halogen atom, a hydroxyl group, a linear, branched or cyclic alkyl group having 1 to 10 carbon atoms, an alkoxy group having 1 to 10 carbon atoms or a phenyl group and may be the same or different; $m^1$ represents an integer of 1 to 3 and may be the same or different; a repetitive unit number p is an integer falling in a range of 0 to 100; and when p is 0, the formula represents a bisphenol derivative.

The phenol novolak resin (2-1-a) is represented by the resin in which $A^1$ in the formula is a hydrogen atom. On the other hand, the esterified phenol novolak resin (2-1-b) is represented by the resin in which $A^1$ in the chemical formula (1) is a hydrogen atom, an aromatic acyl group or an aliphatic acyl group and all of $A^1$ are not hydrogen atoms and in which a mole ratio of hydrogen atom/acyl group falls in a range of 90/10 to 0/100.

Preferred specific examples of the phenol novolak resin (2-1-a) shall not specifically be restricted and are represented by, for example, those obtained by addition-condensation of the following phenols and formaldehyde under an acidic condition, and preferred are those having a softening point of 50°C or higher, preferably 75°C or higher which is determined by a ring and ball method.

Preferred examples of the phenols described above include, for example, at least one selected from phenol, cresol, xylenol, hydroquinone, methylhydroquinone, catechol, resorcin, ethylphenol, diethylphenol, n-propylphenol, isopropylphenol, n-butylphenol, t-butylphenol, 2-ethylhexylphenol and phenylphenol. Phenol and/or cresol are more preferred.

Specific examples of the esterified phenol novolak resin (2-1-b) include those obtained by modifying 10 to 100 mole % of the phenolic hydroxyl groups contained in the phenol novolak resins described above with aromatic and/or aliphatic acyl groups.

In the composition for a liquid crystal display cell sealant of the present invention, the polyphenol curing agent (2) is preferably the phenol novolak resin (2-1-a) and/or the esterified phenol novolak resin (2-1-b) described above. More preferred polyphenol curing agent is a mixture falling in a range of 1 : 99 to 99 : 1, particularly preferably 10 : 90 to 99 : 1 in terms of a mixing mass ratio of the phenol novolak resin (2-1-a) to the esterified phenol novolak resin (2-1-b).

(2-2-a) phenol aralkyl resin) and (2-2-b) esterified phenol aralkyl resin thereof;

They are represented by the following chemical formula (2):

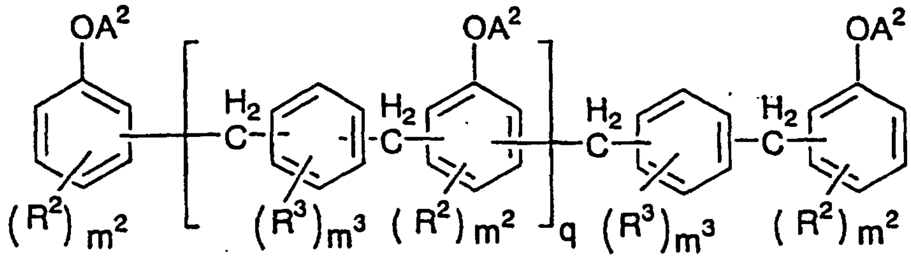

(2)

wherein $A^2$ represents a hydrogen atom, an aromatic acyl group or an aliphatic acyl group; $R^2$ represents a hydrogen atom, a halogen atom, a hydroxyl group, a linear, branched or cyclic alkyl group having 1 to 10 carbon atoms, an alkoxy group having 1 to 10 carbon atoms or a phenyl group; $R^3$ represents a hydrogen atom or a methyl group, and $R^2$ and $R^3$ may be the same or different respectively; $m^2$ and $m^3$ each represent an integer of 1 to 3 and may be the same or different respectively; a repetitive unit number q is an integer falling in a range of 0 to 100; and when q is 0, the formula represents a bisphenol derivative.

The phenol aralkyl resin (2-2-a) is represented by the resin in which $A^2$ in the formula is a hydrogen atom. On the other hand, the esterified phenol aralkyl resin (2-2-b) is represented by the resin in which $A^2$ in the chemical formula (2) is a hydrogen atom, an aromatic acyl group or an aliphatic acyl group and all of $A^2$ are not hydrogen atoms and in which a mole ratio of hydrogen atom/acyl group falls in a range of 90/10 to 0/100.

Preferred examples of the phenol aralkyl resin (2-2-a) shall not specifically be restricted and include, for example, those derived from the following phenols and xylilenedichloride compounds or xylylenedialkyl ether compounds in the presence of a Friedel-Crafts catalyst and obtained by removing free phenol to 0.01 mass % or less under reduced pressure. More preferred are the phenol aralkyl resins having a softening point falling in a range of 50°C to 120°C which is determined by a ring and ball method.

Preferred examples of the esterified phenol aralkyl resin (2-2-b) include those obtained by modifying 10 to 100 mole % of the phenolic hydroxyl groups contained in the phenol aralkyl resins described above with aromatic and/or aliphatic acyl groups.

Preferred examples of the phenols include, for example, at least one selected from phenol, cresol, xylenol, hydroquinone, methylhydroquinone, catechol, resorcin, ethylphenol, diethylphenol, n-propylphenol, isopropylphenol, n-butylphenol, t-butylphenol, 2-ethylhexylphenol and phenylphenol. Phenol and/or cresol are more preferred.

The xylylenedichloride compounds described above include, for example, 1,2-xylylenedichloride, 1,3-xylylenedichloride, 1,4-xylylenedichloride, 2-methyl-1,3-xylylenedichloride, 3-methyl-1,4-xylylenedichloride, 2,4-dimethyl-1,3-xylylenedichloride, 2,4,5-trimethyl-1,3-xylylenedichloride, 2,3-dimethyl-1,4-xylylenedichloride, 2,3,5-trimethyl-1,4-xylylenedichloride, 2-ethyl-1,3-xylylenedichloride, 2,4-diethyl-1,3-xylylenedichloride, 2,4,5-triethyl-1,3-xylylenedichloride, 2,3-diethyl-1,4-xylylenedichloride and 2,3,5-triethyl-1,4-xylylenedichloride.

The xylylenedialkyl ether compounds include, for example, α, α'-dimethoxy-p-xylene, α, α'-diethoxy-p-xylene, α, α'-dimethoxy-o-xylene, α, α'-diethoxy-o-xylene, α, α'-dimethoxy-m-xylene and α, α'-diethoxy-m-xylene, and α, α'-dimethoxy-p-xylene is preferred.

In the composition for a liquid crystal display cell sealant of the present invention, it is one of the preferred embodiments that the polyphenol resin is the phenol aralkyl resin (2-2-a) and/or the esterified phenol aralkyl resin (2-2-b). Among them, preferred polyphenol resin is a mixture falling in a range of 1 : 99 to 99 : 1, more preferably 10 : 90 to 99 : 1 in terms of a mixing mass ratio of (2-2-a) to (2-2-b).

(2-3-a) naphthol novolak resin and (2-3-b) esterified naphthol novolak resin:

They are represented by the following chemical formula (3):

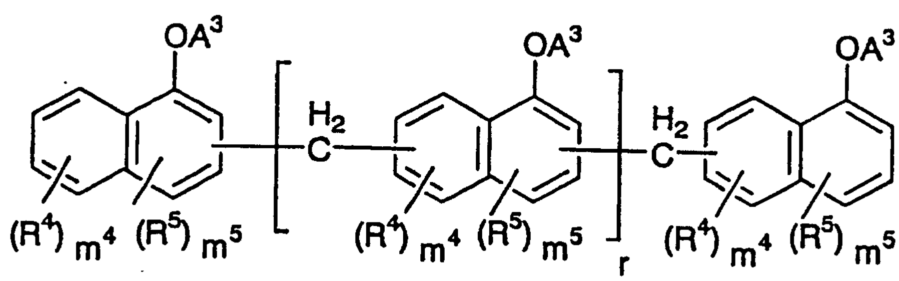

(3)

wherein $A^3$ represents a hydrogen atom, an aromatic acyl group or an aliphatic acyl group; $R^4$ and $R^5$ each represent a hydrogen atom, a halogen atom, a hydroxyl group, a linear, branched or cyclic alkyl group having 1 to 10 carbon atoms, an alkoxy group having 1 to 10 carbon atoms or a phenyl group, and $R^4$ and $R^5$ may be the same or different respectively; $m^4$ and $m^5$ each represent an integer of 1 to 3 and may be the same or different respectively; a repetitive unit number r is an integer falling in a range of 0 to 100; and when r is 0, the formula represents a bisnaphthol derivative.

The naphthol novolak resin (2-3-a) is represented by the resin in which $A^3$ in the formula is a hydrogen atom. On the other hand, the esterified naphthol novolak resin (2-3-b) is represented by the resin in which $A^3$ in the chemical formula (3) is a hydrogen atom, an aromatic acyl group or an aliphatic acyl group and all of $A^3$ are not hydrogen atoms and in which a mole ratio of hydrogen atom/acyl group falls in a range of 90/10 to 0/100.

The naphthol novolak resin (2-3-a) shall not specifically be restricted, and preferred examples thereof include, for example, those obtained by addition-condensation of the following naphthols and formaldehyde under an acidic condition. More preferred are naphthol novolak resins having a softening point of 50°C or higher, preferably 75°C to 150°C which is determined by a ring and ball method.

Preferred examples of the naphthols described above include, for example, at least one selected from α-naphthol, β-naphthol, methylnaphthol, dimethylnaphthol, trimethylnaphthol, methylethylnaphthol, ethylnaphthol, diethylnaphthol, triethylnaphthol, methyldiethylnaphthol, n-propylnaphthol, di-n-propylnaphthol, isopropylnaphthol, diisopropylnaphthol, dihydroxynaphthalene and trihydroxynaphthalene. Naphthol and/or mehylnaphthol are more preferred.

Preferred examples of the esterified naphthol novolak resin (2-3-b) include those obtained by modifying 10 to 100 mole % of the naphtholic hydroxyl groups contained in the naphthol resins described above with aromatic and/or aliphatic acyl groups.

In the composition for a liquid crystal display cell sealant of the present invention, it is one of the preferred embodiments that the polyphenol resin is (2-3-a) and/or (2-3-b). Among them, preferred is a mixture falling in a range of 1 : 99 to 99 : 1, more preferably 90 : 10 to 1 : 99 in terms of a mass ratio of (2-3-a) to (2-3-b).

(2-4-a) naphthol aralkyl resin and (2-4-b) esterified naphthol aralkyl resin thereof:

They are represented by the following chemical formula (4):

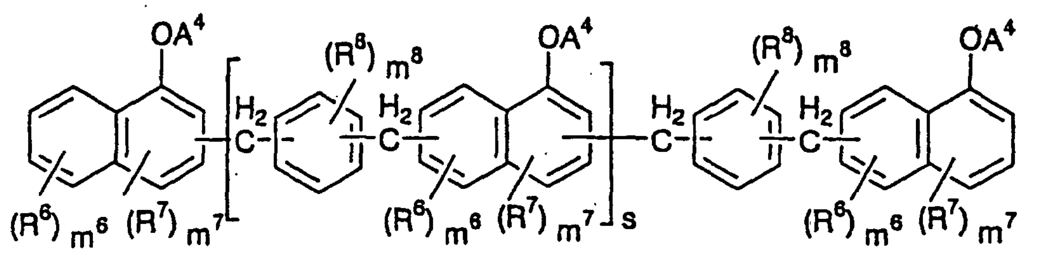

(4)

wherein $A^4$ represents a hydrogen atom, an aromatic acyl group or an aliphatic acyl group; $R^6$ and $R^7$ each represent a hydrogen atom, a halogen atom, a hydroxyl group, a linear, branched or cyclic alkyl group having 1 to 10 carbon atoms, an alkoxy group having 1 to 10 carbon atoms or a phenyl group; $R^8$ represents a hydrogen atom or a methyl group; $R^6$, $R^7$ and $R^8$ may be the same or different respectively; $m^6$, $m^7$ and $m^8$ each represent an integer of 1 to 3 and may be the same or different respectively; a repetitive unit number s is an integer falling in a range of 0 to 100; and when s is 0, the formula represents a bisnaphthol derivative. The naphthol aralkyl resin (2-4-a) is represented by the resin in which $A^4$ in the formula is a hydrogen atom. On the other hand, the esterified naphthol aralkyl resin (2-4-b) is represented by the resin in which $A^4$ in the chemical formula (4) is a hydrogen atom, an aromatic acyl group or an aliphatic acyl group and all of $A^4$ are not hydrogen atoms and in which a mole ratio of hydrogen atom/acyl group falls in a range of 90/10 to 0/100.

Preferred examples of the naphthol aralkyl resin (2-4-a) shall not specifically be restricted and include, for example, those derived from naphthols and the xylylenedichloride compounds described above or the xylylenedialkyl ether compounds described above in the presence of a Friedel-Crafts catalyst and obtained by removing free naphthol to 0.01 mass % or less under reduced pressure.

Preferred examples of the esterified naphthol aralkyl resin (2-4-b) include those obtained by modifying 10 to 100 mole % of the naphtholic hydroxyl groups contained in the naphthol aralkyl resins described above with aromatic and/or aliphatic acyl groups.

Preferred examples of the naphthols described above include, for example, at least one selected from α-naphthol, β-naphthol, methytlnaphthol, dimethylnaphthol, trimethylnaphthol, methylethylnaphthol, ethylnaphthol, diethylnaphthol, triethylnaphthol, methyldiethylnaphthol, n-propylnaphthol, di-n-propylnaphthol, isopropylnaphthol, diisopropylnaphthol, dihydroxynaphthalene and trihydroxynaphthalene. Naphthol and/or methylnaphthol are more preferred.

In the composition for a liquid crystal display cell sealant of the present invention, it is one of the preferred embodiments that the polyphenol resin is (2-4-a) and/or (2-4-b). Among them, preferred is a mixture falling in a range of 1 : 99 to 99 : 1, more preferably 90 : 10 to 1 : 99 in terms of a mass ratio of (2-4-a) to (2-4-b).

(2-5-a) alicyclic compound-modified phenol novolak resin and (2-5-b) esterified alicyclic compound-modified phenol novolak resin thereof:

They are represented by the following chemical formula (5):

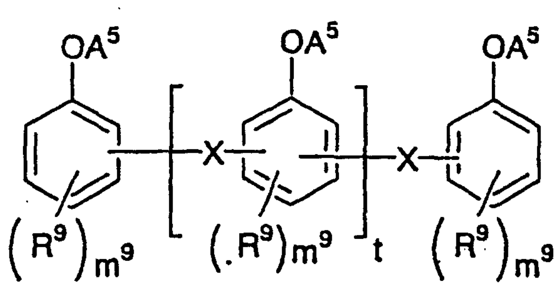

(5)

wherein $A^5$ represents a hydrogen atom, an aromatic acyl group or an aliphatic acyl group; $R^9$ represents a hydrogen atom, a halogen atom, a hydroxyl group, a linear, branched or cyclic alkyl group having 1 to 10 carbon atoms, an alkoxy group having 1 to 10 carbon atoms or a phenyl group and may be the same or different; $m^9$ represents an integer of 1 to 3 and may be the same or different; X represents an aliphatic ring represented by the following formula chemical (6) or (7); a repetitive unit number t is an integer falling in a range of 0 to 100; and when t is 0, the formula represents a bisphenol derivative:

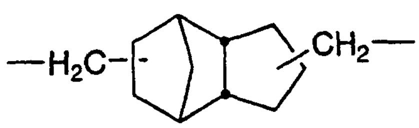

(6)

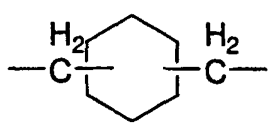

(7)

The alicyclic compound-modified phenol novolak resin (2-5-a) is represented by the resin in which $A^5$ in the formula is a hydrogen atom. On the other hand, the esterified alicyclic compound-modified phenol novolak resin (2-5-b) thereof is represented by the resin in which $A^5$ in the chemical formula (5) is a hydrogen atom, an aromatic acyl group or an aliphatic acyl group and all of $A^5$ are not hydrogen atoms and in which a mole ratio of hydrogen atom/acyl group falls in a range of 90/10 to 0/100.

Preferred specific examples of the alicyclic compound-modified phenol novolak resin in which X in the formula (5) is the aliphatic ring represented by the formula (6) are represented by, for example, those derived from phenols and dicyclopentadienedichloride compounds or dicyclopentadienedialkyl ether compounds in the presence of a Friedel-Crafts catalyst and obtained by removing free phenol to 0.01 mass % or less under reduced pressure.

Preferred examples of the phenols include, for example, at least one selected from phenol, cresol, xylenol, hydroquinone, methylhydroquinone, catechol, resorcin, ethylphenol, diethylphenol, n-propylphenol, isopropylphenol, n-butylphenol, t-butylphenol, 2-ethylhexylphenol and phenylphenol. Phenol and/or cresol are more preferred.

The dicyclopentadienedialkyl ether compounds include, for example, dicyclopentadienedimethyl ether, dicyclopentadienediethyl ether, dicyclopentadienedipropyl ether and dicyclopentadienemethylethyl ether.

Preferred examples of the esterified alicyclic compound-modified novolak resin thereof include those obtained by modifying 10 to 100 mole % of the phenolic hydroxyl groups contained in the alicyclic compound-modified novolak resins described above with aromatic and/or aliphatic acyl groups.

Preferred specific examples of the alicyclic compound-modified novolak resin in which X in the formula (5) is the aliphatic ring represented by the formula (7) are represented by, for example, those derived from the phenols described above, if necessary, in the coexistence of the naphthols described above and cyclohexanedichloride compounds or cyclohexyldialkyl ether represented by cyclohexanedimethoxy ether compounds and/or cyclohexanediethyl ether in the presence of a Friedel-Crafts catalyst and obtained by removing free phenol to 0.01 mass % or less under reduced pressure.

Preferred specific examples of the esterified alicyclic compound-modified novolak resin thereof include those obtained by modifying 10 to 100 mole % of the phenolic hydroxyl groups contained in the alicyclic compound-modified novolak resins described above with aromatic and/or aliphatic acyl groups.

In the composition for a liquid crystal display cell sealant of the present invention, it is one of the preferred embodiments that the polyphenol resin is (2-5-a) and/or (2-5-b). Among them, preferred is a mixture falling in a range of 1 : 99 to 99 : 1, more preferably 90 : 10 to 1 : 99 in terms of a mixing mass ratio of (2-5-a) to (2-5-b).

(2-6-a) alicyclic compound-modified naphthol novolak resin and (2-6-b) esterified alicyclic compound-modified naphthol novolak resin thereof:

They are represented by the following chemical formula (8):

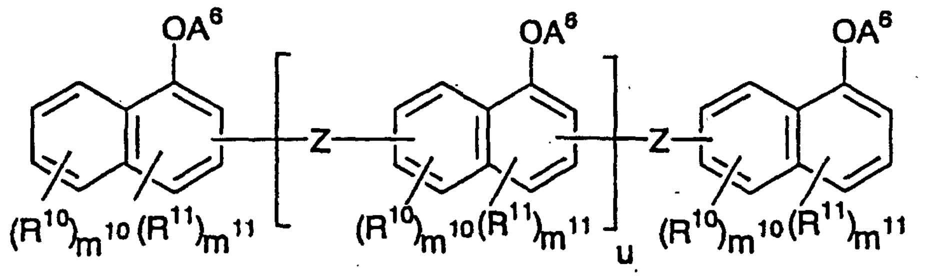

(8)

wherein $A^6$ represents a hydrogen atom, an aromatic acyl group or an aliphatic acyl group; $R^{10}$ and $R^{11}$ each represent a hydrogen atom, a halogen atom, a hydroxyl group, a linear, branched or cyclic alkyl group having 1 to 10 carbon atoms, an alkoxy group having 1 to 10 carbon atoms or a phenyl group, and $R^{10}$ and $R^{11}$ may be the same or different respectively; $m^{10}$ and $m^{11}$ each represent an integer of 1 to 3 and may be the same or different respectively; Z represents an aliphatic ring represented by the following chemical formula (9) or (10); a repetitive unit number u is an integer falling in a range of 0 to 100; and when u is 0, the formula represents a bisnaphthol derivative:

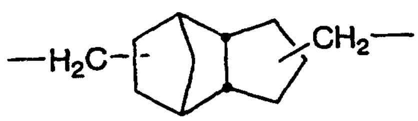

(9)

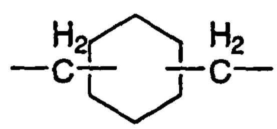

(10)

The alicyclic compound-modified naphthol novolak resin (2-6-a) is represented by the resin in which $A^6$ in the formula is a hydrogen atom. On the other hand, the esterified alicyclic compound-modified naphthol novolak resin (2-6-b) is represented by the resin in which $A^6$ in the chemical formula (8) is a hydrogen atom, an aromatic acyl group or an aliphatic acyl group and all of $A^6$ are not hydrogen atoms and in which a mole ratio of hydrogen atom/acyl group falls in a range of 90/10 to 0/100.

Preferred specific examples of the alicyclic compound-modified naphthol novolak resin in which Z in the formula (8) is the aliphatic ring represented by the formula (9) are represented by, for example, those derived from the naphthols described above and the dicyclopentadienedichloride compounds described above or the dicyclopentadienedialkyl ether compounds described above in the presence of a Friedel-Crafts catalyst and obtained by removing free phenol to 0.01 mass % or less under reduced pressure.

Preferred examples of the esterified alicyclic compound-modified naphthol novolak resin thereof include those obtained by modifying 10 to 100 mole % of the phenolic hydroxyl groups contained in the alicyclic compound-modified novolak resins described above with aromatic and/or aliphatic acyl groups.

Preferred specific examples of the alicyclic compound-modified naphthol novolak resin in which Z in the formula (8) is the aliphatic ring represented by the formula (10) are represented by, for example, those derived from the naphthols described above, if necessary, in the coexistence of the phenols described above and the cyclohexanedichloride compounds described above or the cyclohexanedialkyl ethers described above represented by cyclohexanedimethoxy ether compounds and/or cyclohexanediethyl ether, in the presence of a Friedel-Crafts catalyst and obtained by removing free naphthol to 0.01 mass % or less under reduced pressure.

Preferred specific examples of the esterified alicyclic compound-modified naphthol novolak resin thereof include those obtained by modifying 10 to 100 mole % of the phenolic hydroxyl groups contained in the alicyclic compound-modified resins described above with aromatic and/or aliphatic acyl groups.

It is included as well in the embodiments of the present invention that (2-6-a) and (2-6-b) are used in combination as the polyphenol resin in an optional proportion. Among them, preferred is a mixture falling in a range of 1 : 99 to 99 : 1, more preferably 90 : 10 to 1 : 99 in terms of a mass ratio of (2-6-a) to (2-6-b).

(2-7-a) polycyclic aromatic compound-modified novolak resin and (2-7-b) esterified polycyclic aromatic compound-modified novolak resin thereof:

The polycyclic aromatic compound-modified novolak resin (2-7-a) is represented by, for example, a condensed polycyclic aromatic compound-modified novolak resin which is obtained by reacting with an acid catalyst phenols with formaldehyde in the presence of tri- to tetracyclic condensed polycyclic aromatic hydrocarbon compound originating in a light or heavy oil fraction distilled from a high pressure steam catalytic cracking plant in the petroleum industry and in which the condensed polycyclic aromatic nucleus described above is bonded with the phenol nucleus at random through a methylene bond in a three-dimensional configuration.

The esterified polycyclic aromatic compound-modified novolak resin (2-7-b) thereof is represented by, for example, those obtained by modifying 10 to 100 mole % of the phenolic hydroxyl groups of (2-7-a) described above with aromatic and/or aliphatic acyl groups.

The tri- to tetracyclic condensed polycyclic aromatic hydrocarbon compound originating in a light oil fraction is represented by, for example, a fraction having an aromatic carbon ratio (fa value) falling in a range of 0.4 to 0.95, preferably 0.7 to 0.8, which is represented by an aromatic carbon number in the light or heavy oil determined by $^{13}C$-NMR/carbon number in the light or heavy oil and a fraction having an aromatic ring hydrogen ratio (Ha value) falling in a range of 0.2 to 0.8, preferably 0.35 to 0.6, which is represented by an aromatic ring hydrogen number in the light or heavy oil determined by $^{1}H$-NMR/hydrogen number in the light or heavy oil.

It is included as well in the embodiments of the present invention that (2-7-a) and (2-7-b) are used in combination as the polyphenol resin in an optional proportion. Among them, preferred is a mixture falling in a range of 1 : 99 to 99 : 1, more preferably 90 : 10 to 1 : 99 in terms of a mass ratio of (2-7-a) to (2-7-b).

(2-8-a) polyvalent phenol monomer and (2-8-b) esterified polyphenol monomer thereof:

The polyphenol monomer (2-8-a) shall not specifically be restricted, and representative examples thereof include, for example, bisphenol monomers represented by bisphenol A, bisphenol F, bisphenol S and bisphenol AD, and the following trisphenol monomers.

The trisphenol monomers include, for example, 4,4',4"-methylidenetrisphenol, 4,4',4"-methylidenetris(2-methylphenol), 4,4'-[(2-hydroxyphenyl)methylene]bis-[2,3, 6-trimethylphenol], 4,4',4"-ethylidenetrisphenol, 4,4'-[(2-hydroxyphenyl)methylene]bis[2-methylphenol], 4,4'-[(2-hydroxyphenyl)ethylene]bis[2-methylphenol], 4,4'-[(4-hydroxyphenyl)methylene]bis[2-methylphenol], 4,4'-[(4-hydroxyphenyl)ethylene]bis[2-methylphenol], 4,4'-[(2-hydroxyphenyl)methylene]bis[2,6-dimethylphenol], 4,4'-[(2-hydroxyphenyl)ethylene]bis[2,6-dimethylphenol], 4,4'-[(4-hydroxyphenyl)methylene]bis[2,6-dimethylphenol], 4,4'-[(4-hydroxyphenyl)ethylene]bis[2,6-dimethylphenol], 4,4'-[(2-hydroxyphenyl)methylene]bis[3,5-dimethylphenol], 4,4'-[(2-hydroxyphenyl)ethylene]bis[3,5-dimethylphenol], 4,4'-[(3-hydroxyphenyl)methylene]bis[2,3,6-trimethyl-phenol], 4,4'-[(4-hydroxyphenyl)methylene]bis[2,3,6-trimethylphenol], 4,4'-[(2-hydroxyphenyl)methylene]bis-[2-cyclohexyl-5-methylphenol], 4,4'-[(3-hydroxyphenyl)-methylene]bis[2-cyclohexyl-5-methylphenol], 4,4'-[(4-hydroxyphenyl)methylene]bis[2-cyclohexyl-5-methylphenol], 4,4'-[1-[4-[1-(4-hydroxyphenyl)-1-methylethyl]phenol-ethylidene]bisphenol], 4,4'-[(3,4-dihydroxyphenyl)-methylene]bis[2-methylphenol], 4,4'-[(3,4-dihydroxyphenyl)methylene]bis[2,6-dimethylphenol], 4,4'-[(3,4-dihydroxyphenyl)methylene]bis[2,3,6-trimethylphenol] and 4-[bis(3-cyclohexyl-4-hydroxy-6-methylphenyl)methyl]-1,2-benzenediol.

In particular, (2-8-a) is represented preferably by those which are represented by the following chemical formula (11) and in which $A^7$ in the formula is represented by a hydrogen atom:

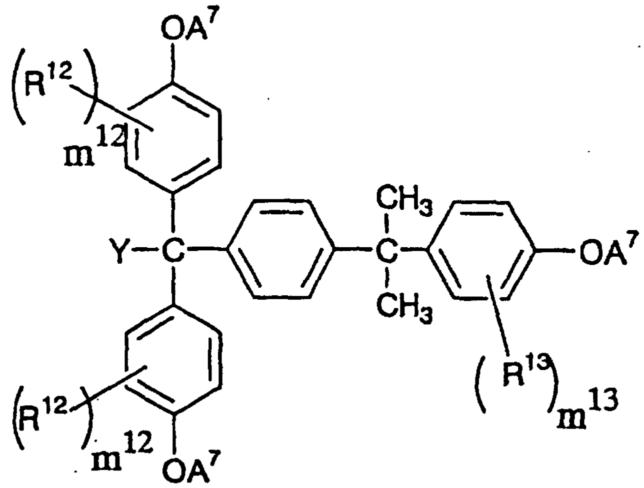 (11)

wherein $A^7$ represents a hydrogen atom, an aromatic acyl group or an aliphatic acyl group; $R^{12}$ represents a hydrogen atom, an acyloxy group, a linear, branched or cyclic alkyl group having 1 to 10 carbon atoms, an alkoxy group having 1 to 10 carbon atoms or a phenyl group; $R^{13}$ represents a hydrogen atom or an alkyl group having 10 or less carbon atoms, and $R^{12}$ and $R^{13}$ may be the same or different respectively; Y represents a hydrogen atom, a methyl group or an ethyl group; $m^{12}$ and $m^{13}$ each represent an integer of 1 to 3 and may be the same or different respectively.

On the other hand, preferred examples of the esterified polyphenol monomer include those obtained by modifying 10 to 100 mole % of the phenolic hydroxyl groups of (2-8-a) described above with aromatic and/or aliphatic acyl groups. Particularly preferably, they are represented by those which are represented by the chemical formula (11) and in which $A^7$ in the formula is a hydrogen atom, an aromatic acyl group or an aliphatic acyl group and all of $A^7$ are not hydrogen atoms, wherein a mole ratio of hydrogen atom/acyl group falls in a range of 90/10 to 0/100.

It is included as well in the embodiments of the present invention that (2-8-a) and (2-8-b) are used in combination as the polyvalent phenol resin in an optional proportion. Among them, preferred is a mixture falling in a range of 1 : 99 to 99 : 1, more preferably 90 : 10 to 1 : 99 in terms of a mass ratio of (2-8-a) to (2-8-b).

(2-9-a) polyvinylphenol and (2-9-b) esterified polyvinylphenol thereof:

The polyvinylphenol (2-9-a) is represented by, for example, a homopolymer of p-vinylphenol. Though specifically be restricted, selected and used is the resin having a polystyrene-reduced mass average molecular weight falling preferably in a range of 300 to 20000, more preferably 500 to 10000 which is determined by GPC.

The esterified polyvinylphenol (2-9-b) thereof is represented by, for example, those obtained by modifying 10 to 100 mole % of the phenolic hydroxyl groups of (2-9-a) with aromatic and/or aliphatic acyl groups.

(2-10-a) vinylphenol copolymer and (2-10-b) esterified vinylphenol copolymer thereof:

Specific examples of the vinylphenol copolymer (2-10-a) are represented by, for example, bipolymers, terpolymers or multiple component copolymers of p-vinylphenol with other vinyl monomers which can be copolymerized with p-vinylphenol. They shall not specifically be restricted, and preferred are those having a polystyrene-reduced mass average molecular weight falling preferably in a range of 500 to 20000, more preferably 500 to 10000 which is determined by GPC.

The other vinyl monomers which can be copolymerized with p-vinylphenol include, for example, styrene, acrylonitrile, methyl acrylate, methyl methacrylate, butyl acrylate, butyl methacrylate and hydroxyacrylate.

The esterified vinylphenol copolymer (2-10-b) thereof is represented by those obtained by modifying 10 to 100 mole % of the phenolic hydroxyl groups of (2-10-a) described above with aromatic and/or aliphatic acyl groups.

(2-11-a) polyisopropenylphenol and (2-11-b) esterified polyisopropenylphenol thereof:

A specific example of the polyisopropenylphenol (2-11-a) is represented by, for example, poly-p-isopropenylphenol. Though specifically be restricted, selected and used is the resin having a polystyrene-reduced mass average molecular weight falling preferably in a range of 300 to 20000, more preferably 500 to 10000 which is determined by GPC.

The esterified polyisopropenylphenol (2-11-b) thereof is represented by, for example, those obtained by modifying 10 to 100 mole % of the phenolic hydroxyl groups of (2-11-a) with aromatic and/or aliphatic acyl groups.

(2-12-a) polyisopropenylphenol copolymer and (2-12-b) esterified polyisopropenylphenol copolymer thereof:

Specific examples of the polyisopropenylphenol copolymer (2-12-a) are represented by binary copolymers or ternary copolymers of p-isopropenylphenol with other vinyl monomers copolymerizable with p-isopropenylphenol, and preferred are those having a polystyrene-reduced mass average molecular weight falling preferably in a range of

500 to 20000, more preferably 500 to 10000 which is determined by GPC.

The other vinyl monomers copolymerizable with p-isopropenylphenol include, for example, styrene, acrylonitrile, methyl acrylate, methyl methacrylate, butyl acrylate, butyl methacrylate and hydroxyacrylate.

The esterified polyisopropenylphenol copolymer (2-12-b) is represented by those obtained by modifying 10 to 100 mole % of the phenolic hydroxyl groups of (2-12-a) with aromatic and/or aliphatic acyl groups.

In the present invention, capable of being used as the polyphenol curing agent (2) in addition those describe above are, for example, novolak resins derived from bisphenols represented by bisphenol A, bisphenol F and bisphenol S, novolak resins derived from biphenylphenols represented by 4,4'-biphenylphenol and novolak resins derived from phenols having a fluorene skeleton represented by 1,1-di-4-hydroxyphenylfluorene.

The most preferred embodiment polyphenol curing agent (2) includes, for example, at least one selected from phenol novolak resins, phenol aralkyl resins, esterified phenol novolak resins and esterified phenol aralkyl resins.

A content of the polyphenol curing agent (2) based on the composition for a liquid crystal display cell sealant which comprises the epoxy resin, the polyphenol curing agent and the curing accelerator comprising at least one selected from alkylurea derivatives and phosphazene compounds shall not specifically be restricted, and it falls preferably in a range of 10 to 65 mass %. A content of 10 mass % or more improves a balance between storage stability and a thermosetting property of the epoxy composition and makes it possible to produce a liquid crystal display element having high durability. On the other hand, the content controlled to 65 mass % or less can inhibit the unreacted materials of the curing agent from remaining and can maintain well a cross-linking density of the cured matter and adhesion reliability for sealing, and therefore such a content is preferred.

In order to control an ionic conductivity of an extracted aqueous solution obtained by extracting the polyphenol curing agent with purified water of a ten times mass at 40 to 80°C to 2 mS/m or less, preferably used is the polyphenol curing agent which is produced in advance via a deionization refining method. Preferably used as the deionization refining method are, for example, a free ion water extraction refining method, a solvent extraction refining method and a ultrafiltration refining method, and it shall not specifically be restricted.

An esterifying agent used in esterifying the phenolic hydroxyl group and the naphtholic hydroxyl group described above (hereinafter, the phenolic hydroxyl group and the naphtholic hydroxyl group shall be referred together merely as a phenolic hydroxyl group) may be any of organic carboxylic anhydrides, organic carboxylic acid halides and organic carboxylic acids, and suitable ones can be selected based on the characteristics of the esterifying agent according to a carbon number of the ester which is intended to be derived.

Specific examples of the esterifying agent include acetic anhydride, acetyl chloride, acetyl bromide, acetic acid, propionic anhydride, propionic chloride, propionic bromide, propionic acid, butyric anhydride, butyric chloride, butyric acid, valeric anhydride, valeric chloride, valeric bromide, valeric acid, pivalic chloride, pivalic acid, phenylacetic acid, phenylacetic chloride, 2-phenylpropionic acid, 3-phenylpropionic acid, o-tolylacetic acid, m-tolylacetic acid, p-tolylacetic acid and cumic acid.

These esterifying agents can be used alone or in combination of optional two or more kinds thereof.

A use amount thereof is 10 mole % or more based on the hydroxyl groups, and an upper limit thereof shall not specifically be restricted. When the agent is used in excess to allow esterification to proceed sufficiently, the excess esterifying agent may be removed after finishing the reaction. To be realistic, it is ten times mole or less, preferably five times mole or less and more preferably three times mole or less as much as the hydroxyl group from a viewpoint of the volume efficiency of the reaction and the cost.

The specific reactions varies according to the kind of the esterifying agent. To describe each of them, a conventional reaction can be used for organic carboxylic anhydrides.

That is, an optional amount of an organic carboxylic anhydride used for esterification is reacted with a phenolic hydroxyl group, and then a by-produced organic carboxylic acid and an excess amount of the organic carboxylic anhydride are removed by an optional method such as atmospheric distillation, vacuum distillation, washing with water and washing with a weak basic aqueous solution of carbonate or a combination thereof, whereby the intended esterified compound can be obtained. That is, in the case of a partially esterified compound, preferred is the esterified compound in which an optional amount, preferably 10 mole % or more of the phenolic hydroxyl groups is esterified, and therefore an organic carboxylic anhydride is used in an amount of 10 mole % or more of the hydroxyl groups. In the case of the completely esterified compound, the equivalent mole or more of the organic carboxylic anhydride based on the phenolic hydroxyl groups is used, and if it doubles as a solvent, an upper limit thereof shall not specifically be restricted. However, taking the economical efficiency and the volume efficiency of the reaction into consideration, ten times mole % or less is used for the esterification. This use amount shall apply in the reaction described later using an organic carboxylic acid.

The esterification temperature falls in a range of 60 to 200°C, preferably 80 to 180°C and particularly preferably 100 to 160°C.

The esterification time depends largely on the kind of the reaction components and the reaction temperature and falls in a range of about 1 to 25 hours. To be realistic, the end point is preferably decided while tracing consumption of the esterifying agent and exhaustion of the hydroxyl groups by means of high performance liquid chromatography

and gas chromatography.

A solvent may be or may not be used in the above esterification reaction. When a substance having a phenolic hydroxyl group which is the raw material is sufficiently molten at the reaction temperature and the esterifying agent is liquid or when they are molten or dissolved in the resin at the reaction temperature and do not interfere with the reaction, the reaction may be carried out without using a solvent.

When requiring the solvent, all solvents can be used as long as they are inactive to the reaction. Examples thereof include aromatic hydrocarbons such as benzene, toluene and xylene, halogenated benzenes such as chlorobenzene and o-dichlorobenzene, aprotic polar solvents such as N,N-dimethylformamide, N,N-dimethylacetamide, N-methyl-2-pyrrolidone, N,N-dimethyl-2-imidazolidine, dimethylsulfoxide and sulfolane, ethers such as diphenyl ether, tetrahydrofuran, dioxane, ethylene glycol dimethyl ether and diethylene glycol dimethyl ether and ketones such as acetone, methyl ethyl ketone and methyl isobutyl ketone. They can be used alone or in optional combination thereof.

The esterification reaction may be carried out at atmospheric pressure, applied pressure (in an autoclave) or reduced pressure, and an atmosphere of the reaction system may be either in the air or an inert gas such as nitrogen, argon and helium. It is carried out preferably under the nitrogen atmosphere.

Next, the reaction in which organic carboxylic halide is used as the esterifying agent shall be explained. In this case, a method usually used can be used.

That is, an optional amount of an organic carboxylic halide required for esterification is reacted with a phenolic hydroxyl group. In this case, available are a method in which a required amount of a base which is inactive to the reaction such as pyridine, piperazine and triethylamine is allowed to be present in the system to trap the by-produced hydrogen halide and a method in which it is quickly discharged in succession in the form of gas to the outside of the system during the reaction and scavenged in a water or alkali trap disposed outside the reaction system. However, because of the reason shown above, in order to avoid nitrogen-containing compounds and ionic compounds from being mixed in, preferred is a method in which hydrogen halide is quickly discharged to the outside of the system during the reaction. In this case, the reaction is carried out more preferably under a stream of gas which is inactive to the reaction.

With regard to a use amount of the organic carboxylic halide, preferably used in the case of the partially esterified compound is the esterified compound in which an optional amount, preferably 10 mole % or more based on the phenolic hydroxyl groups is esterified, and therefore the organic carboxylic halide is used in an amount of 10 mole % or more of the hydroxyl groups. In the case of the completely esterified compound, the equivalent mole or small excess of the organic carboxylic halide based on the hydroxyl groups is used or the large excess may be used. However, taking the economical efficiency, the volume efficiency of the reaction and a complexity in the treating steps after the reaction into consideration, it is used for esterification in a range of 10 times mole or less, preferably 5 times mole or less and more preferably 3 times mole or less based on the hydroxyl groups.

The reaction temperature, use of the solvent in the reaction and a mode of the reaction may correspond to the preceding case of the organic carboxylic anhydride.

When an organic carboxylic acid is used as the esterifying agent, it corresponds almost to the case of the organic carboxylic anhydride, but an acid catalyst is required in the reaction.

Examples of the acid catalyst include mineral acids such as hydrochloric acid, sulfuric acid, phosphoric acid and polyphosphoric acid, organic sulfonic acids such as p-toluenesulfonic acid, methanesulfonic acid, ethanesulfonic acid, dimethylsulfonic acid and diethylsulfonic acid, superstrong acids represented by trifluoromethanesulfonic acid, acidic ion exchange resins represented by an alkanesulfonic acid type and superstrong acid ion exchange resins represented by a perfuloroalkanesulfonic acid type.

A use amount thereof falls in a range of 0.00001 to 5 mass %, preferably 0.0001 to 1 mass % and more preferably 0.001 to 0.1 mass % based on the weight of the raw materials in the case of the superstrong acid and in a range of 1 to 100 mass %, preferably 10 to 50 mass % in the case of the ion exchange resins, and it falls in a range of 0.01 to 10 mass %, preferably 0.1 to 5 mass % in the case of the others. If the amount is smaller than this range, the reaction rate is reduced, and the reaction shall not be completed in practical reaction time. On the other hand, if the amount is larger than this range, the side reaction can not be ignored or it leads to a rise in the cost involving complexity in a step for removing the catalyst.

The reactions of three kinds of the esterifying agents have been explained above, and it is advisable in any method to introduce a water-washing step after finishing the reaction when the more refined esterified product is needed. In this case, a solvent which can be washed with water, such as toluene, xylene, methyl isobutyl ketone, methyl ethyl ketone and ethyl acetate is used to carry out the esterification reaction, and washing is continued until acid components and ionic impurities are not detected in waste water.

An esterification rate of the esterified products falls is a range of 10 to 100 mole %, preferably 50 to 100 mole % and more preferably 90 to 100 mole %.

A method for determining a content of the polyphenol curing agent (2) contained in the sealant composition for a liquid crystal display element shall not specifically be restricted and includes a suitable combination of, for example, a chromatographic fractionation method, an infrared absorption spectral method (IR method), a functional group analysis method and a solution/solid NMR (nuclear magnetic resonance spectrum) method.

A method for determining a content of the polyphenol curing agent (2) contained in the sealant for a liquid crystal display cell shall not specifically be restricted and includes a suitable combination, for example, a thermal decomposition-chromatographic fractionation method, a wet decomposition-chromatographic fractionation method, a solid NMR method and an infrared absorption spectral method.

In the composition for a liquid crystal display cell sealant, it is no problem to use a known potential curing agent for epoxy resin in suitable combination with the polyphenol curing agent (2) as long as the objects of the present invention are not damaged.

Substances which can substantially cure an epoxy resin by heating at 50°C or higher can preferably be used as the potential curing agent for epoxy resin.

The potential curing agent for epoxy resin shall not specifically be restricted, and used are, for example, dicyandiamide and derivatives thereof, dihydrazide compounds, 4,4-diaminodiphenylmethane, 4,4-diaminodiphenylsulfone, imidazole compound-epoxy resin adducts and complexes thereof, polyamine compound-epoxy resin adducts, polyamine-diisocyanate compound adducts, boron trifluoride-amine complexes and organic acid anhydrides. They can be used alone or in combination of two or more kinds thereof.

The preferred potential curing agent for epoxy resin is at least one selected from the dihydrazide compounds, the imidazole compound-epoxy resin adducts and the complexes thereof and the organic acid anhydrides.

Dihydrazide compounds:

Preferred specific examples of the dihydrazide compounds include, for example, dibasic acid dihydrazides having 4 to 22 carbon atoms and comprising a saturated fatty acid skeleton such as succinic acid dihydrazide, adipic acid dihydrazide, sebacic acid dihydrazide, azelaic acid dihydrazide, decanedioic acid dihydrazide and dodecanedioic acid dihydrazide, aromatic dibasic acid dihydrazides represented by isophthalic acid dihydrazide and dihydrazides having a valinehydantoin skeleton.

Dihydrazides compounds derived from dicarboxylic acid compounds having 4 to 22 carbon atoms are more preferred as the dihydrazide compounds.

Imidazole compound-epoxy resin adducts:

Given as specific examples of the adducts of imidazole compounds and epoxy resins are, for example, curing agents having a softening point of 70 to 150°C, which comprise reaction products of polyfunctional epoxy compounds, imidazole compounds and phenol novolak resins whose amount does not exceed twice as much as a mass of the polyfuntional epoxy compounds, wherein a molecular ratio of the epoxy groups contained in the polyfunctional epoxy compounds to the imidazole compounds falls in a range of (0.8 : 1) to (2.2 : 1). Further, included are adducts obtained by mixing the above adducts with polyphenol monomers and/or polyphenol resins of amount which can be neutralized.

Adducts of polyamine compounds and epoxy resins:

The adducts of polyamine compounds and epoxy resins shall not specifically be restricted and are represented by known adducts derived from polyamine compounds and epoxy resins. Specific examples thereof include, for example, adducts obtained by reacting addition reaction products of epoxy resins and polyamines with compounds having two or more acidic hydroxyl groups. The compounds having two or more acidic hydroxyl groups include phenol resins, polyphenol resins and polycarboxylic acids.

Adducts of amine compounds and diisocyanate compounds or modified derivatives thereof:

The adducts of amine compounds and diisocyanate compounds are represented by known adducts obtained by reacting primary and secondary amine compounds with diisocyanates. Adducts obtained by reacting with heating N,N-dialkylaminoalkylamines and cyclic amines with diisocyanates can be given as examples of the modified derivatives of the adducts of amine compounds and diisocyanate compounds. Further, given as the examples thereof are compositions obtained by bringing diisocyanate compounds into even contact with a particle surface of the powdery adducts having a softening point of 60°C or higher and a tertiary amino group among the above adducts.

Organic acid anhydrides:

Given as examples of the organic acid anhydrides are phthalic anhydride, maleic anhydride, trimellitic anhydride, ethylene glycol bistrimellitate, pyromellitic anhydride, dodecynylsuccinic anhydride, hexahydrophthalic anhydride, tetrahydrophthalic anhydride, methylnadic anhydride, nadic anhydride and glutaric anhydride.

A part of the potential curing agents for epoxy resin described above may be selected and used as the following curing accelerator.

(3) Curing accelerator

The curing accelerator (3) used in the composition for a liquid crystal display cell sealant of the present invention is at.least one selected from alkylurea derivatives and phosphazene compounds.

Alkylurea derivatives:

Specific examples of the alkylurea derivatives are, for example, 3-(p-chlorophenyl)-1,1-dimethylurea, 3-(o,p-dichlorophenyl)-1,1-dimethylurea, 2,4-[bis(1,1-dimethylurea)]toluene and/or 2,6-(bis(1,1-dimethylurea)]toluene which are derived from tolylenediisocyanate and dimethylamine, 3,5-di(1,1-dimethylurea)-5-methyl-2-cyclohexene-1-one which is derived from isophoronediisocyanate and dimethylamine and which has an isophorone skeleton and alkylurea derivatives which are derived from norbornanediisocyanate and dimethylamine and which has a norbornane skeleton.

Particularly preferred ones include 3-(p-chlorophenyl)-1,1-dimethylurea, 2,4-[bis(1,1-dimethylurea)]toluene and/or 2,6-(bis(1,1-dimethylurea)]toluene.

Phosphazene compounds:

The phosphazene compound is represented by compounds shown by the following chemical formula (12):

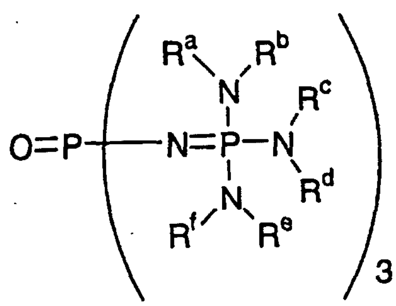

(12)

wherein $R^a$ to $R^f$ each represent a hydrogen atom, a linear, branched or cyclic alkyl group having 1 to 10 carbon atoms, an aryl group or an aralkyl group each having 6 to 10 carbon atoms, and all of them may be the same or different.

Specific examples of $R^a$ to $R^f$ shown in the chemical formula (12) described above include a hydrogen atom, aliphatic hydrocarbon groups such as methyl, ethyl, n-propyl, isopropyl, n-butyl, sec-butyl, tert-butyl, 1-pentyl, 2-pentyl, 3-pentyl, 2-methyl-1-butyl, isopentyl, tert-pentyl, 3-methyl-2-butyl, neopentyl, n-hexyl, 4-methyl-2-pentyl, cyclopentyl, cyclohexyl, 1-heptyl, 3-heptyl, 1-octyl, 2-octyl, 2-ethyl-1-hexyl, nonyl and decyl and aromatic-containing hydrocarbon groups such as phenyl, toluyl, benzyl and 1-phenylethyl.

Among them, preferred are aliphatic hydrocarbon groups having 1 to 6 carbon atoms such as methyl, ethyl, n-propyl, isopropyl, n-butyl and cyclohexyl, and methyl and ethyl are more preferred.

The phosphazene compounds can be synthesized, as described in G. N. Koian et al., Journal of General Chemistry of The USSR, 55, 1453 (1985), by reacting phosphorus oxytrichloride with 3 molecules of iminotrisamino (non-substituted, monosubstituted and disubstituted)phosphorane. Further, if they have to be refined, they can be refined by conventional methods such as column chromatography, distillation and recrystallization.

Phosphazene compounds thus obtained are usually solid.

Compounds represented by the following chemical formula (13) can be given as preferred examples of the phosphazene compounds:

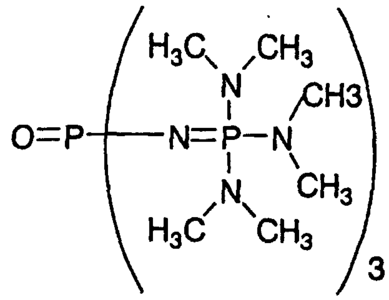

(13)

In the composition for a liquid crystal display cell sealant of the present invention, it is important that the curing accelerator (3) is added in a range of 0.1 to 20 mass %. A range of 0.1 mass % or more makes it possible to sufficiently bring out curing activity of the curing agent (2) in curing with heating. Use thereof in a range of 20 mass % or less makes it possible to solve the problems of the present invention without deteriorating storage stability of the resulting epoxy resin composition at 25°C.

A particularly preferred example of the curing accelerator (3) in the composition for a liquid crystal display cell sealant of the present invention is one of 3-(p-chlorophenyl)-1,1-dimethylurea, 2,4-[bis(1,1-dimethylurea)]toluene and 2,6-[bis(1,1-dimethylurea)]toluene or one selected from the phosphazene compounds represented by the chemical formula (12) described above, and the most preferred is the phosphazene compound represented by the chemical formula (13).

The curing accelerator (3) has a total content of alkali metals of 50 ppm or less, preferably 30 ppm or less and more preferably 15 ppm or less which is determined by a flame elemental analysis of wet decomposition products. This makes it possible to inhibit free ions from unnecessarily transferring to a liquid crystal phase in bringing liquid crystal into contact with the composition for a liquid crystal display cell sealant of the present invention or the sealant for a liquid crystal display cell which is a cured matter thereof. A refining method for reducing a total content of alkali metals to 50 ppm or less shall not specifically be restricted, and known methods such as, for example, a solvent extraction refining method can be applied.

A method for determining the kind and the amount of the curing accelerator (3) contained in the composition for a liquid crystal display cell sealant of the present invention shall not specifically be restricted, and usually used are, for example, a method in which the accelerator is extracted with a solvent and the extract thereof is fractionated by means of GPC and identified and determined by means of an infrared absorption spectrum or an NMR (nuclear magnetic resonance spectrum) and an elemental analysis method. A method for determining the kind and the amount of the curing accelerator contained in the sealant for a liquid crystal display cell which a cured matter thereof shall not specifically be restricted, and can be carried out in suitable combination of, for example, a thermal decomposition-chromatographic fractionation method, a wet decomposition-chromatographic fractionation method, a thermal decomposition gas chromatographic method, a thermal decomposition mass spectral method and a solid NMR method.

The curing accelerator (3) may suitably be used in combination with other curing accelerators shown below as long as the working effects of the composition for a liquid crystal display cell sealant of the present invention are not damaged.

The other curing accelerators include at least one selected from imidazole compounds and salts thereof, trisdimethylaminomethylphenol salts, 1,8-diazabicyclo(5, 4, 0)-undecene-7 salts, 1,5-diazabicyclo(4, 3, 0)-nonene-5 salts and 6-dibutylamino-1,8-diazabicyclo(5, 4, 0)-undecene-7 salts.

Imidazole compounds:

Specific examples of the imidazole salts shall not specifically be restricted and can be represented by, for example, N-cyanoethyl-2-ethyl-4-imidazole.

Imidazole salts:

Given as examples of the imidazole salts are, for example, isocyanuric acid adducts of imidazole compounds and polycarboxylic acid adducts of imidazole compounds.

Trisdimethylaminomethylphenol salts:

Given as examples of the trisdimethylaminomethylphenol salts are, for example, trisdimethylaminomethylphenol octylic acid salts, trisdimethylaminomethylphenol oleic acid salts and trisdimethylaminomethylphenol formic acid salts.

1,8-Diazabicyclo(5,4,0)-undecene -7 salts:

Representative examples of the 1,8-diazabicyclo-(5,4,0)-undecene-7 salts (hereinafter referred to merely as DBU salts) include, for example, DBU phenol salts, DBU polyphenol compound salts, DBU polyphenol salts, DBU octylic acid salts, DBU oleic acid salts and DBU formic acid salts.

1,5-Diazabicyclo(4, 3, 0)-nonene-5 salts:

Representative examples of the 1,5-diazabicyclo (4, 3, 0)-nonene-5 salts (hereinafter referred to merely as DBN salts) include, for example, DBN phenol salts, DBN polyphenol compound salts, DBN polyphenol salts, DBN octylic acid salts, DBN oleic acid salts, DBN formic acid salts and DBN paratoluenesulfonic acid salts.

6-Dibutylamino-1,8-diazabicyclo (5, 4, 0)-undecene-7 salts:

Representative examples of the 6-dibutylamino-1,8-diazabicyclo(5, 4, 0)-undecene -7 salts (hereinafter referred to merely as DB salts) include, for example, DB phenol salts, DB polyphenol compound salts, DB polyphenol salts, DB octylic acid salts, DB oleic acid salts, DB formic acid salts and DB paratoluenesulfonic acid salts.

(4) Rubber-like polymer fine particle having a softening point of 0°C or lower and a primary particle diameter of 5 μm or less:

In the composition for a liquid crystal display cell sealant of the present invention, preferably added is, if necessary, 1 to 25 mass % of the rubber-like polymer fine particle (4) (hereinafter referred to merely as the rubber-like polymer fine particle) which has a softening point of 0°C or lower in terms of a softening point temperature determined by means of a torsional braid analyzer (hereinafter referred to merely as TBA) called a torsion pendulum method and which has a primary particle average particle diameter of 5 μm or less determined by electron microscope observation. In this case, the rubber-like polymer fine particle has preferably a primary particle average particle diameter of 0.01 to 5 μm, more preferably 0.05 to 2 μm.

The rubber-like polymer fine particle is used in a proportion of 1 mass % or more in the composition for a liquid crystal display cell sealant of the present invention, whereby adhesion reliability after a pressure cooker test of a liquid crystal display element itself produced using the composition for a liquid crystal display cell sealant of the present invention can be raised. On the other hand, this is controlled to 25 mass % or less, whereby heat resistant rigidity required to the cured matter can be secured, and therefore such a content is preferred. In particular, the rubber-like polymer fine particle (4) falls more preferably in a range of 1 to 20 mass %, particularly preferably 1 to 15 mass % in terms of a proportion based on the composition for a liquid crystal display cell sealant.

Also, a softening point of the rubber-like polymer fine particle (4) is controlled to 0°C or lower, whereby the adhesion reliability tends to be raised more at a low temperature, and therefore that is preferred. Further, the primary particle diameter of the rubber-like polymer fine particle (4) is controlled to 5 μm or less, whereby a gap in the liquid crystal cell can be thinned, and a use amount of expensive liquid crystal can be controlled. In addition thereto, the liquid crystal display response speed can be improved as well.

Further more preferred rubber-like polymer fine particle (4) includes a silicone rubber fine particle and/or an acryl rubber fine particle or a polyolefin rubber fine particle each having a softening point of -30°C or lower and a primary particle diameter falling in a range of 0.01 to 3 μm, and the rubber-like polymer fine particle (4) is more preferably a cross-linking rubber particle.

The following known rubber-like polymers can suitably be selected and used for these rubber-like polymer fine particle (4) as long as they have a softening point of 0°C or lower.

Given as examples thereof are, for example, rubber-like polymers of an acryl rubber base, rubber-like polymers of a silicone rubber base, rubber-like polymers of a conjugated diene rubber base, rubber-like polymers of an olefin rubber base, rubber-like polymers of a polyester rubber base, rubber-like polymers of a urethane rubber base, composite rubber and rubber-like polymers having a functional group reacting with an epoxy group. In particular, among these rubber-like polymers, preferred are those having a functional group reacting with an epoxy group.

These rubber-like polymers (4) used for the composition for a liquid crystal display cell sealant may be used

alone or in a mixture of two or more kinds selected from those described above.

Specific examples of these rubber-like polymer fine particles shall be shown below.

<Rubber-like polymer fine particles of an acryl rubber base>

Specific examples of the rubber-like polymer fine particle of an acryl rubber base include, for example, particles obtained by drying a core/shell type emulsion in which a core part comprises acryl rubber, a resin composition obtained by subjecting an acryl base monomer to non-aqueous dispersion polymerization in an epoxy resin and a resin composition which is obtained by preparing separately a solution of an acryl rubber polymer into which a functional group reacting with an epoxy group is introduced and then pouring or dropwise adding it into an epoxy resin to mechanically mix, followed by romoving the solvent from the solution or a resin composition obtained by grafting the acryl rubber polymer to the epoxy resin to stably disperse acryl rubber fine particles in the epoxy resin.

<Rubber-like polymer fine particle of a silicone rubber base>

Specific examples of the rubber-like polymer fine particles of a silicone rubber base include, for example, powdery silicone rubber fine particles and a resin composition obtained by introducing a double bond into an epoxy resin, reacting the epoxy resin with a silicon macro monomer having an acrylate group at a single end which is capable of reacting with the double bond and then charging vinyl silicon and hydrogen silicon into the reaction product to dispersion polymerize.

<Rubber-like polymer fine particles of a conjugated diene rubber base>

Specific examples of the rubber-like polymer fine particles of a conjugated diene rubber base include, for example, conjugated diene rubber-like polymer fine particles obtained by polymerizing or copolymerizing monomers such as 1,3-butadiene, 1,3-pentadiene, isoprene, 1,3-hexadiene and chloroprene. They may be publicly known ones and shall not specifically be restricted. Commercial products can be used as they are. More specific examples of the conjugated diene rubber include a copolymer of butadiene with acrylonitrile, a copolymer of butadiene having a carboxyl group at an end with acrylonitrile and a copolymer of butadiene having an amino group at an end with acrylonitrile.

<Rubber-like polymer fine particles of an olefin rubber base>

Specific examples of the rubber-like polymer fine particles of an olefin rubber base include, for example, fine particles comprising amorphous homopolymers of ethylene, propylene, 1-butene, 2-butene and isobutene or copolymers or terpolymers thereof with other copolymerizable monomers, or compositions thereof. A good example is a resin composition obtained by subjecting a product commercially available in the form of an olefin rubber latex to dehydrating treatment in an epoxy resin to disperse and stabilize the olefin rubber in the epoxy resin.

<Rubber-like polymer fine particles of a polyester rubber base>

The rubber-like polymer fine particle of a polyester rubber base is a fine particle comprising a rubber-like polymer having a polyester bond in a polymer skeleton and shall not specifically be restricted. Specific examples of the polyester rubber include, for example, low softening point polyester rubbers derived from at least one diol component selected from liquid polysiloxanediol, liquid polyolefindiol, polypropylene glycol and polybutylene glycol ,if necessary, in the presence of triol or a polyhydric alcohol compound which has more hydroxyl groups than triol and at least one dibasic acid selected from adipic acid, maleic acid, succinic acid and phthalic acid, low softening point polyester rubbers prepared by substituting acid anhydrides for the dibasic acids described above or low softening point polyester resins derived from hydroxypolycarboxylic acids and the like.

<Rubber-like polymer fine particles of a urethane rubber base>

The rubber-like polymer fine particle of a urethane rubber base is a fine particle comprising a rubber-like polymer having a urethane bond and/or a urea bond in a rubber-like polymer skeleton and shall not specifically be restricted. Specific examples of the urethane rubber include, for example, rubber-like polyurethanes obtained by reacting at least one diol component selected from liquid polysiloxanediol, liquid polyolefindiol, polypropylene glycol and polybutylene glycol, if necessary, in the presence of triol or a polyhydric alcohol compound which has more hydroxyl groups than triol with a known diisocyanate compound represented by hexamethylenediisocyanate, isophoronediisocyanate, tolylenediisocyanate, diphenylmethanediisocyanate and norbornanediisocyanate, and rubber-like polyurethanes obtained by reacting at least one long chain diamine component selected from liquid polysiloxanediamine, liquid polyolefindiamine and polypropylene glycoldiamine , if necessary, in the presence of triamine or a polyamine compound which has more amino groups than triamine with a known diisocyanate compound represented by hexamethylenediisocyanate, isophoronediisocyanate, tolylenediisocyanate, diphenylmethanediisocyanate and norbornanediisocyanate.

<Composite rubber particle>

Given as examples of the composite rubber are, for example, fine particles comprising graft polymers and/or block polymers or core/shell polymers and composite polymers each comprising two or more kinds of the acryl base, the silicone base, the conjugated diene base, the olefin base, the polyester base and the urethane base each described above.

<Rubber-like polymers having a functional group reacting with an epoxy group >

Representative examples of the rubber-like polymer having a functional group reacting with an epoxy group include, for example, polymers obtained by introducing functional groups reacting with an epoxy group into particles of the acryl base, the silicone base, the conjugated diene base, the olefin base, the polyester base and the urethane base each described above.

In the rubber-like polymer having a functional group reacting with an epoxy group, a repetitive structure originating in a monomer having the functional group reacting with an epoxy group accounts preferably for 0.1 to 25 mass % in terms of a weight proportion based on the rubber-like polymer.

An adhesive property of the resulting composition for a liquid crystal display cell sealant is notably improved by controlling a content of the repetitive structure originating in a monomer having the functional group reacting with an epoxy group to 0.1 mass % or more and 25 mass % or less.

The functional group reacting with an epoxy group includes, for example, a mercapto group, an amino group, an imino group, a carboxyl group, an acid anhydride group, an epoxy group and a hydroxyl group.

At least one of these functional groups is preferably introduced into the rubber-like polymer in a proportion of preferably 0.01 to 25 mass %, more preferably 0.1 to 10 mass %.

A method for introducing the functional groups shall not specifically be restricted and may be any one of introducing methods carried out by a random copolymerization method, an alternate copolymerization method, a condensation polymerization method, an addition polymerization method, a core-shell polymerization method in each of which a functional group-containing monomer is polymerized with a monomer constituting a main chain polymer, an ion adsorption-introducing method, a swelling impregnation-introducing method and a method of graft-polymerizing with a polymer forming a rubber-like polymer.

Among them, the copolymerizing method and the graft-polymerizing method are preferred since necessary functional groups can efficiently be introduced into the vicinity of a rubber-like polymer fine particle surface in a smaller amount.

In the composition for a liquid crystal display cell sealant of the present invention, the rubber-like polymer fine particle (4) preferably take the form of a particle in the epoxy resin.

A method for distinguishing that the rubber-like polymer fine particle (4) is present in the form of a particle in the epoxy resin shall not specifically be restricted, and being suitably employed are, for example, a method in which a mixture of an epoxy resin having no turbidity and a rubber-like polymer fine particle is prepared and the above composition is observed under an optical microscope to confirm the presence of the above rubber-like polymer fine particle in the form of a particle and a method in which a prescribed amount of a polymercaptan base curing agent is added to the above composition to obtain a cured matter and a cutting plane of a minute piece is sensitized by dyeing with osmic acid to be observed under a scanning electron microscope to confirm the presence of the particles.

The rubber-like polymer fine particle (4) may or may not be grafted in advance to the epoxy resin (1) in the composition for a liquid crystal display cell sealant of the present invention.

A method for determining the kind, the amount and the particle diameter of the rubber-like polymer fine particle (4) contained in the composition for a liquid crystal display cell sealant of the present invention and the sealant for a liquid crystal display cell shall not specifically be restricted, and can be carried out in a suitable combination of, for example, a method in which a scanning electron microscopic image (SEM) of a piece of the cured matter thereof is analyzed, a method in which the above piece is sensitized by dyeing with osmic acid and then a particle image is observed by means of a transmission electron microscope (TEM), a method in which the analytical image of elemental analysis is compared together with observation by SEM to identify and determine the particles, a method of judging by subjecting the micro layer to measurement of microscopic infrared absorption spectra, a method in which the micro layer is irradiated with a heat ray and a gas component generated by decomposition is identified and a method in which

a specific volume of the micro layer is converted to determine the mass ratio.

(5) Inorganic filler:

The inorganic filler (5) may be any ones as long as they can usually be used as inorganic fillers in the electronic material field. To be specific, they include, for example, calcium carbonate, magnesium carbonate, barium sulfate, magnesium sulfate, aluminum silicate, zirconium silicate, iron oxide, titanium oxide, aluminum oxide (alumina), zinc oxide, silicon dioxide, potassium titanate, kaolin, asbestos powder, amorphous silica powder, quartz powder, mica, glass fiber, carbon black, silicon nitride, aluminum nitride and titanium trinitride. They can be used alone or in a mixture of two or more kinds thereof.

The preferred inorganic filler (5) is high purity silica and/or high purity alumina or titanium oxide.

More preferably included are high purity silica and/or high purity alumina or titanium oxide in which a total amount of the contents of alkali metals determined by an atomic absorption spectrometry of the inorganic filler decomposition products under a wet condition is 50 ppm or less, preferably 30 ppm or less and particularly preferably 15 ppm or less. This makes it possible to inhibit free ions from transferring from a cured matter of the composition for a liquid crystal display cell sealant of the present invention to the liquid crystal phase. A refining method for reducing the total of the contents of the alkali metals to 50 ppm or less metals shall not specifically be restricted, and refining can be carried out by, for example, an ion exchange refining method for an aqueous solution of the raw materials for production and refined.

Also, the inorganic filler (5) has preferably a particle diameter falling in a range of 5 μm or less of a value at 99 weight % ($d^{99}$) on a weight integration curve, which is determined by means of a laser method particle size-measuring instrument using laser having a wavelength of 632.8 nm, and it has more preferably a weight average particle diameter falling in a range of 0.005 to 1 μm, which is shown by a value at 50 weight % ($d^{50}$) on the weight integration curve.

In general, use of the inorganic filler having a $^{d99}$ of 5 μm or less elevates further more dimensional stability of a gap width in the liquid crystal panel and therefore is preferred.

In the composition for a liquid crystal display cell sealant of the present invention, the inorganic filler (5) is used if necessary, and a preferred content thereof is 5 to 45 mass %. The content of 5 mass % or more makes it possible to improve a coating workability in screen printing or dispenser coating. On the other hand, the content controlled to 45 mass % or less makes it possible to secure fluidity of the composition and carry out a coating work without causing frequently blurring in screen printing or dispenser clogging, and therefore such a control is preferred. In particular, the content falls preferably in a range of 10 to 40 mass %.

The inorganic filler (5) shall not specifically be restricted and is preferably used after modified in advance by grafting with the epoxy resin (1) and the silane coupling agent (6).

In modification by grafting, a part or the whole of the inorganic filler (5) may be modified by grafting. In this case, the grafting rate is shown by a mass increasing rate determined by a repetitive solvent washing method, and usually either or both of the epoxy resin (1) and the silane coupling agent (6) of 1 to 50 mass parts per 100 mass parts of the inorganic filler (5) are preferably chemically bonded.

A method for determining the kind and the amount of the inorganic filler (5) contained in the composition for a liquid crystal display cell sealant of the present invention shall not specifically be restricted, and can be carried out in a suitable combination of, for example, a filtering fractionation method, an X-ray diffraction spectral method, an elemental analysis method, an ignition residue method, a wet thermal decomposition-atomic absorption method and an analysis of electron microscope observation image. A means for determining the kind and the amount of the inorganic filler contained in the sealant for a liquid crystal display cell which is a cured matter thereof shall not specifically be restricted, and can be carried out in a suitable combination of, for example, an X-ray diffraction spectral method, an elemental analysis method, an ignition residue method, a wet thermal decomposition-atomic absorption method and an analysis of electron microscope observation image.

(6) Silane coupling agent:

In the composition for a liquid crystal display cell sealant of the present invention, a silane coupling agent (6) is used if necessary, and a preferred content thereof is 0.1 to 5 mass %. Use of 0.1 mass % or more makes it possible to secure the adhesive property to a glass substrate, and use exceeding 5 mass % can not bring out further more marked working effects. The content is preferably 0.5 to 3 mass %.

Any ones which are usually used can be used as the silane coupling agent (6), and trialkoxysilane compounds and methyldialkoxysilane compounds can be given as examples thereof. Given as preferred examples thereof are γ-glycidoxypropylmethyldimethoxy-silane, γ-glycidoxypropyltrimethoxysilane, γ-glycidoxy-propylmethyldiethoxysilane, γ-glycidoxypropyltriethoxy-silane, γ-aminopropylmethyldimethoxysilane, γ-amino-propyltrimethoxysilane, γ-aminopropylmethyldiethoxysilane, γ-aminopropyltriethoxysilane, N-aminoethyl-γ-aminopropylmethyldimethoxysilane, N-aminoethyl- γ-aminopropyltrimethoxysilane, N-aminoethyl-γ-aminopropylmethyldiethoxysilane, N-phenyl-γ-aminopropyltrimethoxysilane, N-phenyl- γ -aminopropyltriethoxysilane, N-phenyl- γ -aminopropylmethyldimethoxysilane, N-phenyl-γ-aminopropylmethyldiethoxysilane, γ -mercaptopropylmethyldimethoxysilane, γ-mercaptopropyltrimethoxysilane, γ -mercaptopropylmethyldiethoxysilane, γ-mercaptopropyl-triethoxysilane, γ-isocyanatopropylmethyldiethoxysilane and γ-isocyanatopropyltriethoxysilane. Among them, more preferred is at least one selected from γ-glycidoxypropyltrimethoxysilane, γ -glycidoxypropyltriethoxysilane, N-phenyl- γ -aminopropyltrimethoxysilane and γ-isocyanatopropyltriethoxysilane.

A method for determining the kind and the amount of the silane coupling agent (6) contained in the composition for a liquid crystal display cell sealant of the present invention shall not specifically be restricted, and can be carried out in a suitable combination of, for example, a solvent extraction fractionation method, an NMR spectral identification method, a gas chromatography method and a distillation fractionation method. A means for determining the kind and the amount of the silane coupling agent contained in the sealant for a liquid crystal display cell which is a cured matter thereof shall not specifically be restricted, and can be carried out in a suitable combination of, for example, a thermal decomposition gas chromatography-mass spectroscopy method and solid NMR method.

(7) Solvent:

In the composition for a liquid crystal display cell sealant of the present invention, the solvent (7) which is compatible with an epoxy resin and has a boiling point falling in a range of 150 to 220°C and which is inactive to an epoxy group may be added in a range of 1 to 25 mass parts per 100 mass parts of the above composition. Addition of the solvent makes it possible to elevate the screen printing aptitude and the wettability to an adherend. High boiling solvents having a boiling point falling in a range of 160 to 200°C are preferably given.

Specific examples of the solvent (7) shall not specifically be restricted, and preferred examples thereof include, for example, ketone solvents such as cyclohexanone, ether solvents and acetate solvents.

Specific examples of the ether solvents include ethylene glycol monomethyl ether, ethylene glycol monoethyl ether, ethylene glycol monopropyl ether, ethylene glycol monobutyl ether, ethylene glycol monophenyl ether, ethylene glycol dimethyl ether, ethylene glycol diethyl ether, ethylene glycol dipropyl ether, ethylene glycol dibutyl ether, ethylene glycol diphenyl ether, diethylene glycol monomethyl ether, diethylene glycol monoethyl ether, diethylene glycol monopropyl ether, diethylene glycol monobutyl ether, diethylene glycol monophenyl ether, diethylene glycol dimethyl ether, diethylene glycol diethyl ether, diethylene glycol dipropyl ether, diethylene glycol dibutyl ether and diethylene glycol diphenyl ether.

The acetate solvents include preferably, for example, ethylene glycol monoacetate, ethylene glycol monomethyl ether acetate, ethylene glycol monoethyl ether acetate, ethylene glycol monopropyl ether acetate, ethylene glycol monobutyl ether acetate, ethylene glycol monophenyl ether acetate, ethylene glycol diacetate, diethylene glycol monomethyl ether acetate, diethylene glycol monoethyl ether acetate, diethylene monobutyl ether acetate and diethylene glycol diacetate.

The particularly preferred solvent (7) is at least one selected from ethylene glycol monobutyl ether, ethylene glycol monomethyl ether acetate, diethylene glycol dimethyl ether, propylene glycol monomethyl ether, propylene glycol monomethyl ether acetate, propylene glycol monoethyl ether acetate and propylene glycol diacetate.

A method for determining the kind and the amount of the solvent contained in the composition for a liquid crystal display cell sealant shall not specifically be restricted, and can be carried out in a suitable combination of, for example, a drying loss method, a gas chromatography (fractionation) method, a distillation fractionation method, a gas chromatography-mass spectrometry method, an infrared absorption spectral method and an NMR method.

(8) High softening point-polymer fine particle having a softening point of 50°C or higher and an average primary particle diameter of 2 μm or less:

In the composition for a liquid crystal display cell sealant of the present invention, the high softening point-polymer fine particle (8) may be added, if necessary, in a range of 0.1 to 25 mass parts per 100 mass parts of the above composition. Combined use of 0.1 mass part or more makes it possible to ensure further more the seal adhesion in which through bubbles and bleeding are not caused at a primary adhesion step by a vacuum single layer hot press or a normal single layer hot press. On the other hand, combined use of 25 mass parts or less makes it possible to sufficiently secure the gap-forming workability and therefore such contents are preferred.

The high softening point-polymer fine particle (8) is the high softening point-acryl polymer fine particle (8) (hereinafter referred to merely as the high softening point polymer fine particle) having a softening point of 50°C or higher in terms of a softening point determined by TBA and an average particle diameter of 2 μm or less in a primary particle determined by observation under an electron microscope.

The gap-forming workability can be secured by controlling an average particle diameter of the primary particles

of the high softening point-acryl polymer fine particle (8) to 2 μm or less. The average particle diameter of the primary particles falls preferably in a range of 0.01 to 1 μm, more preferably 0.2 to 0.5 μm.

The high softening point-acryl polymer fine particle (8) of either a cross-linking type or a non-cross-linking type can be used, and the cross-linking type is preferred. In particular, the high softening point-acryl polymer fine particle having a micro crosslinking structure is more preferred.

The high softening point-acryl polymer fine particle having a micro cross-linking structure can be produced by controlling a cross-linkable monomer to a range of 0.1 to 5 mass %, preferably 1 to 3 mass % based on the whole monomers in producing the polymer.

A gel content is one of indices for a degree of the micro cross-linking. This is an index determined by the following equation, wherein 10 g of the high softening point-polymer fine particle is dispersed in 50 g of a methylcarbitol solvent and stirred for one hour at 25°C, and then it is filtered to determine a quantity of filtrate and a polymer content (dissolved amount) in the filtrate:

$$\text{gel content (\%)} = (\text{dissolved amount}/10\text{ g}) \times 100$$

This gel content index falls preferably in a range of 0 to 50 %, more preferably 0 to 5 %.

The high softening point-acryl polymer fine particle falls preferably in a range of 9 to 11, more preferably 9.3 to 10.5 in terms of a wetting index calculated from the chemical structural formula.

Given as specific examples of the high softening point-acryl polymer fine particle (8) are, for example, polymers having micro cross-linking polymethyl methacrylate as the main component which is obtained by copolymerizing 0.1 to 5 mass % of cross-linkable monomers and polymethyl methacrylate polymers having an ionomer structure falling in a range of 0.1 to 5 mass %. In this high softening point-acryl polymer fine particle, one kind of a functional group such as an epoxy group, an amino group, an imino group, a mercapto group and a carboxyl group is more preferably introduced into a particle surface thereof.

More preferred are those having a softening point of 60 to 150°C and a primary particle diameter falling in a range of 0.01 to 1 μm.

In the composition for a liquid crystal display cell sealant of the present invention, the rubber-like polymer fine particle (4) and the high softening point-acryl polymer fine particle (8) may be composited in advance, and included is, for example, an embodiment in which, for example, the rubber-like polymer fine particle (4) forms a core phase and the high softening point-acryl polymer fine particle (8) forms a shell phase, a so-called core/shell type composite fine particle (A) of (4) and (8). Also, in contrast with this, a preferred example is an embodiment using a core/shell type composite fine particle (B) in which the high softening point-acryl polymer fine particle (8) forms a core phase and the rubber-like polymer fine particle (4) forms a shell phase. In particular, preferred is an embodiment using the former core/shell type composite fine particle (A).

In the core/shell type composite fine particle (A) containing the rubber-like polymer fine particle (4) as the core phase, a mass ratio of core : shell falls preferably in a range of (1 : 0.3) to (1 : 2).

A method for determining the kind or the amount ratio of the high softening point-polymer fine particle contained in the composition for a liquid crystal display cell sealant or the sealant for a liquid crystal display cell shall not specifically be restricted, and can be carried out by the same method as the measuring method of the rubber-like polymer fine particle described above.

(9) Gap-forming controller:

In the composition for a liquid crystal display cell sealant of the present invention, more preferred embodiment is the composition prepared by further adding the gap-forming controller (9) to the epoxy resin composition described above.

The gap-forming controller (9) is a substance for controlling optionally and accurately a gap width of a liquid crystal display element in a width of about 3 to 7 μm. Either of organic or inorganic substances can be used as long as such control can be carried out.

The gap-forming controller (9) is suitably added, if necessary, preferably in a proportion of 0.1 to 5 mass parts per 100 mass parts of the composition for a liquid crystal display cell sealant of the present invention. More preferable range is 0.5 to 2.5 mass parts.

The gap-forming controller (9) includes, for example, vertically and horizontally symmetric inorganic particles or thermosetting polymer particles such as spherical or Rugby ball-like particles and cylindrical fibers which are not deformed, dissolved or swollen by the epoxy resin (1) or the solvent (7) used if necessary.

Examples of the inorganic particles in the gap-forming controller (9) include spherical silica particles, spherical alumina particles, glass short fibers, metal short filaments and metal powders.

The organic gap-forming controller (9) includes thermosetting polystyrene spherical particles, other phenol resin base thermosetting particles and benzoguanamine resin base thermosetting particles.
The inorganic particles are a particularly preferred example since they can control the gap accuracy at a high accuracy.
A method for determining the kind or the amount ratio of the gap-forming controller contained in the composition for a liquid crystal display cell sealant or the sealant for a liquid crystal display cell shall not specifically be restricted, and includes, for example, an SEM-observed image analysis of the cured matter, a TEM-observed image analysis of the cured matter, a separating filtration method, a thermal decomposition gas chromatography method, an ignition residue X-ray diffraction method and an elemental analysis.

(10) Conductive beads:

In the composition for a liquid crystal display cell sealant of the present invention, included as a preferred embodiment is the composition prepared by further using the conductive beads (10) of 1 to 15 mass parts per 100 mass parts of the epoxy resin composition described above in combination for the purpose of providing a function of an anisotropic conductivity together with a sealing property. Addition of the conductive beads in a proportion of 1 to 15 mass parts makes it possible to provide a function of the anisotropic conductivity. Use of 1 mass part or more makes it possible to provide the vertical conductive function. On the other hand, use of less than 15 mass parts makes it possible to secure an insulating characteristic between horizontal (left and right) electrodes and therefore is preferred.
The conductive beads (10) shall not specifically be restricted, and preferred are, for example, the conductive beads having an average particle diameter of 3 to 10 μm, a maximum particle diameter of 10 μm or less and a minimum particle diameter of 0.1 μm or more.
The kind of the conductive beads shall not specifically be restricted, and specific examples thereof shall be shown below.
They may be, for example, noble metal beads, noble metal alloy beads, base metal beads, base metal alloy beads, other metal-coated type organic beads and metal-coated type insulating inorganic beads.

(Noble metal)

For example, gold, silver and platinum can be given as examples thereof.

(Noble metal alloy)

Given as examples thereof are, for example, silver-copper alloy, gold-copper alloy, gold-silver alloy, platinum-silver alloy, gold-platinum alloy, gold-nickel alloy and silver-nickel alloy.

(Base metal)

For example, copper, nickel, tin and tungsten can be given as examples thereof.

(Base metal alloy)

For example, copper-nickel alloy, copper-tin alloy and solder can be given as examples thereof.

(Metal-coated type organic particles)

Representative examples thereof include, for example, particles obtained by forming the conductive metal films described above on particles of organic polymers represented by polystyrene and polymethyl methacrylate. "Micropearl AU series", a brand name, manufactured by Sekisui Fine Chemical Co., Ltd. is known as a commercial product and can preferably be used.

(Metal-coated type insulating inorganic particles)

Representative examples thereof include, for example, particles obtained by forming the conductive metal films described above on high insulating inorganic particles represented by mica and glass beads.
From a viewpoint that the conductive beads are liable to secure primary dispersion stability, preferred is an embodiment in which the metal-coated type organic particles account for 3 to 7 volume % in terms of a proportion based on the composition for a liquid crystal display cell sealant of the present invention. In particular, in the composition

for a liquid crystal display cell sealant of the present invention, most preferred is the composition using the conductive beads (10) whose core is an organic polymer and coated with a metal-layer of at least one selected from gold, silver, gold-copper alloy, silver-copper alloy, nickel and alloys thereof.

An average particle diameter of the conductive beads falls preferably in the range described above, and use of the beads having an average particle diameter of 1 μm or less makes it difficult to obtain the good vertical conduction characteristic even if the conductive particles are present between the electrodes. On the other hand, use of the beads having an average particle diameter or the maximum particle diameter exceeding 10 μ m is liable to cause a short circuit.

A method for determining the kind or the amount ratio of the conductive beads (conductive particles) contained in the composition for a liquid crystal display cell sealant or the sealant for a liquid crystal display cell shall not specifically be restricted, and can be carried out in a suitable combination of, for example, an elemental analysis, a TEM or SEM image analysis of the cured matter and a filtering fractionation method.

Other additives:

In the composition for a liquid crystal display cell sealant of the present invention, a wax, a leveling agent, a pigment, a dye, a plasticizer and a defoaming agent can further be used if necessary.

(11) Wax

In the composition for a liquid crystal display cell sealant of the present invention, a wax (11) can be used for the purpose of improving further more the low moisture permeability function and the low water absorbing property while maintaining the adhesive property. The wax (11) is added preferably in a proportion of 0.1 to 5 mass parts per 100 mass parts of the composition for a liquid crystal display cell sealant of the present invention.

The wax controlled to 0.1 mass part or more or more and 5 mass parts or less per 100 mass parts of the composition for a liquid crystal display cell sealant, whereby it is possible to reduce further more a moisture permeability at 80°C of the above cured matter under a high temperature and high humidity environment of 80°C and a relative humidity of 95 % or more. This makes it possible to produce the liquid crystal display cell having high durability.

The wax (11) shall not specifically be restricted, and any waxes can be used. It includes, for example, animal base natural wax, plant base natural wax, mineral base natural wax, petroleum base wax, synthetic hydrocarbon base wax, modified wax and hydrogenated wax.

Among them, preferred are waxes having a melting point of 70°C or higher and 150°C or lower, and more preferred are carnauba wax, microcrystalline wax, Fischer-Tropsch wax and modified Fischer-Tropsch wax.

In the composition for a liquid crystal display cell sealant of the present invention comprising the wax (11), the wax is present preferably in the form of an independent primary particle in the state before curing of the composition for a liquid crystal display cell sealant. The primary particle has preferably an average particle diameter falling in a range of 0.01 to 5 μm, more preferably 0.01 to 3 μm which is determined by observation under an electron microscope or an optical microscope.

More specific examples of the wax (11) shall be shown below.

Animal base natural wax:

Included are, for example, bees wax, spermaceti wax and shellac wax.

Plant base natural wax:

Included are, for example, carnauba wax, auricurie wax, candelilla wax, Japan tallow and cane wax.

Mineral base natural wax:

Included are, for example, montan wax, ozokerite and ceresine.

Petroleum base wax:

Included are, for example, paraffin wax and microcrystalline wax.

synthetic hydrocarbon base wax:

Included are, for example, Fischer-Tropsch wax and derivatives thereof, polyethylene wax and derivatives

thereof and polypropylene wax and derivatives thereof.

Modified wax:

Included are, for example, oxide wax, montan wax and acid-modified wax.

Hydrogenated wax:

Included are, for example, amide wax such as stearic acid amide wax, polyester wax and opal wax.

Preparation process of composition for liquid crystal display cell sealant:

The composition for a liquid crystal display cell sealant of the present invention can be prepared by suitably adding and mixing the epoxy resin (1), the polyphenol curing agent (2), the curing accelerator (3) comprising at least one selected from alkylurea derivatives and a phosphazene compounds and if necessary, the rubber-like polymer fine particle (4) having a softening point of 0°C or lower and an average particle diameter of 5 μm or less in primary particles, the inorganic filler (5), the silane coupling agent (6), the solvent (7), the high softening point-polymer fine particle (8), the gap-forming controller (9), the conductive beads (10), the wax (11) and other additives such as a leveling agent, a pigment, a dye, a plasticizer and a defoaming agent, and the process shall not specifically be restricted.

They can be mixed by means of a known machine such as a double arm stirrer, a roll mixer and a twin screw extruder, and the composition is subjected to vacuum degassing treatment, finally charged into a glass bottle or a plastic vessel and tightly sealed, stored and transported.

Physical properties of the composition for liquid crystal display cell sealant:

A viscosity of the composition for a liquid crystal display cell sealant before curing shall not specifically be restricted, and the viscosity at 25°C determined by a Brookfield type viscometer (B type viscometer) or an E type viscometer falls preferably in a range of 1 to 1000 Pa·s, more preferably 5 to 500 Pa·s and most preferably 10 to 200 Pa·s. The composition for a liquid crystal display cell sealant of the present invention is controlled in advance to a viscosity of the range described above by a method such as heating and aging and then produced.

The thixotropic index represented by, for example, a ratio of a viscosity value at 1 rpm determined from a shear rate of 1 revolution per minute to a viscosity value at 10 rpm at a shear rate of 10 revolutions per minute (viscosity value at 1 rpm/viscosity value at 10 rpm), in which the same rotor number of the B type viscometer or the E type viscometer is used, though not specifically be restricted, falls preferably in a range of 1 to 3.

Production process for liquid crystal display element:

A production process for the liquid crystal display element of the present invention is a production process for a liquid crystal display element comprising TN liquid crystal, STN liquid crystal, ferrodielectric liquid crystal or anti-ferrodielectric liquid crystal, comprising the steps of:

printing or dispenser-coating the composition for a liquid crystal display cell sealant of the present invention on a bonding and sealing part of a glass-made or plastic-made substrate for a liquid crystal cell and precuring it at a temperature of 50 to 120°C,
then adjusting a position and superposing the other paired substrate thereon to temporarily fix them,
subjecting the paired substrates to hot cramping treatment at 80 to 200°C to bond and fix the above paired substrates in a homogeneous thickness falling in a range of 3 to 7 μm to form a liquid crystal display cell, and
then charging a liquid crystal material into the above cell and sealing the injection port with a photocuring type liquid crystal sealant composition or a two-liquid type liquid crystal sealant composition.

Further, another production process for the liquid crystal display element of the present invention is a production process for a liquid crystal display element comprising TN liquid crystal, STN liquid crystal, ferrodielectric liquid crystal or anti-ferrodielectric liquid crystal, comprising the steps of:

printing or dispenser-coating the composition for a liquid crystal display cell sealant of the present invention on a bonding and sealing part of a glass-made or plastic-made substrate for a liquid crystal cell and precuring it at a temperature of 50 to 120°C,
then putting dropwise the liquid crystal thereon and superposing the other paired substrate thereon so that air is

not shut therein and adjusting a position thereof to temporarily fix them,
subjecting the paired substrates to hot cramping treatment at 80 to 150°C to bond and fix the above paired substrates in a homogeneous thickness falling in a range of 3 to 7 μm, and
then sealing the respiratory port with a photocuring type liquid crystal sealant composition or a two-liquid type liquid crystal sealant composition.

In this case, precuring is required in advance in order to completely cure the composition for a liquid crystal display cell sealant containing a solvent. The precuring conditions shall not specifically be restricted. A heating and drying temperature at which the solvent contained can usually be removed by at least 95 mass % based on 100 of the solvent and which is not higher than a thermally active temperature of the curing agent contained is usually selected. It is preferably 70 to 120°C. General precuring conditions are more preferably a precuring temperature falling in a range of 80 to 100°C and a heat treatment time of 30 to 5 minutes. The drying time is preferably shorter as the temperature is higher. The solvent may be removed in precuring at a temperature exceeding 120°C, but the accuracy in the gap width tends to be reduced as the curing reaction advances, and therefore precautions have to be taken.

The substrate used for the liquid crystal cell includes, for example, a glass substrate and a plastic substrate. It is a matter of course in these substrate group that used is a so-called liquid crystal cellconstituting glass substrate or plastic substrate in which provided on needed parts are a transparent electrode represented by indium oxide, an alignment film represented by polyimide and in addition thereto, an inorganic ion-shielding film and the like.

A method of coating the composition for a liquid crystal display cell sealant on a substrate shall not specifically be restricted, and includes, for example, a screen printing coating method and a dispenser coating method. After coating, predrying is carried out, if necessary, and then bonding is carried out by superimposing and hot cramping to bond and seal. In this case, heat curing conditions shall not specifically be restricted and are 100 to 200°C and 24 to 0.5 hour, preferably 110 to 180°C and 24 to 1 hour.

In carrying out a hot press bonding step by means of a single layer hot press, bonding is carried out under a condition under which a temporary adhesive property can be secured, though specifically be restricted, preferably at 110 to 180°C for 10 to 2 minutes, then the pressure is reduced to take out the substrates, and subsequently they are subjected to two-stage or plural heating steps and aging steps in which it is completely cured and aged in a heated oven controlled to the above temperature.

In this case, the single layer hot press means a hot pressing machine having a specification to carry out bonding set by set. Known are a vacuum single layer hot press which is a single layer hot press apparatus capable of heating under vacuum and a normal single layer hot press of a type in which hot press bonding is forcibly carried out via a hot plate under atmospheric pressure. Either single layer hot press system can be used.

Also, it is no problem to carry out the hot press bonding adhesion step by means of a multistage hot press separately from the single layer hot press described above.

Liquid crystal display element:

The liquid crystal display element of the present invention is a liquid crystal display element obtained by a production process for a liquid crystal display element characterized by comprising:

printing or dispenser-coating the composition for a liquid crystal display cell sealant of the present invention on a bonding and sealing part of a glass-made or plastic-made substrate for a liquid crystal cell and precuring it at a temperature of 70 to 120°C,
then adjusting a position in a pair with the other non-coated paired substrate,
subjecting the paired substrates to hot press treatment at 100 to 200°C to bondand fix the above paired substrates in a homogeneous thickness falling in a range of 3 to 7 μm to obtain a liquid crystal display cell, and
then charging a liquid crystal material into the above cell and sealing the injection port with a two-liquid type liquid crystal sealant composition, or a liquid crystal display element obtained by a production process for a liquid crystal display element characterized by comprising:

> printing or dispenser-coating the composition for a liquid crystal display cell sealant of the present invention on a bonding and sealing part of a glass-made or plastic-made substrate for a liquid crystal cell and precuring it at a temperature of 50 to 120°C,
> then putting dropwise the liquid crystal thereon and superposing the other paired substrate thereon so that air is not shut therein to temporarily fix them,
> subjecting the paired substrates to hot cramping treatment at 80 to 150°C to bond and fix the above paired substrates in a homogeneous thickness falling in a range of 3 to 7 μm, and
> then sealing the respiratory port with a photocuring type liquid crystal sealant composition or a two-liquid type

liquid crystal sealant composition.

The photocuring liquid crystal sealant composition shall not specifically be restricted and may be, for example, a composition comprising a polyacrylate resin and a photoinitiator, a composition comprising an epoxy resin and a UV-ray initiator, a composition comprising an oxetane compound and a UV-ray initiator or a composition comprising an epoxy resin, oxetane and a photoinitiator.

The two-liquid type liquid crystal sealant composition shall not specifically be restricted, and given as examples thereof are, for example, a two-liquid type liquid crystal sealant composition comprising an epoxy resin and a polyamide curing agent, a two-liquid type liquid crystal sealant composition comprising an epoxy resin and a polythiol curing agent and a two-liquid type liquid crystal sealant composition comprising an epoxy resin and a polyamine curing agent.

The liquid crystal materials shall not be restricted as well, and nematic liquid crystal and ferroelectric liquid crystal can suitably be used.

Preferred examples of the liquid crystal display element obtained in the present invention include, for example, a TN type (twisted nematic) liquid crystal element or an STN type (super twisted nematic) liquid crystal element which is proposed by M. Schadt and W. Helfrich, a ferroelectric type liquid crystal element proposed by N. A. Clark and S. T. Lagerwall and a liquid crystal display element provided on each pixel with a thin film transistor (TFT).

Examples

The present invention shall be explained below in details with reference to representative examples and comparative examples, but the present invention shall not be restricted thereto. Percentage and part in the examples show mass % and mass part respectively.

The kinds (abbreviation codes) of raw materials in the respective examples are as follows.

Test methods:

Methods of the evaluation tests carried out for the compositions for a liquid crystal display cell sealant and the cured matters thereof used in the examples and the comparative examples shall be shown.

(Storage stability test)

A polyethylene-made vessel was charged with 100 parts of the composition for a liquid crystal display cell sealant and tightly sealed. Then, the viscosity value after 30 days passed at -10°C was shown by a change rate in the viscosity, wherein the viscosity value at 20°C at the time of sealing by a B type viscometer was set at 100:

○: change rate is less than 10 %, and storage stability is good
Δ: change rate is 10 to 50 %, and a little problem is present in storage stability
×: change rate exceeds 50 %, and storage stability is inferior

(Coating workability test)

The composition for a liquid crystal display cell sealant tightly sealed and stored in a polyethylene-made vessel at the freezing point or lower was taken out and turned to 25°C of room temperature in 2 hours. The viscosity value at that time at 25°C by a B type viscometer was set at 100, and the workability was shown by a change rate in the viscosity after left standing at 25°C for 12 hours:

○: change rate is less than 15 %, and coating workability is good
Δ: change rate is 16 to 50 %, and coating workability is a little inferior
×: change rate exceeds 50 %, and coating workability aptitude is markedly inferior

(viscosity characteristic of B stage-reduced composition at 80 to 100°C by an E type viscometer)

The liquid crystal sealant compositions prepared in the respective examples were coated on a smooth release film in a thickness of 10 to 50 μm, and 0.6 part of the B stage-reduced composition lumps obtained under the B stage-reduced conditions in the respective examples was quickly sampled. The temperature was elevated from 40°C at a constant rate of 1°C/2 minutes by means of an E type viscometer (corn cup viscometer) to obtain a viscosity curve of up to 120°C [temperature]-[rotational viscosity at 0.5rpm]. The viscosity at 90°C was determined from the above viscosity curve:

X (-): viscosity at 90°C is less than 50 Pa·s
○: viscosity at 90°C is 5 to 300 Pa·s
◎ : viscosity at 90°C is 301 to 10000 Pa·s
X (+): viscosity at 90°C exceeds 10000 Pa·s

(Moisture permeability characteristic)

The liquid crystal sealant compositions prepared in the respective examples were coated on a smooth release film in a thickness of 70 to 120 μm and subjected to heat treatment at 80°C for 30 minutes, and then they were further subjected to hot curing at 150°C for 90 minutes to obtain a cured film. The cure film was cut out and subjected to a moisture permeability test according to a moisture permeability test method (cup method) JIS-Z-0208 of a damp proofing packaging material in Japan Industrial Standard (JIS) to determine the amount of moisture (unit: $g/m^2 \cdot 24$ hrs) per 100 μm of the film thickness which permeated at 60°C and 80°C in 24 hours:

◎ : moisture permeability characteristic at 60°C is less than 35 $g/m^2 \cdot 24$ hrs, and the composition for a liquid crystal display cell sealant is particularly excellent in a low moisture permeability
○: moisture permeability characteristic at 60°C is 35 to 80 $g/m^2 \cdot 24$ hrs, and the composition for a liquid crystal display cell sealant is excellent in a low moisture permeability
Δ: moisture permeability characteristic at 60°C is 81 to 150 $g/m^2 \cdot 24$ hrs, and the composition for a liquid crystal display cell sealant is considerably reduced in a low moisture permeability
×: moisture permeability characteristic at 60°C is 151 to 250 $g/m^2 \cdot 24$ hrs, and composition for a liquid crystal display cell sealant is a little lacking in a low moisture permeability
××: moisture permeability characteristic at 60°C is 251 $g/m^2 \cdot 24$ hrs or more, and composition for a liquid crystal display cell sealant is lacking in a low moisture permeability

In the case of moisture permeability characteristic at 80°C:

◎ : moisture permeability characteristic at 80°C is 100 $g/m^2 \cdot 24$ hrs or less, and the composition for a liquid crystal display cell sealant is particularly excellent in a low moisture permeability
○: moisture permeability characteristic at 80°C is 101 to 150 $g/m^2 \cdot 24$ hrs, and the composition for a liquid crystal display cell sealant is excellent in a low moisture permeability
Δ: moisture permeability characteristic at 80°C is 151 to 200 $g/m^2 \cdot 24$ hrs, and the composition for a liquid crystal display cell sealant is considerably reduced in a low moisture permeability
×: moisture permeability characteristic at 80°C is 201 to 350 $g/m^2 \cdot 24$ hrs, and composition for a liquid crystal display cell sealant is a little lacking in a low moisture permeability
××: moisture permeability characteristic at 80°C is 351 $g/m^2 \cdot 24$ hrs or more, and composition for a liquid crystal display cell sealant is lacking in a low moisture permeability

(Linear expansion coefficient of cured matter)

The liquid crystal sealant compositions prepared in the respective examples were coated on a smooth release film in a thickness of 70 to 120 μm and subjected to heat treatment at 80°C for 30 minutes, and then they were further subjected to hot curing at 150°C for 90 minutes to obtain a cured film. A small piece (15 mm square) of the cured film was cut out and subjected to TMA measurement by elevating the temperature from 30°C up to 180°C at 5°C per minute. The distortion observed from 30°C through 80°C was divided by 50 to determine a linear expansion coefficient per 1°C.

(Heat deformation temperature of cured matter)

The liquid crystal sealant compositions prepared in the respective examples were coated on a smooth release film in a thickness of 70 to 120 μm and subjected to heat treatment at 80°C for 30 minutes, and then they were further subjected to hot curing at 150°C for 90 minutes to obtain a cured film. A small piece (15 mm square) of the cured film was cut out and subjected to TMA measurement by elevating the temperature from 40°C up to 180°C at 5°C per minute. The inflection point of distortion was set as a heat deformation temperature (Tg) of the cured matter.

(Water absorption coefficient of cured matter)

The liquid crystal sealant compositions prepared in the respective examples were coated on a smooth release

film in a thickness of 70 to 120 μm and subjected to heat treatment at 80°C for 30 minutes, and then they were further subjected to hot curing at 150°C for 90 minutes to obtain a cured film. The cured film was cut out to a 100 mm square and dipped in boiling water for 30 minutes, 3 hours or 5 hours. Then, an increment in the mass was measured to obtain the water absorption coefficient which is determined by dividing the increment by the original mass to obtain a value and multiplying the resulting value by 100. That is, it is shown by:

water absorption coefficient (%) = (increment in the mass after dipping in boiling water)/mass before test) × 100

(Hardness of cured matter)

The liquid crystal sealant compositions prepared in the respective examples were subjected to heat treatment under vacuum at 80°C for 30 minutes on a smooth release film, and then the compositions were charged into an aluminum-made cell of 1 cm square having a height of 2 mm. Further, it was subjected to hot curing at 150°C for 90 minutes to obtain a cured matter, and a surface hardness of the cured matter was measured at 23°C of room temperature by means of a shore D hardness meter:

◎ : shore D hardness is 80 or more, and the cured matter is excellent in rigidity
○: shore D hardness is 70 or more and less than 80, and the cured matter is rich in rigidity
×: shore D hardness is less than 70, and the cured matter is lacking in rigidity

(Storage elastic modulus of cured matter)

The liquid crystal sealant compositions prepared in the respective examples were coated on a smooth release film in a thickness of 70 to 120 μm and subjected to heat treatment at 80°C for 30 minutes, and then they were further subjected to hot cuiring at 150°C for 90 minutes to obtain a cured film. The cured film was cut out to a 100 mm square, and the above cured matter was heated at a constant rate of 5°C per minute under air atmosphere by means of a dynamic viscoelastometer manufactured by Rheometric Co., Ltd. at a frequency of one Hertz to obtain a viscoelasticity curve, and then the storage elastic modulus in an area of from 100 to 150°C was determined:

○: storage elastic modulus is $1 \times 10^5$ Pa to $1 \times 10^8$ Pa
×: storage elastic modulus is $9.9 \times 10^4$ Pa or less

(Free ion concentration)

Measured was an ionic conductivity of aqueous solutions prepared by stirring and admixing 100 mass parts of the compositions for a liquid crystal display cell sealant prepared in the respective examples with the same mass of ultra purified water at room temperature for 30 minutes:

◎ : conductivity is 2 mS/m or less
○: conductivity is 2.1 to 10 mS/m
×: conductivity is 10.1 to 50 mS/m
××: conductivity is 51 mS/m or more

(Bonding-sealing test)

The cells for liquid crystal display produced by carrying out bonding and curing under the conditions shown in the respective examples were expanded under a magnifying glass of 20 magnifications and observed with eyes to determine the presence of disturbance in the seal lines and inferior spots brought about by seal leak generated.

(Peeling test of cell by wedge)

A wedge was driven under an environment of 60°C into the cells for liquid crystal display produced via the single layer press curing step under the conditions shown in the respective examples, and an adhesive force of the sealant composition for a liquid crystal display cell was shown by a peeling state thereof:

◎ : substrate is broken, and heat resistant adhesive property is excellent
○: cohesive failure of the composition for a liquid crystal display cell sealant is partly observed, and heat resistant

adhesive property is good
×: breakage having interfacial peeling is observed, and heat resistant adhesive force is problematic

(Peeling test of cell by wedge after pressure cooker test)

The cells for liquid crystal display produced via the single layer press curing step under the conditions shown in the respective examples were exposed to pressure cooker tester at 121°C for 2 hours and then taken out, and a wedge was driven thereinto at room temperature, and an adhesive force of the composition for a liquid crystal display cell sealant is shown by a peeling state thereof:

◎ : substrate is broken, and heat resistant adhesive property is excellent
○: cohesive failure of the composition for a liquid crystal display cell sealant is partly observed, and heat resistant adhesive property is good
×: breakage having interfacial peeling is observed, and heat resistant adhesive force is problematic

(Non-bleeding property of the composition for a liquid crystal sealant)

A liquid crystal material, RC4087 (manufactured by Chisso Corporation) in which liquid crystal has a threshold voltage of 1.38 V and a $\Delta\varepsilon$ of 12.4 was charged into the cells for liquid crystal display produced via the single layer press curing step under the conditions shown in the respective examples from a liquid crystal-injection port by a vacuum method, and then the injection port was sealed by Structbond ES-302 (manufactured by Mitsui Chemicals Inc.). A polarizing plate was stuck on the front side, and a polarizing plate equipped with a reflecting plate was disposed on the rear side. Then, a driving circuit and the like were mounted on the above unit to prepare a liquid crystal panel. It was observed whether or not a liquid crystal display function in the vicinity of the sealant in the liquid crystal panel functioned normally from the beginning to evaluate and judge the non-bleeding property:

○: liquid crystal display function can be exhibited to the sealed edge, and non-bleeding property is secured
Δ: normal liquid crystal display is not shown within 1 mm in the vicinity of the sealed edge, and non-bleeding property is a little inferior
×: abnormal liquid crystal display is observed exceeding 1 mm in the vicinity of the sealed edge, and non-bleeding property is markedly inferior

(Sealing function durability test)

The liquid crystal material, RC4087 (manufactured by Chisso Corporation) was charged into the cells for liquid crystal display produced via the single layer press curing step under the conditions shown in the respective examples from a liquid crystal-injection port, and then the injection port was sealed by Structbond ES-302 (manufactured by Mitsui Chemicals Inc..) to prepare a liquid crystal panel. The liquid crystal panel was taken out after left standing under an environment of 65°C/RH 95 % for 250 hours, 500 hours and 1,000 hours respectively. A polarizing plate was stuck on the front side, and a polarizing plate equipped with a reflecting plate was disposed on the rear side. Then, a driving circuit and the like were mounted on the above unit to observe a change in the display function:

◎ : uneven display is not observed
○: uneven display is slightly observed within 150 μm in terms of a distance from the sealed edge in cell circumferential part
Δ: uneven display is observed in a range of 151 to less than 500 μm in terms of a distance from the sealed edge in cell circumferential part
×: uneven display is extended to 500 μm or more in the sealed edge, and a marked reduction in display function is caused

(Curing-initiation temperature)

Each 10 mg of the compositions for a liquid crystal display cell sealant prepared in the respective examples were heated from 30°C up to 220°C at a constant rate of 5°C per minute by differential scanning calorimetry (DSC) to obtain a thermogram, and the exothermic initiation peak temperature was obtained from the curve as a curing-initiation temperature.

(Curing exothermic peak temperature)

Each 10 mg of the compositions for a liquid crystal display cell sealant prepared in the respective examples was heated from 30°C up to 220°C at a constant rate of 5°C per minute by differential scanning calorimetry (DSC) to obtain a thermogram, and the maximum exothermic peak inflection point was obtained from the curve as the maximum exothermic peak temperature.

(Influence of cured matter exerted on liquid crystal)

The liquid crystal sealant compositions prepared in the respective examples were coated on a smooth release film in a thickness of 70 to 120 μm and subjected to heat treatment at 80°C for 30 minutes, and then they were further subjected to hot curing at 150°C for 90 minutes to obtain a cured film. The cured film piece of 0.1 mass part was weighed and put in a sealed type glass vessel, and one mass part of the liquid crystal material, RC4087 (manufactured by Chisso Corporation) was further added thereto. The vessel was sealed under nitrogen atmosphere and heated at 125°C for one hour. The content was aspirated by means of an injector having therein a small-sized ceramic-made filter to sample the liquid crystal, and a resistivity of the liquid crystal was measured by means of a resistivity measuring meter and a change rate relative to a resistivity value obtained by the above test for only the liquid crystal were shown (referred to as the original resistivity of liquid crystal):

◎ : change of less than 50 times based on the original resistivity of liquid crystal
○: change falling in a range of 50 times to 250 times based on the original resistivity of liquid crystal is observed, and influence exerted on the liquid crystal by the cured matter of the composition for a liquid crystal display cell sealant is considerably small
×: change of 250 times or more based on the original resistivity of liquid crystal is observed, and influence exerted on the liquid crystal by the cured matter of the composition for a liquid crystal display cell sealant is relatively large

Raw materials used:

1. Epoxy resin (1)

Prepared as monofunctional epoxy resins were 2-ethylhexyl monoglycidyl ether (abbreviation code: 2EHG) so refined that an ionic conductivity of extract water is 1.5 mS/m (15 μS/cm) or less (hereinafter referred to merely as an ionic conductivity of extract water), wherein 2 EHG is subjected to extraction by bringing into contact with the same mass of purified water for one hour and t-butylphenol monoglycidyl ether (abbreviation code: t-BPMG) refined to 1.2 mS/m (12 μS/cm) or less in terms of an ionic conductivity of extracted water.

The following ones were used as polyepoxy resins having di-functionality or higher.

1,6-Hexanediol diglycidyl ether (abbreviation code: 1,6-HGDE) refined to 0.2 mS/m (2 μS/cm) or less in terms of an ionic conductivity of extracted water was used as a difunctional aliphatic epoxy resin; used as difunctional bisphenol A type epoxy resins were a brand name "Epomik R-140P" (average molecular weight: 370), a product manufactured by Mitsui Chemicals Inc., a brand name "Epikote 1007" (average molecular weight: 4000), a product manufactured by Yuka Shell Co., Ltd. and a brand name "Epomik R367" (average molecular weight: 2600), a product manufactured by Mitsui Chemicals Inc..; used as a difunctional bisphenol F type epoxy resin was a brand name "Epiclon 830-S" (average molecular weight: about 350 to 370), a product manufactured by Dainippon Ink & Chemicals Inc.; and used as difunctional hydrogenated bisphenol A type epoxy resin was a brand name "Epotote ST-1000" (average molecular weight: 400 to 440), a product manufactured by Toto Kasei Co., Ltd.

Used as a trifunctional novolak epoxy resin was a brand name "Epotote YDCN" (polystyrene-reduced mass average molecular weight determined by GPC: about 1000), a product manufactured by Toto Kasei Co., Ltd.; used as a triphenolethane type epoxy resin was a product "Epomik VG3101" manufactured by Mitsui Chemicals Inc..; used as a trifunctional aminoepoxy resin was a product "Sumika ELM-100" manufactured by Sumitomo Chemical Co., Ltd.; and used as a tetrafunctional aminoepoxy resin was a brand name "Epotote YH-434" (polystyrene-reduced mass average molecular weight determined by GPC: about 460), a product manufactured by Toto Kasei Co., Ltd.

Further, the resin composition (abbreviated as EPA-005) obtained in the following Synthetic Example 6 was used as the modified epoxy resin.

2. Curing agent (2)

A resin in which a softening point was 114.9°C and a content of free phenol was 0.03 % or less and in which a content of a chlorine atom was 0.01 % or less and an ionic conductivity of extract water was 0.5 mS/m (5 μ S/cm)

was selected from a brand name "Milex VR9315" (a resin in which phenol nuclei were bonded through a methylene bond), a product manufactured by Mitsui Chemicals Inc. as a phenol novolak resin (this resin is referred merely as an FP resin in the following examples).

Novolak PSM-4261 manufactured by Gunei Chemical Industry Co., Ltd. was prepared as another phenol novolak resin, and prepared as an esterified phenol novolak resin was, as shown in the following Synthetic Example 1, a resin (hereinafter referred to as esterified PSM-4261) obtained by benzoyl-esterifying 98 mole % of phenolic hydroxyl groups contained in Novolak PSM-4261 manufactured by Gunei Chemical Industry Co., Ltd.

Further, all the following esterification-modified products were obtained by esterification modification according to Synthetic Example 1. However an esterified trisphenol monomer, which is high melting substance, was produced by Synthetic Example 2.

A resin in which a polystyrene-reduced mass average molecular weight was 7150 determined by GPC and a softening point was 84°C and in which a content of free phenol was 0.01 % or less and a content of a chlorine atom was 0.01 % or less and an ionic conductivity of extract water was 0.3 mS/m (3 µS/cm) was selected from a brand name "Xylok XLC-225L" (a resin in which phenol nuclei were bonded via a p-xylene nucleus and a methylene bond), a product manufactured by Mitsui Chemicals Inc. as a phenol aralkyl resin (referred to merely as an XP resin in the following examples).

Prepared as another phenol aralkyl resin was a resin in which phenol nuclei were bonded via a p-xylene nucleus and a methylene bond and a polystyrene-reduced mass average molecular weight determined by GPC was about 1750 and in which a softening point was 76°C and a content of free phenol was 0.01 % or less and in which a content of a chlorine atom was 0.01 % or less and an ionic conductivity of extract water was 0.3 mS/m (3 µ S/cm) (hereinafter referred to merely as an XLP resin), and prepared as an esterified phenol aralkyl resin thereof was a resin in which 99 mole % of active phenolic hydroxyl groups contained in the above XLP resin was benzoyl-esterified and an ionic conductivity of extract water was 1.1 mS/m (11 µS/cm) (hereinafter referred to merely as an esterified aralkyl resin).

Prepared as an alicyclic compound-modified phenol novolak resin was a so-called dicyclopentadiene-modified phenol novolak resin (hereinafter referred to merely as a DCN resin) which was derived from refined phenol and α, α-dimethyl ether-2,5-dicyclopentadiene and in which a polystyrene-reduced mass average molecular weight was 969 and an ionic conductivity of extract water was 0.7 mS/m (7 µ S/cm), or a so-called cyclohexane-modified phenol novolak resin (hereinafter referred to merely as a CHN resin) which was derived from phenol and α, α-dimethyl ether-p-cyclohexane and in which a polystyrene-reduced mass average molecular weight was 1084 and an ionic conductivity of extract water was 1 mS/m (10 µS/cm); and prepared as an esterified alicyclic compound-modified phenol novolak resin thereof was a resin in which 91 mole % of active phenolic hydroxyl groups contained in the above dicyclopentadiene-modified phenol novolak resin was benzoyl-esterified and an ionic conductivity of extract water was 1 mS/m (10 µS/cm) (hereinafter referred to merely as an esterified DCN resin), and a resin in which 100 mole % of active phenolic hydroxyl groups contained in the above cyclohexane-modified phenol novolak resin was benzoyl-esterified and an ionic conductivity of extract water was 0.6 mS/m (6 µS/cm) (hereinafter referred to merely as an esterified CHN resin).

Prepared as a polycyclic aromatic compound-modified novolak resin was FPI-5136 (softening point: 75°C, number average molecular weight: 640, free phenol content: 0.1 % or less, ionic conductivity of extract water: 0.8 mS/m (8 µ S/cm), which is a product of Kashima Oil Co., Ltd.; prepared as an esterified polycyclic aromatic compound-modified novolak resin thereof was a resin in which 95 mole % of active phenolic hydroxyl groups contained in FPI-5136 was benzoyl-esterified and an ionic conductivity of extract water was 0.6 mS/m (6 µS/cm) (hereinafter referred to merely as an esterified FPI resin); prepared as a naphthol novolak resin was a resin which was derived from β-naphthol and formaldehyde and in which a polystyrene-reduced mass average molecular weight was 878 and an ionic conductivity of extract water was 0.3 mS/m (3 µS/cm) (hereinafter referred to merely as an NN resin); and prepared as an esterified naphthol novolak resin thereof was an esterified NN resin in which 50 mole % of phenolic hydroxyl groups contained in the NN resin was benzoyl-esterified.

Prepared as a naphthol aralkyl resin was a resin which was derived from β-naphthol and α, α-dimethyl ether-p-xylylene and in which a polystyrene-reduced mass average molecular weight was 555 and an ionic conductivity of extract water was 0.7 mS/m (7 µS/cm) (hereinafter referred to merely as an NA resin), and prepared as an esterified naphthol aralkyl resin thereof was an esterified NA resin in which 50 mole % of phenolic hydroxyl groups contained in the NA resin was benzoyl-esterified.

Prepared as an alicyclic compound-modified naphthol novolak resin was a resin which was derived from β-naphthol and α, α-dimethyl ether-2,5-dicyclopentadiene and in which a polystyrene-reduced mass average molecular weight was 1240 and an ionic conductivity of extract water was 0.7 mS/m (7 µS/cm) (hereinafter referred to merely as a DC-NN resin), and prepared as an esterified resin thereof was an esterified DC-NN resin in which 50 mole % of phenolic hydroxyl groups contained in the DC-NN resin was benzoyl-esterified.

Prepared as a polyphenol monomer was 4,4'-[(2-hydroxyphenyl)methylene]bis[2,3,6-trimethylphenol] (hereinafter referred to merely as a tris P compound) which was refined so that an ionic conductivity of extract water was

0.3 mS/m (3 μS/cm), and used was one crushed to a maximum particle diameter of 4 μm or less (4 μm or less in terms of a maximum particle diameter at 99.9 % on a weight integration curve determined by a laser irradiation type particle size distribution-measuring method using laser having a wavelength of 632.8 nm) by means of a pulverizer.

Prepared as an esterified polyphenol monomer was one in which 99.3 mole % of active phenolic hydroxyl groups contained in the tris P compound described above was benzoyl-esterified and an ionic conductivity of extract water was 0.6 mS/m (6 μS/cm), and it shall hereinafter be referred to merely as an esterified tris P compound.

A resin in which a content of free phenol was 0.01 % or less and a softening point was 80°C and in which a polystyrene-reduced mass average molecular weight determined by GPC was about 650 and an ionic conductivity of extract water was 2 mS/m (20 μS/cm) was selected from a brand name "PPF resin; FPI-5127", a product of Kashima Oil Co., Ltd. (a resin in which phenol nuclei and a tri-to tetracyclic aromatic hydrocarbon nucleus originating in a light fraction coming from a catalytic cracking plant are bonded at random via a methylene bond) as another polycyclic aromatic compound-modified phenol novolak resin.

A compound in which an ionic conductivity of extract water was 2 mS/m (20 μS/cm) or less was prepared from a brand name "Marukalyncur M(S-2)", a product of Maruzen Petrochemical Co., Ltd. as polyvinylphenol; a copolymer in which an ionic conductivity of extract water was 2 mS/m (20 μS/cm) or less was prepared from a brand name "Marukalyncur CBA" (a random copolymer of p-vinylphenol and butyl acrylate, mass average molecular weight determined by GPC: 10,000), a product of Maruzen Petrochemical Co., Ltd. as a polyvinylphenol copolymer; and prepared as polyisopropenylphenol was a compound which was homopolymer of p-isopropenylphenol and in which a mass average molecular weight determined by GPC was 3350 and an ionic conductivity of extract water was 2 mS/m (20 μS/cm) or less (hereinafter referred to merely as an OP resin). Further, a copolymer in which an ionic conductivity of extract water was 2 mS/m (20 μS/cm) or less was selected from a brand name "Milex SP" (a random copolymer of p-isopropenylphenol and styrene, styrene-reduced mass average molecular weight determined by GPC: about 4,000), a product of Mitsui Chemicals, Inc. as a polyisopropenylphenol copolymer.

Adipic acid dihydrazide (abbreviated code: ADH) was selected and prepared as a dihydrazide compound.

"Cat Z-15", a product of Mitsui Chemicals Inc. or "Ajicure PN23", a product of Ajinomoto Co., Inc. was selected and used as an imidazole-epoxy resin adduct type potential curing agent for eposy resin.

Synthetic Example 1

Production of esterified novolak resin

A glass-made vessel equipped with a thermometer, a stirrer, a dropping funnel and a reflux condenser was charged with 107 g of a phenol novolak resin (brand name: PSM-4216, hydroxyl equivalent: 107 g/eq, manufactured by Gunei Chemical Industry Co., Ltd.), and the liquid temperature was elevated up to 125°C. Dropwise added was 140.6 g of benzoyl chloride in 2 hours while maintaining the liquid temperature at the above temperature and stirring. Thereafter, the reaction was carried out for 2 hours while maintaining the temperature at 125°C, and then the temperature was further elevated up to 140°C. After ripening the solution at 140 to 150°C for 2 hours, generated hydrochloric acid gas was distilled off under reduced pressure under a condition of maximum 150°C/10 mm Hg.

The resin obtained above was dissolved in 1000 g of toluene, and the solution was washed with warm water at 60 to 70°C until the waste water became neutral, and toluene was distilled off on a condition of maximum 150° C/5 mm Hg to obtain 210 g of a so-called esterified novolak resin (esterified PSM-4216) in which 98 mole % of hydroxyl groups was converted to benzoyl.

Synthetic Example 2

Production of esterified trisphenol compound

A glass-made vessel equipped with a thermometer, a stirrer, a dropping funnel and a reflux condenser was charged with 143 parts of 4,4'-[(2-hydroxyphenyl)-methylene]bis[2,3,6-trimethylphenol] and 100 parts of acetophenone, and the liquid temperature was elevated up to 125°C. Dropwise added was 126.5 g of benzoyl chloride in 2 hours while maintaining the liquid temperature at the above temperature and stirring. Thereafter, the reaction was carried out for 2 hours while maintaining the temperature at 125°C, and then the temperature was further elevated up to 140°C. After ripening the solution at 140 to 150°C for 2 hours, generated hydrochloric acid gas was distilled off under reduced pressure under a condition of maximum 150°C/10 mm Hg.

The compound obtained above was dropwise added to 1000 g of toluene to be deposited, and the resulting crystal component was dissolved again in a 5 % water-acetone mixed solution, and deposition with a toluene solvent was repeated five times to carry out recrystallization until the water-containing acetone waste water became neutral. Then, the above crystal was dried on a condition of maximum 150°C/5 mm Hg to obtain 110 g of a so-called esterified

trisphenol monomer (esterified trisphenol compound) in which 99.3 mole % of hydroxyl groups was converted to benzoyl.

3. Curing accelerator (3)

Prepared were 3-p-chlorophenyl-1,1-dimethylurea (hereinafter abbreviated as an accelerator U) having a purity of 99.7 %, Ucat-3502T (hereinafter abbreviated as 3502T) manufactured by San-Apro Ltd. as 2,4-[bis(1,1-dimethylurea)]toluene, Ucat-3503N (hereinafter abbreviated as 3503N) manufactured by San-Apro Ltd. as 3,5-di(1,1-dimethylurea)-5-methyl-2-cyclohexene-1-one, 2E4MZ, a product of Shikoku Chemicals Corp. as 2-ethyl-4-methylimidazole and triphenylphosphine (reagent), and they were used respectively after pulverized to a maximum particle diameter of 4 μm or less (4 μ m or less in terms of a maximum particle diameter at 99.9 % on a weight integration curve determined by a laser irradiation type particle size distribution-measuring method using laser having a wavelength of 632.8 nm) by means of a pulverizer.

Further, used was a curing accelerator (hereinafter referred to merely as PZO) represented by the following formula (13) which was produced by a production process described in Journal of General Chemistry of The USSR, 55, p. 1453 (1985):

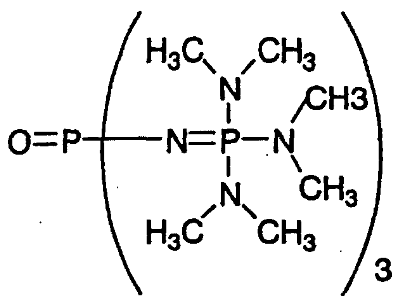

(13)

4. Inorganic filler (5)

Used as spherical silica was a γ-glycidoxypropyltrimethoxysilane 6 mass %-dry treated filler (hereinafter referred to merely as SO-E1-6) of a brand name "Adma Fine SO-E1" manufactured by Tatsumori Co., Ltd.; used as spherical alumina was a γ-glycidoxypropyltrimethoxysilane 5 mass %-dry treated filler (hereinafter referred to merely as SO-A805) of a brand name "Adma Fine SO-A800" manufactured by Tatsumori Co., Ltd.; used as amorphous silica were a brand name "Aerosil #200" (primary average particle size determined by an electron microscope observation method: 0.08 μm), a product manufactured by Nippon Aerosil Co. Ltd., and a brand name "MU-120" (primary average particle size determined by an electron microscope observation method: 0.07 μm), a product manufactured by Shin-etsu Chemical Co., Ltd.,; used as amorphous alumina was a brand name "UA-5105" (hereinafter referred to merely as amorphous alumina 1), a product manufactured by Showa Denko K.K.; and used as titanium oxide was a brand name "CR-EL" (1 μm in terms of an average particle size in which a particle diameter at 50 % on a weight integration curve determined by a laser irradiation type particle size distribution-measuring method using laser having a wavelength of 632.8 nm was set as a primary average particle size) a product manufactured by Ishihara Sangyo Kaisha Ltd.

Further, the following ones were used as graft-modified alumina.

Prepared as graft-modified alumina was amorphous γ-alumina in which an average particle diameter at 50 % on a weight integration curve determined by a laser irradiation type particle size distribution-measuring method using laser having a wavelength of 632.8 nm was 0.1 μm and a particle diameter at 99.5 % was 2 μm, and used was a compound obtained by subjecting 1 kg of the amorphous γ-alumina to spraying treatment with 30.3 g of γ-glycidoxypropyltrimethoxysilane (a brand name: KBM403, a product manufactured by Shin-etsu Chemical Co., Ltd.) under an atmosphere of 100°C and ripening it at 80°C for 48 hours (hereinafter referred to merely as graft-modified alumina).

A sample dried after washing five times 10 parts of the graft-modified alumina with 100 parts of a toluene solvent was burned in a crucible to find that a heating loss of 1.7 % for organic components was observed, and therefore it was confirmed that about 2.4 % of γ-glycidoxypropyltrimethoxysilane was grafted.

5. Coupling agent (6)

Selected and used were γ-glycidoxypropyltrimethoxysilane (hereinafter referred to merely as epoxysilane), N-phenyl-γ-aminopropyltrimethoxysilane (hereinafter referred to merely as aminosilane) and γ-isocyanatopropyltriethoxysilane (hereinafter referred to merely as isocyanatosilane).

6. Rubber-like polymer fine particle (4)

Compositions prepared through Synthetic Example 3 and Synthetic Example 4 were used for the rubber-like polymer fine particle (4).

Synthetic Example 3

Synthesis of rubber-like polymer fine particle (micro cross-linking type acryl rubber fine particle; abbreviated as S1)-containing epoxy resin composition (a):

A four neck flask of 2000 ml equipped with a stirrer, a gas-inlet tube, a thermometer and a cooling tube was charged with 600 g of a bisphenol F type epoxy resin (Epiclon 830S, manufactured by Dainippon Ink & Chemicals Inc.) as a difunctional epoxy resin, 12 g of acrylic acid, 1 g of dimethylethanolamine and 50 g of toluene, and they were reacted at 110°C for 5 hours while introducing air to introduce a double bond to the epoxy resin . Next, added thereto were 350 g of butyl acrylate, 20 g of glycidyl methacrylate, 1 g of divinylbenzene, 1 g of azobisdimethylvaleronitrile and 2 g of azobisisobutyronitrile, and they were reacted at 70°C for 3 hours and further at 90°C for one hour while introducing nitrogen into the reaction system. Then, toluene was removed at 110°C under reduced pressure to obtain an epoxy resin composition (a) in which homogeneously dispersed was a micro cross-linking type acryl rubber fine particle (S1) having a minimum particle diameter of 0.02 μm and a maximum particle diameter of 1 μm determined by a method in which the above composition was quickly cured at a low temperature in the presence of a photocuring catalyst and a breaking face morphology of the cured matter thereof was observed under an electron microscope to determine a particle diameter of the dispersed rubber particle.

It was confirmed that a content of the micro cross-linking type acryl rubber fine particle (S1) which was calculated from the amount of the charged monomer and the residual monomers was 37.9 weight %.

The micro cross-linking type acryl rubber fine particle (S1) had a softening point of -42°C which was determined by subjecting the epoxy resin composition (a) to TBA.

Synthetic example 4

Synthesis of silicone base rubber-like polymer fine particle (cross-linking type silicone rubber fine particle; S2)-containing epoxy resin composition (b):

A four neck flask of 2000 ml equipped with a stirrer, a gas-inlet tube, a thermometer and a cooling tube was charged with 600 g of a bisphenol F type epoxy resin (Epiclon 830S, manufactured by Dainippon Ink & Chemicals Inc.) as a difunctional epoxy resin, 12 g of acrylic acid, 1 g of dimethylethanolamine and 50 g of toluene, and they were reacted at 110°C for 5 hours while introducing air to introduce a double bond to the epoxy resin. Next, added thereto were 5 g of hydroxyacrylate, 10 g of butyl acrylate and 1 g of azobisisobutyronitrile, and they were reacted at 70°C for 3 hours and further at 90°C for one hour. Then, toluene was removed at 110°C under reduced pressure. Next, 70 g of a silicone intermediate having a methoxy group in a molecule and 0.3 g of dibutyltin dilaurate were added thereto and reacted at 150°C for one hour. In order to remove produced methanol, the reaction was further continued for one hour. Added was 300 g of a mixture of this grafted resin and a room temperature-curing type silicone rubber of two-liquid type in a ratio of 1/1, and reaction was carried out for 2 hours to obtain an epoxy resin composition (b) in which a micro cross-linking type silicone rubber fine particle (S2) was homogeneously dispersed.

The above composition (b) was the epoxy resin composition (b) in which homogeneously dispersed was a micro cross-linking type silicone rubber fine particle (S2) having an average particle diameter of 1.5 μm determined by a method in which the above composition (b) was quickly cured at a low temperature in the presence of a photocuring catalyst and a breaking face morphology of the cured matter thereof was observed under an electron microscope to determine a particle diameter of the dispersed rubber particle.

A content of the micro cross-linking type silicone rubber fine particle (S2) which was calculated from the amount of the charged monomer was 30 %. Further, the micro cross-linking type silicone rubber fine particle (S2) had a softening point of -65°C which was determined by subjecting the epoxy resin composition (b) to TBA.

7. High softening point-polymer fine particle (8)

A composition prepared in the following Synthetic Example 5 was used for the high softening point-polymer fine particle (8).

Synthetic Example 5

Synthesis of high softening point-acryl polymer fine particle (P1):

A four neck flask of 2000 ml equipped with a stirrer, a gas-inlet tube, a thermometer and a reflux condenser was charged with 420.5 g of ion-exchanged water, 10 g of itaconic acid and 2.6 g of「Pelex SS-L」as a surfactant, a product manufactured by Kao Corporation, which is sodium alkyldiphenylether-disulfonate, and the temperature was elevated up to 70°C while introducing nitrogen. At a stage of reaching the above temperature, added thereto was 11.2 g of an initiator aqueous solution prepared by dissolving 1.2 g of potassium persulfate in 10 g of ion-exchanged water, and further added in lump sum was a mixed solution comprising 5 g of n-butyl acrylate, 5 g of methyl methacrylate and 0.5 g of hydroxyethyl methacrylate to carry out seed polymerization at 70°C for 20 minutes. Thereafter, continuously dropwise added in about 4 hours under an environment of the above temperature was an emulsion prepared by mechanically emulsifying a mixed monomer solution of 339 g of methyl methacrylate, 20 g of glycidyl methacrylate, 40 g of n-butyl acrylate and 2 g of 1,6-hexanediol dimethacrylate in an aqueous solution containing 1.8 g of "Pelex SS-L" described above in 160 g of ion-exchanged water. After finishing dropwise adding, the reaction was further continued at the same temperature for one hour to complete the polymerization of the residual monomers to thereby obtain an emulsion solution (Em-1) having a solid content of 39.9 weight %. Subsequently, the above solution (Em-1) was treated with a ultrafiltration apparatus using purified water in 48 hours to remove water-soluble components for refining. The emulsion solution (Em-1) of 1,000 g obtained after the ultrafiltration treatment was treated with a spray drier to obtain 388 g of a high softening point-acryl polymer fine particle (P1) powder having a moisture content of 0.1 % or less.

Em-1 was observed under an electron microscope to determine an average primary particle size of the dispersed particle to find that it was 170 nm (0.17 μm).

The high softening point-acryl polymer fine particle (P1) had a micro cross-linking degree of 0.5 mass % in terms of a content ratio of the cross-linkable monomer based on the whole monomers. The high softening point-acryl polymer fine particle (P1) had a softening point of 80°C which was determined by TBA measurement using a hot melt film thereof.

Synthetic Example 6

A reaction flask having a volume of 500 ml was charged in advance with 42 parts of Epotote YDCN, 133 parts of Epiclon 830S and 250 parts of toluene as a solvent, and added thereto while stirring was 100 parts of polydimethylsiloxane (a product of Shin-etsu Silicon Co., Ltd.; X-22-161B) having an amine value of 1500 and primary amino groups at both ends to react them at 120°C for 2 hours. Then, the solvent was removed under reduced pressure at the above temperature to obtain 275 parts of a modified epoxy resin. This modified epoxy resin shall be called EPA-005.

8. Composite particle in which the rubber-like polymer fine particle (4) is used for a core phase and the high softening point-polymer fine particle (8) is used for a shell phase:

Obtained was "Zeon F351" (average particle diameter: 0.3 μm), a product of Zeon Kasei Co., Ltd. which was known as a composite particle in which the rubber-like polymer fine particle (4) was used for a core phase and the high softening point-polymer fine particle (8) was used for a shell phase in a core-shell mass ratio of 1 : 1. Used was a composite obtained by subjecting a 50 % aqueous solution thereof to a ultrafilter with purified water in 48 hours for deionization and then turning it into powder by means of a spraying drier. Hereinafter, it shall be called merely "high softening point-polymer fine particle P2".

Example 1

Mixed together were 9.1 parts of an epoxy resin composition prepared by dissolving 4.1 parts of a cresol novolak type epoxy resin "Epotote YDCN", which was a solid epoxy resin in 5 parts of methylcarbitol and 26.8 parts of an epoxy resin composition (a) in which homogeneously dispersed were the micro cross-linking type acryl rubber fine particle (S1) having an average particle diameter of 0.05 μm, 38.3 parts of a curing agent solution prepared by dissolving in advance 13.3 parts of esterified PSM4261 (benzoyl-esterified novolak resin) and 11.3 parts of the XLP resin (Milex XL-2L which is a phenol aralkyl resin) as a curing agent in 13.7 parts of methylcarbitol, 1.5 parts of PZO as a curing accelerator, 2.1 parts of amorphous silica "MU-120", 20.6 parts of spherical silica "SO-E1-6" and 1.6 parts of KBM4031 as a coupling agent, and they were pre-kneaded by means of a Dalton mixer. Then, they were kneaded by means of a three roll mill until the solid raw materials were pulverized to 5 μm or less, and the kneaded matter was subjected to vacuum degassing treatment to obtain a composition for a liquid crystal display cell sealant (E1).

The composition for a liquid crystal display cell sealant (E1) had an epoxy resin content of 20.7 %, a rubber-like polymer fine particle content of 10.2 %, an inorganic filler content of 22.7 %, a solvent content of 18.7 %, a coupling

agent content of 1.6 %, a curing agent content of 24.6 % and a curing accelerator content of 1.5 %.

The physical properties as a sealant of the composition for a liquid crystal display cell sealant (E1) are shown in Table 2.

Blended with 100 parts of the composition for a liquid crystal display cell sealant (E1) was 5 parts of a gap controller of a glass short fiber having a size of 5 μm, and they were sufficiently mixed to obtain a composition. The resulting composition was screen-printed on a glass substrate for a liquid crystal cell provided with transparent electrodes and an alignment film (hereinafter referred to merely as an ITO substrate) in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 90°C for 15 minutes and then put another ITO substrate which was to be paired, and after adjusting the position, they were temporarily bonded by means of a normal single layer hot press at a press pressure of 0.03 MPa/cm$^2$ and 180°C for 4 minutes. Then, it was put in succession in an oven heated at 150°C for 90 minutes for full curing and bonding. This bonding test was repeatedly carried out ten times. As a result, found was even no one sample having inferior spots in sealing caused by bubbles through the seal (seal leak) and disturbed seal lines, and the desired substrate for a liquid crystal display cell was able to be produced in all lots.

Next, the respective cells were cut off independently and then subjected to a peeling test of cell by wedge and a sealing function durability test. The results thereof are shown in Table 2.

Example 2

A composition for a liquid crystal display cell sealant (E2) was obtained in the same manner as in Example 1 according to the recipe shown in Table 1.

The composition for a liquid crystal display cell sealant (E2) had an epoxy resin content of 26.2 %, a rubber-like polymer fine particle content of 6.5 %, an inorganic filler content of 16.5 %, a solvent content of 19.7 %, a coupling agent content of 1.2 %, a curing agent content of 28.4 % and a curing accelerator content of 1.5 %.

The physical properties as a sealant of the composition for a liquid crystal display cell sealant (E2) are shown in Table 2.

Blended with 100 parts of the composition for a liquid crystal display cell sealant (E2) was 5 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally tow by two on a substrate to obtain the ITO substrate which was coated the sealant in a width of about 0.5 mm and a thickness of about 20 to 22 μm. Then, it was treated in a hot air drier of 80°C for 30 minutes and then put another ITO substrate which was to be paired, and after adjusting the position, they were temporarily bonded by means of a normal single layer hot press at a press pressure of 0.03 MPa/cm$^2$ and 180°C for 4 minutes. Then, it was put in succession in an oven heated at 150°C for 90 minutes for full curing and bonding. This bonding test was repeatedly carried out ten times. As a result, found was even no one sample having inferior spots in sealing caused by bubbles through the seal (seal leak) and disturbed seal lines, and the desired substrate for a liquid crystal display cell was able to be produced in all lots.

Next, the respective cells were cut off independently and then subjected to a peeling test of cell by wedge and a sealing function durability test. The results thereof are shown in Table 2.

Example 3

A composition for a liquid crystal display cell sealant (E3) was obtained in the same manner as in Example 1 according to the recipe shown in Table 1.

The composition for a liquid crystal display cell sealant (E3) had an epoxy resin content of 20.18 %, a rubber-like polymer fine particle content of 6.82 %, an inorganic filler content of 22 %, a solvent content of 15 %, a coupling agent content of 1 %, a curing agent content of 33.5 % and a curing accelerator content of 1.5 %.

The physical properties as a sealant of the composition for a liquid crystal display cell sealant (E3) are shown in Table 2.

Added to 100 parts of the composition for a liquid crystal display cell sealant (E3) was 2 parts of a gap controller of a glass short fiber of 6 μm, and they were sufficiently mixed to obtain a composition. The resulting composition was screen-printed on the ITO substrate in a pattern comprising 4 cells (cell size: 1 inch) which were disposed vertically and horizontally two by tow on a substrate to obtain the ITO substrate which was coated the sealant in a width of about 0.5 mm and a thickness of about 20 to 22 μm. Then, it was subjected to heat treatment in a hot air drier of 95°C for 15 minutes and then put another ITO substrate which was to be paired, and after adjusting the position, they were temporarily bonded by a normal hot press at a press pressure of 0.05 MPa/cm$^2$ and 170°C for 5 minutes. Then, it was put in an oven heated at 150°C for 80 minutes for full curing and bonding. This bonding test was repeatedly carried

out ten times. As a result, found was even no one sample having inferior spots in sealing caused by bubbles through the seal (seal leak) and disturbed seal lines, and the desired substrate for a liquid crystal display cell was able to be produced in all lots.

Next, the respective cells were cut off independently and then subjected to a peeling test of cell by wedge and a sealing function durability test. The results thereof are shown in Table 2.

Example 4

A composition for a liquid crystal display cell sealant (E4) was obtained in the same manner as in Example 1 according to the recipe shown in Table 1.

The composition for a liquid crystal display cell sealant (E4) had an epoxy resin content of 21.3 %, a rubber-like polymer fine particle content of 10.4 %, an inorganic filler content of 23.3 %, a solvent content of 17.4 %, a coupling agent content of 1.7 %, a curing agent content of 24.3 % and a curing accelerator content of 1.6 %.

The physical properties as a sealant of the composition (E4) for a liquid crystal display cell sealant (E4) are shown in Table 2.

Blended with 100 parts of the composition for a liquid crystal display cell sealant (E4) was 2 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 22 to 24 μm. Then, it was treated in a hot air drier of 90°C for 15 minutes and then put another ITO substrate which was to be paired, and after adjusting the position, they were temporarily bonded by means of a normal single layer hot press at a press pressure of 0.03 $MPa/cm^2$ and 180°C for 4 minutes. Then, it was put in succession in an oven heated at 150°C for 90 minutes for full curing and bonding. This bonding test was repeatedly carried out ten times. As a result, found was even no one sample having inferior spots in sealing caused by bubbles through the seal (seal leak) and disturbed seal lines, and the desired substrate for a liquid crystal display cell was able to be produced in all lots.

Next, the respective cells were cut off independently and then subjected to a peeling test of cell by wedge and a sealing function durability test. The results thereof are shown in Table 2.

Table 1

| | | Example | | | |
|---|---|---|---|---|---|
| | Composition | 1 | 2 | 3 | 4 |
| Sealant composition | Composition for liquid crystal display cell sealant | E1 | E2 | E3 | E4 |
| | Epoxy resin | | | | |
| | t-BPMG | | | 3 | |
| | Epiclon EP830S | | | 3 | |
| | Epotote YDCN | 4.1 | 15.5 | 3 | 4.2 |
| | Rubber-dispersed epoxy resin | | | | |
| | (a) | 26.8 | 17.2 | 18 | 27.5 |
| | Curing agent | | | | |
| | Esterified PSM4261 | 13.3 | 28.4 | | 24.3 |
| | XLP (Milex XL-2L) | 11.3 | | | |

Table 1 (continued)

| | | Example | | | |
|---|---|---|---|---|---|
| | Composition | 1 | 2 | 3 | 4 |
| | Esterified XLP | | | 33.5 | |
| | Curing accelerator | | | | |
| | PZO | 1.5 | 1.5 | 1.5 | 1.6 |
| | Silane coupling agent | | | | |
| | KBM403 | 1.6 | 1.2 | 1 | 1.7 |
| | Filler | | | | |
| | SO-E1-6 | 20.6 | 15 | | 21.2 |
| | MU120 | 2.1 | 1.5 | 2 | 2.1 |
| | CR-125-30 | | | 20 | |
| | Solvent | | | | |
| | Methylcarbitol | | 19.7 | | |
| | PGDA | 18.7 | | 15 | 17.4 |
| Total | | 100.0 | 100.0 | 100.0 | 100.0 |

Table 2

| | Example | | | |
|---|---|---|---|---|
| | 1 | 2 | 3 | 4 |
| Single layer hot press aptitude | Suited | Suited | Suited | Suited |
| Storage stability | ○ | ○ | ○ | ○ |
| Coating workability | ○ | ○ | ○ | ○ |
| B stage aptitude | ○ | ○ | ○ | ○ |
| Free ion | ◎ | ◎ | ◎ | ◎ |
| Cured matter hardness | ○ | ○ | ○ | ○ |
| Storage elastic modulus in hot state | ○ | ○ | ○ | ○ |
| Moisture permeability 60°C/80°C | ◎ /◎ | ◎ /◎ | ◎ /◎ | ◎ /○ |
| Water absorption coefficient 30 min<br>Water absorption coefficient 3 hrs<br>Water absorption coefficient 5 hrs | 0.38<br>0.35<br>0.34 | 0.41<br>0.4<br>0.39 | 0.38<br>0.35<br>0.35 | 0.58<br>0.56<br>0.55 |
| Tg | 110 | 118 | 102 | 115 |
| Curing initiation temperature<br>Exothermic initiation peak temperature | 59<br>149 | 57<br>151 | 57<br>147 | 57<br>151 |
| Linear expansion coefficient | 48 PPM | 53 PPM | 41 PPM | 52 PPM |
| Bonding-sealing test<br>Presence of disturbed seal line<br>Presence of through-bubbles/ inferior sealing | <br>None<br>None | <br>None<br>None | <br>None<br>None | <br>None<br>None |
| Peeling test of cell by wedge | ○ | ◎ | ◎ | ◎ |

Table 2 (continued)

| | Example | | | |
|---|---|---|---|---|
| | 1 | 2 | 3 | 4 |
| Interaction with liquid crystal | ◎ | ◎ | ○ | ◎ |
| Non-bleeding property test | ◎ | ◎ | ◎ | ◎ |
| Sealing durability<br>250 hrs<br>500 hrs<br>1000 hrs | <br>◎<br>◎<br>◎ | <br>◎<br>◎<br>◎ | <br>◎<br>◎<br>◎ | <br>◎<br>◎<br>◎ |

Example 5

Mixed together were 31 parts of an epoxy resin composition prepared by dissolving 20 parts of a cresol novolak type epoxy resin "Epotote YDCN", which was a solid epoxy resin and 2 parts of a bisphenol A type epoxy resin "Epomik R367" in 9 parts of methylcarbitol and 15.5 parts of an epoxy resin composition (a) in which homogeneously dispersed were a micro cross-linking type acryl rubber fine particle (S1) having an average particle diameter of 0.05 µm, 35 parts of a curing agent solution prepared by dissolving in advance 25 parts of the XP resin (phenol aralkyl resin) as a curing agent in 10 parts of methylcarbitol, 1 part of the accelerator U as a curing accelerator, 2 parts of amorphous silica "MU-120", 14.6 parts of amorphous alumina "UA-5105" and 0.9 part of aminosilame as a silane coupling agent, and they were further pre-kneaded by means of a Dalton mixer. Then, they were kneaded by means of a three roll mill until the solid raw materials were pulverized to 5 µm or less, and the kneaded matter was subjected to vacuum degassing treatment to obtain a composition for a liquid crystal display cell sealant (E5) described in Table 3.
The composition for a liquid crystal display cell sealant (E5) comprised an epoxy resin having 3.5 epoxy groups on a mass average in a molecule and had an epoxy resin content of 31.73 %, a rubber-like polymer fine particle content of 5.87 %, an inorganic filler content of 16.6 %, a solvent content of 19 %, a silane coupling agent content of 0.9 %, a curing agent content of 25 % and a curing accelerator content of 1 %.
The physical properties as a sealant of the composition for a liquid crystal display cell sealant (E5) are shown in Table 4.
Blended with 100 parts of the composition for a liquid crystal display cell sealant (E5) was 5 parts of a gap controller of a glass short fiber having a size of 5 µm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 µm. Then, it was treated in a hot air drier of 80°C for 30 minutes and then put another ITO substrate which was to be paired, and after adjusting the position, they were temporarily bonded by means of a normal single layer hot press at a press pressure of 0.03 $MPa/cm^2$ and 180°C for 4 minutes. Then, it was put in succession in an oven heated at 150°C for 90 minutes for full curing and bonding. This bonding test was repeatedly carried out ten times. As a result, found was even no one sample having inferior spots in sealing caused by bubbles through the seal (seal leak) and disturbed seal lines, and the desired substrate for a liquid crystal display cell was able to be produced in all lots.
Next, the respective cells were cut off independently and then subjected to a peeling test of cell by wedge and a peeling test of cell by wedge after a pressure cooker test at 121°C for 2 hours. Further, a liquid crystal display function of the resulting cell was observed, and the results thereof are shown in Table 4 together. The sealing function durability test of the resulting cell was carried out, and the results thereof are shown as well in Table 4.

Example 6

A composition for a liquid crystal display cell sealant (E6) of the present invention was obtained in the same manner as in Example 5 according to the recipe shown in Table 3.
The composition for a liquid crystal display cell sealant (E6) comprised an epoxy resin having 3 epoxy groups on a mass average in a molecule and had an epoxy resin content of 29.2 %, a rubber-like polymer fine particle content of 3.8 %, a high softening point-polymer fine particle content of 9.5 %, an inorganic filler content of 16 %, a solvent content of 22 %, a silane coupling agent content of 1.5 %, a curing agent content of 16 % and a curing accelerator content of 2 %. The initial viscosity at 25°C determined by an E type viscometer was 65 Pa·s.
The physical properties as a sealant of the composition for a liquid crystal display cell sealant (E6) are shown in Table 4.

Blended with 100 parts of the composition for a liquid crystal display cell sealant (E6) was 5 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 90°C for 15 minutes and then put another ITO substrate which was to be paired, and after adjusting the position, they were temporarily bonded by means of a normal single layer hot press at a press pressure of 0.03 $MPa/cm^2$ and 180°C for 4 minutes. Then, it was put in succession in an oven heated at 150°C for 90 minutes for full curing and bonding. This bonding test was repeatedly carried out ten times. As a result, found was even no one sample having inferior spots in sealing caused by bubbles through the seal (seal leak) and disturbed seal lines, and the desired substrate for a liquid crystal display cell was able to be produced in all lots.

Next, the respective cells were cut off independently and then subjected to a peeling test of cell by wedge and a peeling test of cell by wedge after a pressure cooker test at 121°C for 2 hours. Further, a liquid crystal display function of the resulting cell was observed, and the results thereof are shown in Table 4 together. The sealing function durability test of the resulting cell was carried out, and the results thereof are shown as well in Table 4.

Example 7

A composition for a liquid crystal display cell sealant (E7) described in Table 3 was obtained in the same manner as in Example 6, except that the same parts of the high softening point-polymer fine particle (P2) was substituted for the high softening point-polymer fine particle (P1) used in Example 6.

The composition for a liquid crystal display cell sealant (E7) comprised an epoxy resin having 3 epoxy groups on a weight average in a molecule and had an epoxy resin content of 29.2 %, a rubber-like polymer fine particle content of 8.55 %, a high softening point-polymer fine particle content of 4.75 %, an inorganic filler content of 16 %, a solvent content of 22 %, a silane coupling agent content of 1.5 %, a curing agent content of 16 % and a curing accelerator content of 2 %. The initial viscosity at 25°C determined by an E type viscometer was 68 Pa·s.

The physical properties as a sealant of the composition for a liquid crystal display cell sealant (E7) are shown in Table 4.

Blended with 100 parts of the composition for a liquid crystal display cell sealant (E7) was 3 parts of a gap controller of a spherical silica having a particle diameter of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 80°C for 15 minutes and then put another ITO substrate which was to be paired, and after adjusting the position, they were temporarily bonded by a vacuum single layer hot press at -980 hectopascal and 150°C for 10 minutes. Further, it was left standing in an oven heated at 150°C for 80 minutes for full curing and bonding. This bonding test was repeatedly carried out ten times. As a result, found was even no one sample having inferior sealing caused by bubbles through the seal (seal leak), and the desired substrate for a liquid crystal display cell was able to be produced in all lots.

Next, the respective cells were cut off independently and then subjected to a peeling test of cell by wedge and a peeling test of cell by wedge after a pressure cooker test at 121°C for 2 hours. Further, the presence of the inferior spots through the seal of the resulting cell and a linearity of the seal lines were observed under a magnifying glass. The results thereof are shown in Table 4. The sealing function durability test of the resulting cell was carried out, and the results thereof are shown as well in Table 4.

Example 8

A composition for a liquid crystal display cell sealant (E8) of the present invention was obtained in the same manner as in Example 5 according to the recipe shown in Table 3.

The composition for a liquid crystal display cell sealant (E8) had an epoxy resin content of 35 %, an inorganic filler content of 16.6 %, a solvent content of 19 %, a silane coupling agent content of 0.9 %, a curing agent content of 27.5 % and a curing accelerator content of 1 %. The initial viscosity at 25°C determined by an E type viscometer was 39 Pa·s.

The physical properties as a sealant of the composition for a liquid crystal display cell sealant (E8) are shown in Table 4.

Blended with 100 parts of the composition for a liquid crystal display cell sealant (E8) was 3 parts of a gap controller of a spherical silica having a particle diameter of 5 μm, and they were sufficiently mixed to obtain a composition. The resulting composition was screen-printed on the ITO substrate in a pattern comprising 4 cells (cell size: 1

inch) which were disposed vertically and horizontally two by two on a substrate to obtain the ITO substrate which was coated the sealant in a width of about 0.5 mm and a thickness of about 20 to 22 μm. Then, it was treated in a hot air drier of 95°C for 25 minutes and then put another ITO substrate which was to be paired, and after adjusting the position, they were temporarily bonded by means of a normal single layer hot press at a press pressure of 0.03 $MPa/cm^2$ and 165°C for 5 minutes. Further, it was then left standing in an oven heated at 150°C for 90 minutes for full curing and bonding. This bonding test was repeatedly carried out ten times. As a result, found was even no one sample having inferior sports in sealing caused by bubbles through the seal (seal leak), and the desired substrate for a liquid crystal display cell was able to be produced in all lots.

Next, the respective cells were cut off independently and then subjected to a peeling test of cell by wedge and a peeling test of cell by wedge after a pressure cooker test at 121°C for 2 hours. Further, the presence of the inferior spots through the seal of the resulting cell and a linearity of the seal lines were observed under a magnifying glass. The results thereof are shown in Table 4. The sealing function durability test of the resulting cell was carried out, and the results thereof are shown as well in Table 4.

Table 3

| | | Example | | | |
|---|---|---|---|---|---|
| | | 5 | 6 | 7 | 8 |
| Raw material | Composition for liquid crystal display cell sealant | E5 | E6 | E7 | E8 |
| | Epoxy resin | | | | |
| | Epotote YDCN | 20 | 12 | 12 | 20 |
| | Epomik R-367 | 2 | | | 2 |
| | Epikote 1007 | | 11 | 11 | |
| | Epiclon 830S | | | | 13 |
| | Rubber-dispersed epoxy resin | | | | |
| | (a) | 15.5 | 10 | 10 | |
| | Curing agent | | | | |
| | X P (Xy lok XLC225) | 25 | 16 | 16 | |
| | Millex 4L | | | | 27.5 |
| | Curing accelerator | | | | |
| | Accelerator U | 1 | 2 | 2 | 1 |
| | Silane coupling agent | | | | |
| | Aminosilane | 0.9 | | | |
| | Y9030 | | 1.5 | 1.5 | |
| | KBM403 | | | | 0.9 |
| | Filler component | | | | |
| | #200 | | 1 | 1 | |
| | MU120 | 2 | | | 2 |
| | UA-5105 alumina | 14.6 | | | 14.6 |
| | Grafted modified alumina | | 15 | 15 | |
| | Solvent | | | | |
| | Methylcarbitol | 19 | | | 19 |
| | PGDA | | 22 | 22 | |
| | High softening point-polymer fine particle raw materiel | | | | |
| | P1 | | 9.5 | | |
| | P2 | | | 9.5 | |
| Total | | 100.0 | 100.0 | 100.0 | 100.0 |

Table 4

| | Example | | | |
|---|---|---|---|---|
| | 5 | 6 | 7 | 8 |
| Single layer hot press aptitude | Suited | Suited | Suited | Suited |
| Storage stability | ○ | ○ | ○ | ○ |
| Coating workability | ○ | ○ | ○ | ○ |

Table 4 (continued)

| | Example | | | |
|---|---|---|---|---|
| | 5 | 6 | 7 | 8 |
| B stage aptitude | ○ | ○ | ○ | ○ |
| Free ion | ◎ | ◎ | ◎ | ◎ |
| Cured matter hardness | ◎ | ○ | ○ | ◎ |
| Storage elastic modulus in hot state | ○ | ○ | ○ | ○ |
| Moisture permeability 60°C/80°C | ○/○ | ○/○ | ○/○ | ○/△ |
| Water absorption coefficient 30 min<br>Water absorption coefficient 3 hrs<br>Water absorption coefficient 5 hrs | 1.5<br>1.4<br>1.3 | 1.6<br>1.6<br>1.5 | 1.2<br>1.1<br>1 | 1.7<br>1.6<br>1.5 |
| Tg | 127 | 107 | 111 | 115 |
| Curing initiation temperature<br>Exothermic intention peak temperature | 101<br>161 | 97<br>158 | 96<br>157 | 102<br>159 |
| Linear expansion coefficient | 47 PPM | 49 PPM | 48 PPM | 47 PPM |
| Bonding-sealing test<br>Presence of disturbed seal line<br>Presence of through-bubbles/ inferior sealing | <br>None<br>None | <br>None<br>None | <br>None<br>None | <br>None<br>None |
| Peeling test of cell by wedge | ◎ | ◎ | ◎ | × |
| Opening test of cell by wedge after pressure cooker test | ○ | ◎ | ◎ | × |
| Interaction with liquid crystal | ◎ | ◎ | ◎ | ◎ |
| Non-bleeding property test | ○ | ○ | ○ | ○ |
| Sealing durability<br>250 hrs<br>500 hrs<br>1000 hrs | <br>◎<br>◎<br>◎ | <br>◎<br>◎<br>◎ | <br>◎<br>◎<br>◎ | <br>◎<br>○<br>△ |

Example 9

A composition for a liquid crystal display cell sealant (E9) of the present invention was obtained in the same manner as in Example 5 according to the recipe shown in Table 5.

The composition for a liquid crystal display cell sealant (E9) comprised an epoxy resin having 2.5 epoxy groups on a weight average in a molecule and had an epoxy resin content of 37 %, a rubber-like polymer fine particle content of 3.9 %, an inorganic filler content of 10.8 %, a high softening point-polymer fine particle content of 3.5 %, a silane coupling agent content of 2 %, a curing agent content of 16.6 %, a curing accelerator content of 2.2 %, a solvent content of 23 % and a wax content of 1 %. The initial viscosity at 25°C determined by an E type viscometer was 64 Pa·s.

The sealant physical properties as a sealant of the composition for a liquid crystal display cell sealant (E9) are shown in Table 6.

Blended with 100 parts of composition for a liquid crystal display cell sealant (E9) was 3 parts of a gap controller of a spherical silica having a particle diameter of 5 µm, and they were sufficiently mixed to obtain a composition. The resulting composition was screen-printed on the ITO substrate in a pattern comprising 4 cells (cell size: 1 inch) which were disposed vertically and horizontally two by two on a substrate which was coated the sealant in to obtain the ITO substrate having a width of about 0.5 mm and a thickness of about 20 to 22 µm. Then, it was dried in a hot air drier of 90°C for 20 minutes and then put another ITO substrate which was to be paired, and after adjusting the position, they were temporarily bonded by a normal single layer hot press at a press pressure of 0.05 MPa/$cm^2$ and 150°C for 6 minutes. Then it was put in an oven heated at 150°C for 80 minutes for full curing. This bonding test was repeatedly carried out ten times. As a result, found was even no one sample having inferior sealing caused by bubbles through

the seal (seal leak), and the desired substrate for a liquid crystal display cell was able to be produced in all lots.

Next, the respective cells were cut off independently and then subjected to a peeling test of cell by wedge and a peeling test of cell by wedge after a pressure cooker test at 121°C for 3 hours. Further, the presence of the inferior spots through the seal of the resulting cell and a linearity of the seal lines were observed under a magnifying glass. The results thereof are shown in Table 6. The sealing function durability test of the resulting cell was carried out, and the results thereof are shown as well in Table 6.

Example 10

A composition for a liquid crystal display cell sealant (E10) of the present invention was obtained in the same manner as in Example 5 according to the recipe shown in Table 5.

The composition for a liquid crystal display cell sealant (E10) comprised an epoxy resin having 2.2 epoxy groups on a weight average in a molecule and had an epoxy resin content of 45.58 %, a rubber-like polymer fine particle content of 5.51 %, an inorganic filler content of 8 %, a high softening point-polymer fine particle content of 1.85 %, a silane coupling agent content of 1.48 %, a curing agent content of 35.73 %, a curing accelerator content of 1.85 % and no solvent content. The initial viscosity determined at 25°C by an E type viscometer was 102 Pa·s.

The physical properties as a sealant of the composition for a liquid crystal display cell sealant (E10) are shown in Table 6.

Blended with 100 parts of composition for a liquid crystal display cell sealant (E10) was 3 parts of a gap controller of a spherical silica having a particle diameter of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was subjected to heat treatment in a hot air drier of 95°C for 15 minutes and then put another ITO substrate which was to be paired, and after adjusting the position, they were temporarily bonded by a normal single layer hot press at a press pressure of 0.05 $MPa/cm^2$ and 170°C for 5 minutes. Then it was put in an oven heated at 150°C for 80 minutes for full curing. This bonding test was repeatedly carried out ten times. As a result, found was even no one sample having inferior sealing caused by bubbles through the seal (seal leak), and the desired substrate for a liquid crystal display cell was be able to be produced in all lots.

Next, the respective cells were cut off independently and then subjected to a peeling test of cell by wedge and a peeling test of cell by wedge after a pressure cooker test at 120°C for 3 hours. Further, the presence of the inferior spots through the seal of the resulting cell and a linearity of the seal lines were observed under a magnifying glass. The results thereof are shown in Table 6. The sealing function durability test of the resulting cell was carried out, and the results thereof are shown as well in Table 6.

Example 11

A composition for a liquid crystal display cell sealant (E11) of the present invention was obtained in the same manner as in Example 5 according to the recipe shown in Table 5.

The composition for a liquid crystal display cell sealant (E11) comprised an epoxy resin having 2.8 epoxy groups on a weight average in a molecule and had an epoxy resin content of 27.84 %, a rubber-like polymer fine particle content of 9.66 %, an inorganic filler content of 16.6 %, a solvent content of 14 %, a silane coupling agent content of 1.9 %, a curing agent content of 25 % and a curing accelerator content of 5 %.

The physical properties as a sealant of the composition for a liquid crystal display cell sealant (E11) are shown in Table 6.

Blended with 100 parts of the composition for a liquid crystal display cell sealant (E11) was 5 parts of a gap controller of a glass short fiber having a size of 5 μm, and they were sufficiently mixed to obtain a composition. The resulting composition was screen-printed on a polyethylene terephthalate plastic substrate for a liquid crystal cell provided with transparent electrodes and an alignment film (hereinafter referred to merely as an ITO plastic substrate) in a pattern comprising 4 cells (cell size: 1 inch) which were disposed vertically and horizontally two by two on a substrate to obtain the ITO plastic substrate which was coated the sealant in a width of about 0.5 mm and a thickness of about 20 to 22 μm. Then, it was subjected to heat treatment at 85°C for 20 minutes and then put another ITO plastic substrate which was to be paired, and after adjusting the position, they were bonded by full curing by a multistage hot press at a press pressure of 0.02 $MPa/cm^2$ and 120°C for 120 minutes. The bonding test was repeatedly carried out ten times. As a result, found was even no one sample having inferior sealing caused by bubbles through the seal (seal leak), and the desired substrate for a liquid crystal display cell was able to be produced in all lots.

Blended with 100 parts of the composition for a liquid crystal display cell sealant (E11) was 3 parts of a gap controller of a spherical silica having a particle diameter of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was subjected to heat treatment in a hot air drier of 95°C for 15 minutes and then put another ITO substrate which was to be paired, and after adjusting the position, they were temporarily bonded by a normal single layer hot press at a press pressure of 0.05 MPa/$cm^2$ and 170°C for 5 minutes, and then it was put in an oven heated at 150°C for 80 minutes for full curing and bonding. This bonding test was repeatedly carried out ten times. As a result, found was even no one sample having inferior sealing caused by bubbles through the seal (seal leak), and the desired substrate for a liquid crystal display cell was able to be produced in all lots.

Next, the respective cells were cut off independently and then subjected to a peeling test of cell by wedge and a peeling test of cell by wedge after a pressure cooker test at 120°C. Further, the presence of the inferior spots through the seal of the resulting cell and a linearity of the seal lines were observed under a magnifying glass. The results thereof are shown in Table 6. The sealing function durability test of the resulting cell was carried out, and the results thereof are shown as well in Table 6.

Example 12

A composition for a liquid crystal display cell sealant (E12) was prepared in the same manner as in Example 11, except that 10 parts of Marukalyncur S-1 and 15 parts of Marukalyncur CBA were substituted for 25 parts of the curing agent FPI5127 (PPF resin) used in Example 11. The physical properties as a sealant of the composition for a liquid crystal display cell sealant (E12) are shown in Table 6.

Blended with 100 parts of the composition for a liquid crystal display cell sealant (E12) was 5 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 80°C for 20 minutes and then put another ITO substrate which was to be paired, and after adjusting the position, they were temporarily bonded by a normal single layer hot press at a press pressure of 0.03 MPa/$cm^2$ and 180°C for 5 minutes. Then, it was bonded by full curing at 150°C for 80 minutes. This bonding test was repeatedly carried out ten times. As a result, inferior spots in sealing caused by bubbles through the seal (seal leak) and disturbed seal lines were not brought about at all. Further, the result of the sealing function durability test carried out using the resulting cell was good even after 1000 hours as shown in Table 6.

Example 13

A composition for a liquid crystal display cell sealant (E13) was prepared in the same manner as in Example 11, except that 5 parts of the OP resin and 15 parts of the Milex SP resin were substituted for 25 parts of the curing agent FPI5127 (PPF resin) used in Example 11.

The physical properties as a sealant of the composition for a liquid crystal display cell sealant (E13) are shown in Table 6.

Blended with 100 parts of the composition for a liquid crystal display cell sealant (E13) was 5 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 80°C for 20 minutes and then put another ITO substrate which was to be paired, and after adjusting the position, they were temporarily bonded by a normal single layer hot press at a press pressure of 0.03 MPa/$cm^2$ and 180°C for 5 minutes. Then, it was bonded by full curing at 150°C for 80 minutes. This bonding test was repeatedly carried out ten times. As a result, inferior spots in sealing caused by bubbles through the seal (seal leak) and disturbed seal lines were not brought about at all.

The result of the bonding-sealing test and the sealing function durability test are shown in Table 6.

Table 5

| | | Example | | | | |
|---|---|---|---|---|---|---|
| | | 9 | 10 | 11 | 12 | 13 |
| Raw material | Composition for liquid crystal display cell sealant | E9 | E10 | E11 | E12 | E13 |
| | Epoxy resin | | | | | |
| | 2-EHMG | | 5.19 | | | |
| | 1,6-EGDE | | 13.34 | | | |
| | t-BPMG | | 0.37 | | | |
| | Epomik VG3101L | 12 | 8.9 | | | |
| | Epotote YDCN | 0 | | 10 | 10 | 10 |
| | Epotote ST-1000 | | | 2 | 2 | 2 |
| | Epomik R-367 | 12 | 8.9 | | | |
| | Epotote YH434 | 3.9 | 2.89 | | | |
| | Rubber-dispersed epoxy resin composition | | | | | |
| | (a) | | 9.54 | | | |
| | (b) | 13 | | 25.5 | 25.5 | 25.5 |
| | Curing agent | | | | | |
| | EP (Milex VR9315) | 16.6 | | | | |
| | FPI5127 | | 13.57 | 25 | | |
| | Tris P compound | | 22.17 | | | |
| | Marukalyncur S-1 | | | | 10 | |
| | Marukalyncur CBA | | | | 15 | |
| | OP | | | | | 5 |
| | SP | | | | | 15 |
| | Curing accelerator | | | | | |
| | Accelerator U | 2.2 | 1.85 | 5 | 5 | 5 |
| | Silane coupling agent | | | | | |
| | Aminosilane | | | 1.9 | 1.9 | 1.9 |
| | KBM403 | 2 | 1.47 | | | |

Table 5 (continued)

| | | Example | | | | |
|---|---|---|---|---|---|---|
| | | 9 | 10 | 11 | 12 | 13 |
| Raw material | Filler component | | | | | |
| | CR-EL | 1.5 | 1.1 | | | |
| | MU120 | | | 1 | 1 | 1 |
| | UA-5105 alumina | | | 15.6 | 15.6 | 15.6 |
| | Grafted modified alumina | 9.3 | 7 | | | |
| | Solvent | | | | | |
| | Butyl cellosolve/ ethyl cellosolve | 23 | | | | |
| | Methylcarbitol | | | 5 | 5 | 5 |
| | PGMEA | | | 9 | 9 | 9 |
| | High softening point-polymer fine particle raw material | | | | | |
| | P1 | 3.5 | | | | |
| | P2 | | 3.71 | | | |
| | Wax | | | | | |
| | Carnauba wax | 1 | | | | |
| Total | | 100.0 | 100.0 | 100.0 | 100.0 | 95.0 |

Table 6

| | Example | | | | |
|---|---|---|---|---|---|
| | 9 | 10 | 11 | 12 | 13 |
| Single layer hot press aptitude | Suited | Suited | Suited | Suited | Suited |
| Storage stability | ○ | ○ | ○ | ○ | ○ |
| Coating workability | ○ | ○ | ○ | ○ | ○ |
| B stage aptitude | ○ | ○ | ○ | ○ | ○ |
| Free ion | ◎ | ○ | ◎ | ◎ | ◎ |
| Cured matter hardness | ○ | ○ | ○ | ○ | ○ |
| Storage elastic modulus in hot state | ○ | ○ | ○ | ○ | ○ |
| Moisture permeability 60°C/80°C | ○/○ | ○/Δ | ○/○ | ○/◎ | ◎ /◎ |
| Water absorption coefficient 30 min<br>Water absorption coefficient 3 hrs<br>Water absorption coefficient 5 hrs | 1.35<br>1.3<br>1.25 | 1.7<br>1.7<br>1.6 | 1.7<br>1.6<br>1.5 | 1.4<br>1.3<br>1.25 | 1.65<br>1.6<br>1.6 |
| Tg | 117 | 104 | 122 | 119 | 125 |
| Curing initiation temperature<br>Exothermic initiation peak temperature | 95<br>156 | 100<br>159 | 93<br>159 | 95<br>158.9 | 95<br>151 |
| Linear expansion coefficient | 45 PPM | 47 PPM | 44 PPM | 46 PPM | 45 PPM |
| Bonding-sealing test<br>Presence of disturbed seal line | None | None | None | None | None |

Table 6 (continued)

| | Example | | | | |
|---|---|---|---|---|---|
| | 9 | 10 | 11 | 12 | 13 |
| Presence of through-bubbles/inferior sealing | None | None | None | None | None |
| Peeling test of cell by wedge | ◎ | ◎ | ◎ | ◎ | ◎ |
| Peeling test of cell by wedge after pressure cooker test | ◎ | ◎ | ○ | ○ | ○ |
| Interaction with liquid crystal | ◎ | ◎ | ◎ | ◎ | ◎ |
| Non-bleeding property test | ○ | ○ | ○ | ○ | ○ |
| Sealing durability<br>250 hrs<br>500 hrs<br>1000 hrs | <br>◎<br>◎<br>◎ | <br>◎<br>◎<br>○ | <br>◎<br>◎<br>○ | <br>◎<br>◎<br>○ | <br>◎<br>◎<br>○ |

Comparative Example 1

Added to a solution prepared by dissolving in 20 parts of methylcarbitol, 30 parts of an unrefined orthocresol novolak type epoxy resin (shown as crude novolak epoxy in Table 7) which was a solid epoxy resin and in which an ion concentration of extract water was 6.2 mS/m (62 μS/cm) and a number average molecular weight determined by GPC was about 890 were 106 parts of a liquid bisphenol A type epoxy resin "Epomik R140 special grade" (shown merely as crude R-140 in Table 7) in which a content of hydrolytic chlorine was 350 ppm, 18 parts of adipic acid dihydrazide (abbreviated as ADH in Table 7) as a potential curing agent for epoxy resin which was insoluble in an epoxy resin at room temperature, 0.2 parts of N-cyanoethyl-2-ethyl-4-methylimidazole as a curing accelerator, 5 parts of titanium oxide "CR-EL", 3 parts of spherical silica "SO-E1-6", 14.8 parts of amorphous alumina UA-5105, a product manufactured by Showa Denko K. K. and 2 parts of epoxysilane, and they were pre-kneaded. Then, they were kneaded by means of a three roll mill until the solid raw materials were pulverized to 5 μm or less, and the kneaded matter was subjected to vacuum degassing treatment to obtain a composition for a liquid crystal display cell sealant (F1) described in Table 7.

The composition for a liquid crystal display cell sealant (F1) comprised an epoxy resin having 2.5 epoxy groups on a weight average in a molecule and had an epoxy resin content of 68 %, an inorganic filler content of 11.9 %, a silane coupling agent content of 1 %, a potential curing agent for epoxy resin content of 9 %, a curing accelerator content of 0.1 % and a solvent content of 10 %. The initial viscosity at 25°C determined by an E type viscometer was 29 Pa·s and a thixotropic index shown by a ratio of a viscosity at 1 revolution/a viscosity at 10 revolution was 1.7.

The physical properties as a sealant of the composition for a liquid crystal display cell sealant (F1) are shown in Table 8.

Blended with 100 parts of the composition for a liquid crystal display cell sealant (F1) was 5 parts of a gap controller of a glass short fiber having a size of 5 μm, and they were sufficiently mixed to obtain a composition. The resulting composition was screen-printed on the ITO substrate in a pattern comprising 4 cells (cell size: 1 inch) which were disposed vertically and horizontally two by two on a substrate to obtain the ITO substrate which was coated the sealant in a width of about 0.5 mm and a thickness of about 20 to 22 μm. Then, it was treated in a hot air drier of 80°C for 20 minutes and then put another ITO substrate which was to be paired, and after adjusting the position, it was left standing in a oven of 150°C for 90 minutes under a condition in which 10 sets thereof were compressed and maintained at a press pressure of 0.03 MPa/$cm^2$ by means of a multistage press, whereby they were fully cured and bonded. As a result, inferior spots in sealing caused by bubbles through the seal (seal leak) and disturbed seal lines were not found. The sealing function durability test of the resulting cell was carried out, and the results thereof are shown in an evaluation column of the sealing durability in Table 8. It was shown that a liquid crystal display element prepared by bonding this composition for a liquid crystal display cell sealant (F1) by a multistage hot press had a good production aptitude.

Further, blended with 100 parts of the composition for a liquid crystal display cell sealant (F1) was 5 parts of a gap controller of a glass short fiber having a size of 5 μm, and they were sufficiently mixed to obtain a composition. The resulting composition was screen-printed on the ITO substrate in a pattern comprising 6 cells (cell size: 1 inch) which were disposed vertically and horizontally two by two on a substrate to obtain the ITO substrate which was coated the sealant in a width of about 0.5 mm and a thickness of about 20 to 22 μm. Then, the above 4 cells were treated in a hot air drier of 80°C for 20 minutes and then put another ITO substrate which was to be paired, and after adjusting the position, they were temporarily bonded at a press pressure of 0.03 MPa/$cm^2$ and 180°C for 4 minutes by means

of a normal single layer hot press to find that bubbles through the seal (seal leak) were produced and inferior seal lines were observed. Accordingly, it was confirmed that this composition for a liquid crystal display cell sealant (F1) was lacking in a single layer hot press aptitude. Further, the remaining 2 cells were treated in a hot air drier of 80°C for 20 minutes and then put another ITO substrate which was to be paired, and after adjusting the position, they were compressed and fixed at 0.03 MPa/cm$^2$. Then, the temperature was elevated at 2°C per minute, and after reaching 130°C, they were left standing at the above temperature for 90 minutes to prepare a liquid crystal display cell. The results of a peeling test of the resulting cell by wedge and a non-bleeding property test are shown respectively in Table 8.

Comparative Example 2

Added to a solution prepared by dissolving in 15 parts of methylcarbitol, 25 parts of the unrefined orthocresol novolak type epoxy resin (shown as crude novolak epoxy in Table 7) which was a solid epoxy resin and in which an ion concentration of extract water was 6.2 mS/m (62 μS/cm) and a number average molecular weight determined by GPC was about 890 and 3 parts of Epomik R-367 were 17 parts of a liquid bisphenol F type epoxy resin Epiclon EP830 in which a content of hydrolytic chlorine was 500 ppm, 12 parts of dodecanedioic acid dihydrazide (abbreviated as DDH in Table 7), 1 part of tris(dimethylaminomethylphenol) hydrochloride (shown merely as DMP-30 hydrochloride in Table 7) as an accelerator, 1 part of aminosilane, 2 parts of amorphous silica "MU-120" and 10 parts of CR-10 and 13 parts of CR-125 as amorphous alumina, and they were pre-kneaded. Then, they were kneaded by means of a three roll mill until the solid raw materials were pulverized to 5 μm or less, and the kneaded matter was subjected to vacuum degassing treatment to obtain a composition for a liquid crystal display cell sealant (F2) described in Table 7.

The composition for a liquid crystal display cell sealant (F2) comprised 45 % of the epoxy resin, 25 % of the inorganic filler, 1 % of the silane coupling agent, 12 % of the potential curing agent for epoxy resin, 2 % of the curing accelerator and 15 % of the solvent. The initial viscosity at 25°C determined by an E type viscometer was 35 Pa·s and a thixotropic index shown by a ratio of a viscosity at 1 revolution/a viscosity at 10 revolution was 1.6.

The physical properties as a sealant of the composition for a liquid crystal display cell sealant (F2) are shown in Table 8.

Blended with 100 parts of the composition for a liquid crystal display cell sealant (F2) was 3 parts of a gap controller of a glass short fiber having a size of 5 μm, and they were sufficiently mixed to obtain a composition. The resulting composition was screen-printed on the ITO substrate in a pattern comprising 6 cells (cell size: 1 inch) which were disposed vertically and horizontally two by two on a substrate to obtain the ITO substrate which was coated the sealant in a width of about 0.5 mm and a thickness of about 20 to 22 μm. Then, the above 4 cells were treated in a hot air drier of 80°C for 20 minutes and then put another ITO substrate which was to be paired, and after adjusting the position, they were temporarily bonded for 10 minutes by a vacuum single layer hot press at a vacuum degree of -980 hectopascal and 180°C to find that bubbles through the seal (seal leak) were produced and inferior seal lines were observed. Accordingly, it was confirmed that this composition for a liquid crystal display cell sealant (F2) was lacking in a vacuum single layer hot press aptitude. Further, the remaining 2 cells were treated in a hot air drier of 80°C for 20 minutes and then put another ITO substrate which was to be paired, and after adjusting the position, they were compressed and fixed at 0.03 MPa/cm$^2$. Then, the temperature was elevated from room temperature at 2°C per minute, and after reaching 150°C. they were further left standing at the above temperature for 90 minutes to prepare a liquid crystal display cell. The results obtained by observing a liquid crystal display function of the resulting cells are shown together in Table 8. In the result of the sealing function durability test carried out using the resulting cells, uneven display was notably observed within 250 hours, and a reduction in the display function was brought about.

Table 7

| | | Comparative Example | |
|---|---|---|---|
| | | 1 | 2 |
| Sealant composition | Composition for liquid crystal display cell sealant | F1 | F2 |
| | Epoxy resin | | |
| | Crude R-140 | 106 | |
| | Crude EP-830 | | 17 |
| | Crude novolak epoxy | 30 | 25 |
| | Epomik R-367 | | 3 |
| | Curing agent component | | |
| | ADH | 18 | |
| | CN-2E4MZ | 0.2 | |
| | DDH | | 12 |
| | Curing accelerator | | |
| | DMP-30 hydrochloride | | 2 |
| | Silane coupling agent | | |
| | Aminosilane | | 1 |
| | KBM403 | 2 | |
| | Filler | | |
| | #380 | 3 | |
| | CR-EL | 5 | |
| | MU120 | | 2 |
| | UA-5105 alumina | | 0 |
| | Amorphous alumina | 15.8 | |
| | CR-10 | | 10 |
| | CR-125 | | 13 |
| | Solvent | | |
| | Methylcarbitol | 20 | 15 |
| Total | | 200 | 100.0 |

Table 8

| | Comparative Example | |
|---|---|---|
| | 1 | 2 |
| Single layer hot press aptitude | Unsuited | Unsuited |
| Storage stability | ○ | ○ |
| Coating workability | Δ | ○ |
| B stage aptitude | X (-) | X (-) |
| Free ion | × | ×× |

Table 8 (continued)

| | Comparative Example 1 | Comparative Example 2 |
|---|---|---|
| Cured matter hardness | ○ | ○ |
| Storage elastic modulus in hot state | ○ | ○ |
| Moisture permeability 60°C/80°C | Δ/× | ×/× |
| Water absorption coefficient 30 min<br>Water absorption coefficient 3 hrs<br>Water absorption coefficient 5 hrs | 3.6<br>3.6<br>3.5 | 3.6<br>3.6<br>3.5 |
| Tg | 115 | 122 |
| Curing initiation temperature<br>Exothermic initiation peak temperature | 55<br>139 | 75<br>157 |
| Linear expansion coefficient | 62 PPM | 51 PPM |
| Bonding-sealing test<br>Presence of disturbed seal line<br>Presence of through-bubbles/ inferior sealing | <br>Present<br>Present | <br>Present<br>Present |
| Peeling test of cell by wedge | X | X |
| Interaction with liquid crystal | X | X |
| Non-bleeding property test | X | X |
| Sealing durability<br>250 hrs<br>500 hrs<br>1000 hrs | <br>○<br>Δ<br>X | <br>× |

Example 14

Pre-mixed together by means of a Dalton mixer were 68.1 parts of a resin solution obtained by dissolving 43.1 parts of Epomik VG3101L in 25 parts of propylene glycol monomethyl ether acetate, 372.4 parts of a curing agent solution obtained by dissolving in advance 111.2 parts of the NA resin (naphthol aralkyl resin) and 111.2 parts of DCN (didcyclopentadiene-modified phenol novolak resin) in 150 parts of propylene glycol monomethyl ether acetate, 250 parts of the silicone rubber-containing epoxy resin composition (b), 21.6 parts of 5302T as a curing accelerator, 4.3 parts of Cat Z-15 as a curing accelerator, 8.6 parts of KBM403, 12.9 parts of MU-120 as amorphous silica and 262.1 parts of spherical alumina SO-A805 prepared by grafting thereon in advance a silane coupling agent. Then, they were kneaded by means of a three roll mill until the solid raw materials were pulverized to 5 μm or less, and 2 parts of a gap controller of a glass short fiber of 6 μm was added to 100 parts of the above kneaded matter, and they were mixed and subjected to vacuum degassing treatment to obtain a composition for a liquid crystal display cell sealant (E14) described in Table 9.

The composition for a liquid crystal display cell sealant (E14) excluding the gap controller had an epoxy resin content of 21.81 %, a solvent content of 17.5 %, a rubber-like polymer fine particle content of 7.5 %, an inorganic filler content of 27.5 %, a curing agent content of 22.24 %, a curing accelerator content of 2.59 % and a silane coupling agent content of 0.86 %.

The physical properties as a sealant of the composition for a liquid crystal display cell sealant (E14) are shown in Table 10.

The composition for a liquid crystal display cell sealant (E14) was used to carry out the bonding-sealing test in the same manner as in Example 1, and the results of the bonding-sealing test and the sealing durability test were shown in Table 10. It was confirmed that the resulting cell showed complete cohesive failure of the sealant in both of the peeling test of cell by wedge and the peeling test of cell by wedge after pressure cooker and was excellent in adhesion reliability. Further, the display function was good after 1000 hours passed in the sealing function durability test.

Example 15

A composition for a liquid crystal display cell sealant (E15) of the present invention was obtained in the same manner as in Example 14 according to the recipe shown in Table 9.

The composition for a liquid crystal display cell sealant (E15) excluding the gap controller had an epoxy resin content of 21.15 %, a solvent content of 16 %, a rubber-like polymer fine particle content of 9.85 %, an inorganic filler content of 23.5 %, a curing agent content of 26.5 %, a curing accelerator content of 1 % and a silane coupling agent content of 2 %.

The physical properties as a sealant of the composition for a liquid crystal display cell sealant (E15) are shown in Table 10.

The composition for a liquid crystal display cell sealant (E15) was used to carry out the bonding-sealing test in the same manner as in Example 5, and the results of the bonding-sealing test and the sealing durability test were shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Example 16

A composition for a liquid crystal display cell sealant (E16) of the present invention was obtained in the same manner as in Example 14 according to the recipe shown in Table 9.

The composition for a liquid crystal display cell sealant (E16) excluding the gap controller had an epoxy resin content of 35.15 %, a rubber-like polymer fine particle content of 9.85 %, an inorganic filler content of 21.3 %, a curing agent content of 29 %, a curing accelerator content of 3.2 % and a silane coupling agent content of 1.5 %.

The physical properties as a sealant of the composition for a liquid crystal display cell sealant (E16) are shown in Table 10.

The composition for a liquid crystal display cell sealant (E16) was used to carry out the bonding-sealing test in the same manner as in Example 5, and the results of the bonding-sealing test and the sealing durability test were shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Example 17

A composition for a liquid crystal display cell sealant (E17) of the present invention was obtained in the same manner as in Example 14 according to the recipe shown in Table 9.

The composition for a liquid crystal display cell sealant (E17) excluding the gap controller had an epoxy resin content of 35.15 %, a rubber-like polymer fine particle content of 9.85 %, an inorganic filler content of 21.3 %, a curing agent content of 29 %, a curing accelerator content of 3.2 % and a silane coupling agent content of 1.5 %.

The physical properties as a sealant of the composition for a liquid crystal display cell sealant (E17) are shown in Table 10.

The composition for a liquid crystal display cell sealant (E17) was used to carry out the bonding-sealing test in the same manner as in Example 5, and the results of the bonding-sealing test and the sealing durability test were shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Example 18

A composition for a liquid crystal display cell sealant (E18) of the present-invention was obtained in the same manner as in Example 14 according to the recipe shown in Table 9.

The composition for a liquid crystal display cell sealant (E18) excluding the gap controller had an epoxy resin content of 35.15 %, a rubber-like polymer fine particle content of 9.85 %, an inorganic filler content of 21.3 %, a curing agent content of 25.5 %, a curing accelerator content of 3.2 %, a silane coupling agent content of 1.5 % and a high softening point-polymer fine particle content of 3.5 %.

The physical properties as a sealant of the composition for a liquid crystal display cell sealant (E18) are shown in Table 10.

The composition for a liquid crystal display cell sealant (E18) was used to carry out the bonding-sealing test in the same manner as in Example 5, and the results of the bonding-sealing test and the sealing durability test were

shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Example 19

A composition for a liquid crystal display cell sealant (E19) of the present invention was obtained in the same manner as in Example 14 according to the recipe shown in Table 9.

The composition for a liquid crystal display cell sealant (E19) excluding the gap controller had an epoxy resin content of 34.57 %, a solvent content of 19.2 %, a rubber-like polymer fine particle content of 7.13 %, an inorganic filler content of 17 %, a curing agent content of 19 %, a curing accelerator content of 2.1 % and a silane coupling agent content of 1 %.

The physical properties as a sealant of the composition for a liquid crystal display cell sealant (E19) are shown in Table 10.

The composition for a liquid crystal display cell sealant (E19) was used to carry out the bonding-sealing test in the same manner as in Example 5, and the results of the bonding-sealing test and the sealing durability test were shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Example 20

A composition for a liquid crystal display cell sealant (E20) of the present invention was obtained in the same manner as in Example 14 according to the recipe shown in Table 9.

The composition for a liquid crystal display cell sealant (E20) excluding the gap controller had an epoxy resin content of 28.54 %, a solvent content of 13.2 %, a rubber-like polymer fine particle content of 8.26 %, an inorganic filler content of 17.3 %, a curing agent content of 28 %, a curing accelerator content of 3.2 % and a silane coupling agent content of 1.5 %.

The physical properties as a sealant of the composition for a liquid crystal display cell sealant (E20) are shown in Table 10.

The composition for a liquid crystal display cell sealant (E20) was used to carry out the bonding-sealing test in the same manner as in Example 5, and the results of the bonding-sealing test and the sealing durability test were shown in Table 10. It was confirmed that the resulting cell showed complete cohesive failure of the sealant in the peeling test of cell by wedge and was excellent in adhesion reliability. Further, the display function was good after 1000 hours passed in the sealing function durability test.

Table 9

| | | Example | | | | | | |
|---|---|---|---|---|---|---|---|---|
| | | 14 | 15 | 16 | 17 | 18 | 19 | 20 |
| Sealant composi -tion | Composition for liquid crystal display cell sealant | E14 | E15 | E16 | E17 | E18 | E19 | E20 |
| | Epoxy resin | | | | | | | |
| | EPA-005 | | | | | | | 15 |
| | 1,6-HGDE | | | 13 | 13 | 13 | | |
| | t-BPMG | | | 6 | 6 | 6 | | |
| | Epomik VG3101L | 4.31 | | | | | | |
| | Epotote YDCN | | 2.5 | | | | 16.9 | |
| | Sumika ELM-100 | | 2.5 | | | | | |
| | Epikote 1007 | | | | | | 6 | |
| | Rubber-dispersed epoxy resin | | | | | | | |
| | (a) | | 26 | 26 | 26 | 26 | 18.8 | 21.8 |
| | (b) | 25 | | | | | | |
| | Curing agent | | | | | | | |
| | Naphthol aralkyl NA | 11.12 | | | | | | 27.5 |
| | DCN (dcpg-modified novolak resin) | 11.12 | 16.5 | | | | | |
| | Esterified DCN | | 10 | | | | | |
| | NN | | | 14.5 | 14.5 | 14.5 | | |
| | CHN | | | | 14.5 | | | |
| | PSM4261 | | | | | 11 | 2 | |
| | FPI5136 | | | 14.5 | | | 7 | |
| | Other potential curing agent for epoxy resin | | | | | | | |
| | ADH | | | | | | | 0.5 |
| | Curing accelerator | | | | | | | |
| | 5302T | 2.16 | | 3 | | 3 | 2.1 | |
| | 5303N | | | | | | | 2.2 |
| | Accelerator U | | | | 3 | | | |
| | Cat-Z | 0.43 | | | | | | 1 |
| | PZO | | 1 | 0.2 | 0.2 | 0.2 | | |

Table 9 (continued)

| | | Example | | | | | | |
|---|---|---|---|---|---|---|---|---|
| | | 14 | 15 | 16 | 17 | 18 | 19 | 20 |
| Sealant composition | Silane coupling agent | | | | | | | |
| | Y9030 | | | 1.5 | 1.5 | 1.5 | | |
| | KBM403 | 0.86 | 2 | | | | 1 | 1.5 |
| | Filler | | | | | | | |
| | MU120 | 1.29 | 2 | 1.3 | 1.3 | 1.3 | 1 | 1.3 |
| | SO-A805 | 26.21 | | 20 | 20 | 20 | | |
| | SO-E1-6 | | | | | | 16 | 16 |
| | CR10 | | 1.5 | | | | | |
| | CR-10-3 | | 20 | | | | | |
| | High softening point polymer fine particle | | | | | | | |
| | P2 | | | | | 3.5 | | |
| | Solvent | | | | | | | |
| | Methylcarbitol | | | | | | 19.2 | 13.2 |
| | PGMEA | 17.5 | 16 | | | | | |
| | Subtotal | 100 | 100 | 100 | 100 | 100 | 100 | 100 |
| | Gap controller | | | | | | | |
| | 6 μm glass short fiber | 2 | 2 | 2 | 2 | 2 | 2 | 2 |
| Total | | 102 | 102 | 102 | 102 | 102 | 102 | 102 |

Table 10

| | Example | | | | | | |
|---|---|---|---|---|---|---|---|
| | 14 | 15 | 16 | 17 | 18 | 19 | 20 |
| Single layer hot press aptitude | Suited | Suited | Suited | Suited | Suited | Suited | Suited |
| Storage stability | ○ | ○ | ○ | ○ | ○ | ○ | ○ |
| Coating workability | ○ | ○ | ○ | ○ | ○ | ○ | ○ |
| B stage aptitude | ○ | ○ | ○ | ○ | ○ | ○ | ○ |
| Free ion | ◎ | ◎ | ○ | ○ | ○ | ◎ | ◎ |
| Cured matter hardness | ○ | ○ | ○ | ○ | ◎ | ○ | ○ |
| Storage elastic modulus in hot state | ○ | ○ | ○ | ○ | ○ | ○ | ○ |
| Moisture permeability 60°C/80°C | ◎ /◎ | ◎ /◎ | ○/○ | ○/○ | ○/○ | ◎ /◎ | ○/○ |
| Water absorption coefficient 30 min<br>Water absorption coefficient 3 hrs<br>Water absorption coefficient 5 hrs | 0.24<br>0.27<br>0.28 | 0.21<br>0.23<br>0.23 | 0.9<br>1.1<br>1.1 | 1.1<br>1.3<br>1.4 | 0.78<br>0.8<br>0.82 | 1.2<br>1.3<br>1.4 | 1.6<br>1.7<br>1.7 |
| Tg | 127 | 115 | 122 | 119 | 141 | 116 | 106 |
| Curing initiation temperature | 71 | 75 | 75 | 74 | 76 | 106 | 114 |

Table 10 (continued)

| | Example | | | | | | |
|---|---|---|---|---|---|---|---|
| | 14 | 15 | 16 | 17 | 18 | 19 | 20 |
| Exothermic initiation peak temperature | 162 | 147 | 147 | 145 | 146 | 153 | 166 |
| Linear expansion coefficient | 37 ppm | 39 ppm | 57 ppm | 55 ppm | 49 ppm | 41 ppm | 43 ppm |
| Bonding-sealing test<br>Presence of disturbed seal line<br>Presence of through-bubbles/inferior sealing | <br>None<br>None | <br>None<br>None | <br>None<br>None | <br>None<br>None | <br>None<br>None | <br>None<br>None | <br>None<br>None |
| Peeling test of cell by wedge | ◎ | ◎ | ◎ | ◎ | ◎ | ◎ | ◎ |
| Interaction with liquid crystal | ◎ | ◎ | ◎ | ○ | ○ | ◎ | ◎ |
| Non-bleeding property test | ○ | ○ | ○ | ○ | ○ | ○ | ○ |
| Sealing durability<br>250 hrs<br>500 hrs<br>1000 hrs | <br>◎<br>◎<br>◎ | <br>◎<br>◎<br>◎ | <br>◎<br>◎<br>◎ | <br>◎<br>◎<br>◎ | <br>◎<br>◎<br>◎ | <br>◎<br>◎<br>◎ | <br>◎<br>◎<br>◎ |

Comparative Example 3

A composition for a liquid crystal display cell sealant (F3) was obtained in the same manner as in Comparative Example 1 according to the recipe shown in Table 11. The F3 composition is an example containing no curing accelerator, and shown in Table 12 were the measured results of the physical properties as a sealant other than the water absorption coefficient, the TMA measurement (Tg, linear expansion coefficient), the moisture permeability and the surface hardness characteristic. The coated film obtained in hot curing at 150°C for 90 minutes formed only a non-curing film exhibiting a strong adhesive property in a range of 80 to 150°C and exhibited a property of easily swelling in an acetone solvent. Accordingly, the above F3 composition containing no curing accelerator is a composition having a markedly slow hot curing property, so that the water absorption characteristic evaluation and the TMA measurement were not substantially able to be carried out, and the water absorption coefficient, the Tg and the moisture permeability in Table 12 were not able to be measured.

Blended with 100 parts of the above composition F3 was 2 parts of a gap controller of a glass short fiber of 6 μm, and it was subjected to the bonding-sealing test in the same manner as in Example 1. As a result, a bonded cell in which bleeding and production of bubbles through the seal (seal leak) were scarcely observed was able to be formed, but the heat resistant adhesive strength was low, and the adhesive strength was low in taking out from a hot press plate, so that positional deviation between the substrates provided vertically was observed in all lots. Accordingly, it was judged that the single layer hot press aptitude was unsuitable. In the result of the sealing function durability test carried out using the resulting cell, the liquid crystal display function durability was lacking as shown in Table 12.

Comparative Example 4

A composition for a liquid crystal display cell sealant (F4) was obtained in the same manner as in Example 1 according to the recipe shown in Table 11. The F4 composition is an example using an imidazole monomer as a curing accelerator. The physical properties as a sealant of the composition for a liquid crystal display cell sealant (F4) are shown in Table 12. It was confirmed that the above composition F4 apparently had a fatal problem on a pot life at room temperature and was lacking in coating workability.

Blended with 100 parts of the above composition F4 obtained immediately after produced was 2 parts of a gap controller of a glass short fiber of 6 μm, and it was subjected to the bonding-sealing test in the same manner as in Example 1. As a result, it was confirmed that the composition obtained after pre-dried was hard and did not have wettability to the paired substrates and that a half of the cells obtained in the bonding-sealing test was not substantially adhered and was a sealant which was lacking in a single layer hot press aptitude. Further, the results obtained by observing the resulting cells are shown in Table 12.

The above composition F4 which was left standing at room temperature of 23°C for 10 hours after produced was used to carry out the bonding-sealing test in the same manner as in Example 1 to find that all of the cells exhibited

inferior bonding, and it was confirmed that the sealant was notably lacking in a single layer hot press aptitude.

The cell which was produced using the above composition F4 obtained immediately after produced and was subjected to the bonding-sealing test described above and in which adhesion was secured to some extent was subjected to the sealing durability test, and the results thereof are shown in Table 12. As a result, it was confirmed that the durability was almost good, but it was fatal that the storage stability was lacking.

Comparative Example 5

A composition for a liquid crystal display cell sealant (F5) was obtained in the same manner as in Example 1 according to the recipe shown in Table 11. The F5 composition is an example using triphenylphosphine as a curing accelerator. The physical properties as a sealant of the composition for a liquid crystal display cell sealant (F5) are shown in Table 12. The above composition F5 apparently had a serious problem on a pot life at room temperature and was lacking in a coating workability.

Blended with 100 parts of the above composition F5 obtained immediately after produced was 2 parts of a gap controller of a glass short fiber of 6 μm, and it was subjected to the bonding-sealing test in the same manner as in Example 1. As a result, it was confirmed that the composition obtained after pre-dried was hard and short of wettability to the paired substrates and that almost a half of the cells obtained in the bonding-sealing test was found to be substantially defective in adhesion and was a sealant which was lacking in a single layer hot press aptitude. The results obtained by observing the resulting cells are shown in Table 12.

The above composition F5 which was left standing at room temperature of 25°C for 12 hours after produced was used to carry out the bonding-sealing test in the same manner as in Example 1 to find that inferior adhesion or defective adhesion was observed in all of the cells and that leakage and a peeling phenomenon in charging liquid crystal were caused, and it was confirmed that the sealant was notably lacking in a single layer hot press aptitude.

The cell which was produced using the above composition F5 obtained immediately after produced and was subjected to the bonding-sealing test described above and in which adhesion was secured was subjected to the sealing durability test, and the results thereof are shown in Table 12. As a result, it was confirmed that the durability was almost good, but it was fatal that the storage stability was lacking.

Comparative Example 6

A composition for a liquid crystal display cell sealant (F6) was obtained in the same manner as in Example 1 according to the recipe shown in Table 11. The F6 composition has a blending amount of the polyphenol curing agent of 9.9 mass % and is an example in which an equivalent ratio of the curing agent to the epoxy resin is too small (epoxy group : active phenolic hydroxyl group = 1 : 0.3 in terms of an equivalent ratio). The physical properties as a sealant of the composition for a liquid crystal display cell sealant (F6) are shown in Table 12. It was confirmed that the composition F6 apparently had a fatal problem that it provided only a cured matter which was lacking in heat resistant rigidity.

The coated film obtained in hot curing at 150°C for 90 minutes formed only a non-curing film exhibiting a strong adhesive property in a range of 80 to 150°C and exhibited a property of easily swelling in an acetone solvent. Accordingly, a problem resides in that the F6 sealant composition having a too small curing agent content provides at room temperature only a cured matter which is fragile and has a strong adhesive property and which is lacking in heat resistant rigidity. The smooth film-like cured matter having no tackiness was not obtained, so that the moisture permeability and the water absorption characteristic were not substantially able to be evaluated, and the water absorption coefficient and the moisture permeability in Table 12 were rated as unmeasurable.

Blended with 100 parts of the above composition F6 was 2 parts of a gap controller of a glass short fiber of 6 μm, and it was subjected to the bonding-sealing test in the same manner as in Example 1. As a result, bleeding was not found, but production of bubbles through the seal (seal lack) was observed at a probability of 25 %. The bonded cell maintaining a form thereof was able to be obtained, and therefore it was judged that the single layer hot press aptitude was almost good. Further, the resulting cell was subjected to the peeling test of cell by wedge and the sealing durability test. The results thereof are shown in Table 12 and show that the liquid crystal display function durability is lacking.

Comparative Example 7

A composition for a liquid crystal display cell sealant (F7) was obtained in the same manner as in Example 1 according to the recipe shown in Table 11. The F7 composition has a blending amount of the polyphenol curing agent of 52 mass % and is an example in which an equivalent ratio of the curing agent to the epoxy resin is too large (epoxy group : active phenolic hydroxyl group = 1 : 4 in terms of a charged equivalent ratio). The physical properties as a sealant of the composition for a liquid crystal display cell sealant (F7) are shown in Table 12. It is apparently a sealant

having a fatal problem that it provides only a cured matter which is so fragile as easily broken by bending by about 10°. Accordingly, the respective tests of the surface hardness, the TMA (Tg, linear expansion coefficient), the moisture permeability and the water absorption coefficient were not substantially able to be carried out, and they were rated as unmeasurable in Table 12.

Blended with 100 parts of the above composition F7 was 2 parts of a gap controller of a glass short fiber of 6 µm, and it was subjected to the bonding-sealing test in the same manner as in Example 1. As a result, bleeding was not found, but production of bubbles through the seal (seal leak) was observed at a probability of a half or more. The sealant was fragile and easily broken in handling the cell, and none of the normal cells was obtained. Accordingly, it was judged that the single layer hot press aptitude was bad. The sealing durability test was not substantially able to be carried out, and therefore the result of the sealing durability test in Table 12 was rated as impossible to produce a cell.

Comparative Example 8

A composition for a liquid crystal display cell sealant (F8) was obtained in the same manner as in Example 1 according to the recipe shown in Table 11. The F8 composition is a composition comprising the epoxy resin, the esterified polyphenol resin curing agent, the silane coupling agent, the inorganic filler and the high boiling solvent, and as apparent from the physical properties as a sealant shown in Table 12, it is apparent that the F8 composition is markedly lacking in a hot curing property and a cell-forming property as is the case with the F3 composition prepared in Comparative Example 3.

In particular, a coated film of the sealant obtained in hot curing at 150°C for 90 minutes stayed in a substantially uncured state, and only the cured film which was fragile and easily broken was formed. The above coated film exhibited a property of dissolving and swelling in an acetone solvent. As the result described above, it is the largest problem that the F8 composition is lacking a hot curing property.

Blended with 100 parts of the composition for a liquid crystal display cell sealant (F8) was 5 parts of a gap controller of a glass short fiber having a size of 5 µm, and they were sufficiently mixed to obtain a composition. The resulting composition was screen-printed on the ITO substrate in a pattern comprising 4 one inch-size cells which were disposed vertically and horizontally two by two on a substrate to obtain the ITO substrate which was coated the sealant in a width of about 0.5 mm and a thickness of about 20 to 22 µm. Then, it was treated in a hot air drier of 120°C for 30 minutes and then put another ITO substrate which was to be paired, and after adjusting the position, they were temporarily bonded by means of a normal single layer hot press at a press pressure of 0.03 $MPa/cm^2$ and 250°C for 4 minutes. Then, it was put in succession in an oven heated at 200°C for 5 hours for full curing and bonding. This bonding test was repeatedly carried out ten times. As a result, inferior spots caused in sealing by bubbles through the seal (seal lack) and disturbed seal lines were observed at a probability of 60 %. Accordingly, it was confirmed that the single layer hot press aptitude was lacking. Further, the cell in which a sealing property was secured to some extent was subjected to the sealing durability test, but the result thereof was not satisfactory as shown in Table 12.

Comparative Example 9

A composition for a liquid crystal display cell sealant (F9) was obtained in the same manner as in Example 1 according to the recipe shown in Table 11. The F9 composition is a composition comprising the phosphazene compound (PZO) and the imidazole-epoxy adduct (PN-23), bath of which are curing accelerator, in the sum of 16 mass %. As apparent from the physical properties as a sealnt shown in Table 12, the cured matter thereof has a low water absorbing property and a low moisture permeability. On the other hand, it has a hard and fragile property and therefore has a problem on adhesion reliability.

Blended with 100 parts of the above composition (F9) was 2 parts of a gap controller of a glass short fiber of 6 µm, and it was subjected to the bonding-sealing test in the same manner as in Example 1. As a result, inferior gap and defective sealing were observed in many spots, and therefore it was confirmed that the cell-forming aptitude was lacking. Accordingly, the result of the sealing durability in Table 12 was rated as impossible to produce a cell.

Table 11

| | | Comparative Example | | | | | | |
|---|---|---|---|---|---|---|---|---|
| | | 3 | 4 | 5 | 6 | 7 | 8 | 9 |
| Sealant composition | Composition for liquid crystal display cell sealant | F3 | F4 | F5 | F6 | F7 | F8 | F9 |
| | Epoxy resin | | | | | | | |
| | Epotote YDCN | 16.9 | 16.9 | 16.9 | 20 | 0 | 20 | 20 |
| | Epomik R367 | 6 | 6 | 6 | 2 | 2 | 2 | 2 |
| | Epiclon EP830S | | | | | | 13 | 13 |
| | Rubber-dispersed epoxy resin | | | | | | | |
| | (a) | 18.8 | 18.8 | 18.8 | 15.5 | 15 | | |
| | Curing agent | | | | | | | |
| | PSM4261 | 2 | 2 | 2 | | | | |
| | FPI5136 | 17 | 17 | 17 | | | | |
| | Esterified PSM4261 | | | | 9.9 | 52 | 28.5 | 28.5 |
| | Curing accelerator | 100 | 100 | 100 | 100 | 100 | 100 | 100 |
| | 2E4MZ | | 2.1 | | | | | |
| | Triphenylphosphne | | | 2.1 | | | | |
| | PN-23 | | | | | | | 5 |
| | PZO | | | | 2 | 2 | | 11 |
| | Silane coupling agent | | | | | | | |
| | KBM403 | 1 | 1 | 1 | 0.9 | 0.9 | 0.9 | 1 |
| | Inorganic filler | | | | | | | |
| | MU120 | 1 | 1 | 1 | 2 | 3.1 | 2 | 2.5 |
| | SO-E1-6 | 16 | 16 | 16 | | | | |
| | CR-10 | | | | 30.7 | | 14.6 | |
| | Solvent | | | | | | | |
| | Methylcarbitol | 19.2 | 19.2 | 19.2 | 17 | 25 | 19 | 17 |
| Total | | 97.9 | 100.00 | 100 | 100.0 | 100.0 | 100.00 | 100.00 |

Table 12

| | Comparative Example | | | | | | |
|---|---|---|---|---|---|---|---|
| | 3 | 4 | 5 | 6 | 7 | 8 | 9 |
| Single layer hot press aptitude | Suited | Unenforceable | Unenforceable | Suited | Unsuited | Unsuited | Unsuited |
| Storage stability | ○ | × | △ | ○ | ○ | ○ | △ |
| Coating workability | ○ | × | × | ○ | ○ | ○ | × |
| B stage aptitude | ○ | × (+) | × (+) | Semi-cured × (-) | ○ | ○ | × (+) |
| Free ion | ◎ | ○ | ○ | ○ | ◎ | ◎ | ○ |
| Cured matter hardness | Uncured | ○ | ○ | × | Fragile, unmea-surable | Uncured | ○ |
| Storage elastic modulus in hot state | × (-) | ○ | ○ | × (-) | × (-) | × (-) | ○ |
| Moisture permeability 60°C/80°C | Unmea-surable | ◎/◎ | ◎/◎ | Unmea-surable | Fragile, unmea-surable | Unmea-surable | ◎/◎ |
| Water absorption coefficient 30 min | Unmea-surable | 1.1 | 1.2 | Unmea-surable | Fragile, unmea-surable | Unmea-surable | 0.28 |
| Water absorption coefficient 3 hrs | ↑ | 1.1 | 1.2 | | | ↑ | 0.29 |
| Water absorption coefficient 5 hrs | ↑ | 1.2 | 1.3 | | | ↑ | 0.3 |
| Tg | Unmea-surable | 115 | 117 | <10°C | Same as above | Unmea-surable | 139 |
| Curing initiation temperature | 135 | 28 | 39 | 85 | 75 | >200 | 45 |
| Exothermic initiation peak temperature | 247 | 132 | 145 | 158 | 158 | decomposed | 138 |

Table 12 (continued)

| Comparative Example No. | Comparative Example 3 | 4 | 5 | 6 | 7 | 8 | 9 |
|---|---|---|---|---|---|---|---|
| Linear expansion coefficient | Unmea-surable | 43 ppm | 44 ppm | >250 ppm | Fragile, unmea-surable | Unmea-surable | 66 ppm |
| Presence of disturbed seal line<br>Presence of through-bubbles/inferior sealing | None<br>None | None in sealant just after produced<br>None | None in sealant just after produced<br>None | None<br>Present | None<br>Present | Present<br>Present | Inferior gap<br>Inferior sealing |
| Peeling test of cell by wedge | Inferior curing | ○ | ○ | ○ | Inferior adhesion | Inferior curing | Inferior adhesion |
| Interaction with liquid crystal | ◎ | ○ | ◎ | ◎ | ◎ | ◎ | ◎ |
| Non-bleeding property test | ○ | ○ | ○ | ○ | △ | ○ | ◎ |
| Sealing durability test<br>250 hrs<br>500 hrs<br>1000 hrs | <br>×<br>-<br>- | <br>◎<br>○<br>△ | <br>◎<br>◎<br>○ | <br>×<br>-<br>- | Impossible to produce cell | <br>×<br>-<br>- | Impossible to produce cell |

Example 21

A composition for a liquid crystal display cell sealant (E21) of the present invention was obtained in the same manner as in Example 1 according to the recipe shown in Table 13.

The composition for a liquid crystal display cell sealant (E21) excluding the gap controller had an epoxy resin content of 29.44 %, a solvent content of 13.2 %, a rubber-like polymer fine particle content of 8.26 %, an inorganic filler content of 18 %, a curing agent content of 27.8 %, a curing accelerator content of 2 % and a silane coupling agent content of 1.3 %.

The physical properties as a sealant of the composition for a liquid crystal display cell sealant (E21) are shown in Table 14.

The composition for a liquid crystal display cell sealant (E21) was used to carry out the bonding-sealing test in the same manner as in Example 1, and the results of the bonding-sealing test and the sealing durability test were shown in Table 14. It was confirmed that the resulting cell exhibited partial cohesive failure of the sealnt in the peeling test of cell by wedge and had good adhesion reliability. Further, the display function was good after 1000 hours passed in the sealing function durability test.

Example 22

A composition for a liquid crystal display cell sealant (E22) of the present invention was obtained in the same manner as in Example 1 according to the recipe shown in Table 13.

The composition for a liquid crystal display cell sealant (E22) excluding the gap controller had an epoxy resin content of 21.1 %, a rubber-like polymer fine particle content of 6.9 %, an inorganic filler content of 25.5 %, a curing agent content of 24.5 %, a curing accelerator content of 1.5 %, a silane coupling agent content of 2 % and a solvent content of 18.5 %.

The physical properties as a sealant of the composition for a liquid crystal display cell sealant (E22) are shown in Table 14.

The composition for a liquid crystal display cell sealant (E22) was used to carry out the bonding-sealing test in the same manner as in Example 1, and the results of the bonding-sealing test and the sealing durability test were shown in Table 14. It was confirmed that the resulting cell exhibited complete cohesive failure of the sealant in the peeling test of cell by wedge and was excellent in adhesion reliability. Further, the display function was good after 1000 hours passed in the sealing function durability test.

Example 23

A composition for a liquid crystal display cell sealant (E23) of the present invention was obtained in the same manner as in Example 1 according to the recipe shown in Table 13.

The composition for a liquid crystal display cell sealant (E23) excluding the gap controller had an epoxy resin content of 22.5 %, a rubber-like polymer fine particle content of 7.5 %, an inorganic filler content of 24.5 %, a curing agent content of 23 %, a curing accelerator content of 2 %, a silane coupling agent content of 2.5 % and a solvent content of 18 %.

The physical properties as a sealant of the composition for a liquid crystal display cell sealant (E23) are shown in Table 14.

The composition for a liquid crystal display cell sealant (E23) was used to carry out the bonding-sealing test in the same manner as in Example 1, and the results of the bonding-sealing test and the sealing durability test were shown in Table 14. It was confirmed that the resulting cell exhibited partial cohesive failure of the sealant in the peeling test of cell by wedge and had good adhesion reliability. Further, the display function was good after 1000 hours passed in the sealing function durability test.

Example 24

A composition for a liquid crystal display cell sealant (E24) of the present invention was obtained in the same manner as in Example 1 according to the recipe shown in Table 13.

The composition for a liquid crystal display cell sealant (E24) excluding the gap controller had an epoxy resin content of 22.5 %, a rubber-like polymer fine particle content of 7.5 %, an inorganic filler content of 24.5 %, a curing agent content of 23 %, a curing accelerator content of 2 %, a silane coupling agent content of 2.5 % and a solvent content of 18 %.

The physical properties as a sealant of the composition for a liquid crystal display cell sealant (E24) are shown in Table 14.

The composition for a liquid crystal display cell sealant (E24) was used to carry out the bonding-sealing test in the same manner as in Example 1, and the results of the bonding-sealing test and the sealing durability test were shown in Table 14. It was confirmed that the resulting cell exhibited partial cohesive failure of the in the peeling test of cell by wedge and had good adhesion reliability. Further, the display function was good after 1000 hours passed in the sealing function durability test.

Example 25

A composition for a liquid crystal display cell sealant (E25) of the present invention was obtained in the same manner as in Example 1 according to the recipe shown in Table 13.
The composition for a liquid crystal display cell sealant (E25) excluding the gap controller had an epoxy resin content of 22.5 %, a rubber-like polymer fine particle content of 7.5 %, an inorganic filler content of 24.5 %, a curing agent content of 23 %, a curing accelerator content of 2 %, a silane coupling agent content of 2.5 % and a solvent content of 18 %.
The physical properties as a sealant of the composition for a liquid crystal display cell sealant (E25) are shown in Table 14.
The composition for a liquid crystal display cell sealant (E25) was used to carry out the bonding-sealing test in the same manner as in Example 1, and the results of the bonding-sealing test and the sealing durability test were shown in Table 14. It was confirmed that the resulting cell showed partial cohesive failure of the sealant in the peeling test of cell by wedge and had good adhesion reliability. Further, the display function was good after 1000 hours passed in the sealing function durability test.

Example 26

A composition for a liquid crystal display cell sealant (E26) of the present invention was obtained in the same manner as in Example 1 according to the recipe shown in Table 13.
The composition for a liquid crystal display cell sealant (E26) excluding the gap controller had an epoxy resin content of 37.2 %, a rubber-like polymer fine particle content of 7.8 %, an inorganic filler content of 21.3 %, a curing agent content of 29 %, a curing accelerator content of 3.2 % and a silane coupling agent content of1.5 %.
The physical properties as a sealant of the composition for a liquid crystal display cell sealant (E26) are shown in Table 14.
The composition for a liquid crystal display cell sealant (E26) was used to carry out the bonding-sealing test in the same manner as in Example 1, and the results of the bonding-sealing test and the sealing durability test were shown in Table 14. It was confirmed that the resulting cell exhibited partial cohesive failure of the sealant in the peeling test of cell by wedge and was excellent in adhesion reliability. Further, the display function was good after 1000 hours passed in the sealing function durability test.

Example 27

Added to 100 parts of the composition for a liquid crystal display cell sealant (E5) of the present invention prepared in Example 5 was 5.28 parts of conductive beads of a brand name "Micropearl AU-205" manufactured by Sekisui Fine Chemical Co., Ltd. to obtain a composition (E27).
The physical properties as a sealant of the composition for a liquid crystal display cell sealant (E27) are shown in Table 14.
The composition for a liquid crystal display cell sealant (E27) was used to carry out the bonding-sealing test in the same manner as in Example 1, and the results of the bonding-sealing test and the sealing durability test were shown in Table 14. It was confirmed that the resulting cell exhibited partial cohesive failure of the sealant in the peeling test of cell by wedge and was excellent in adhesion reliability. Further, the display function was good after 1000 hours passed in the sealing function durability test.
The measurement result of the anisotropic conductivity is shown together in Table 14, and it was confirmed that both the anisotropic conductivity and the adhesion aptitude in sealing were excellent.

Example 28

Added to 100 parts of the composition for a liquid crystal display cell sealant (E12) of the present invention prepared in Example 12 was 7.52 parts of the conductive beads of a brand name "Micropearl AU-205" manufactured by Sekisui Fine Chemical Co., Ltd. to obtain a composition (E28).
The physical properties as a sealant of the composition for a liquid crystal display cell sealant (E28) are shown

in Table 14.

The composition for a liquid crystal display cell sealant (E28) was used to carry out the bonding-sealing test in the same manner as in Example 1, and the results of the bonding-sealing test and the sealing durability test were shown in Table 14. It was confirmed that the resulting cell exhibited partial cohesive failure of the sealant in the peeling test of cell by wedge and was excellent in adhesion reliability. Further, the display function was good after 1000 hours passed in the sealing function durability test.

The measurement result of the anisotropic conductivity is shown together in Table 14, and it was confirmed that both the anisotropic conductivity and the adhesion aptitude in sealing were excellent.

Table 13

| | | Example | | | | | | | |
|---|---|---|---|---|---|---|---|---|---|
| | | 21 | 22 | 23 | 24 | 25 | 26 | 27 | 28 |
| Sealant composition | Composition for liquid crystal display cell sealant | E21 | E22 | E23 | E24 | E25 | E26 | E27 | E28 |
| | Epoxy resin | | | | | | | | |
| | EPA-005 | 15.9 | | | | | | E5/ 100 parts | E5/ 100 parts |
| | 1,6-HGDE | | | | | | 13 | | |
| | t-BPMG | | | | | | 6 | | |
| | Epotote YDCN702 | | 3 | 2 | 2 | 2 | | | |
| | Sumika ELM-100 | | 2 | 3 | 3 | 3 | | | |
| | Rubber-dispersed epoxy resin | | | | | | | | |
| | (a) | 21.8 | | | | | | | |
| | (b) | | 23 | 25 | 25 | 25 | 26 | | |
| | Curing agent | | | | | | | | |
| | NN | | | | | | 14.5 | | |
| | DC-NA | | | 3.5 | | | | | |
| | CH-NA | | | 3.5 | | | | | |
| | Esterified PSM4261 | | | 16 | 16 | 16 | | | |
| | Esterified NA | 18 | | | | | | | |
| | Esterified NN | 9.8 | | | | | | | |
| | Esterified DCN (dcpg-modified novolak) | | 4 | | | | | | |
| | Esterified CHNA | | 4 | | | | | | |
| | Esterified CHN | | 16.5 | | | | | | |
| | Esterified OP | | | | 2 | | | | |
| | Esterified SP | | | | 5 | | | | |
| | Esterified S1 | | | | | 3.5 | | | |
| | Esterified CBA | | | | | 3.5 | | | |
| | FPI5136 | | | | | | 14.5 | | |

Table 13 (continued)

| | | Example | | | | | | | |
|---|---|---|---|---|---|---|---|---|---|
| | | 21 | 22 | 23 | 24 | 25 | 26 | 27 | 28 |
| Sealant composition | Curing accelerator | | | | | | | | |
| | 5302T | | | 1 | 1 | 1 | 3 | | |
| | PZO | 2 | 1.5 | 1 | 1 | 1 | 0.2 | | |
| | Silane coupling agent | | | | | | | | |
| | Y9030 | | | | | | 1.5 | | |
| | KBM403 | 1.3 | 2 | 2.5 | 2.5 | 2.5 | | | |
| | Inorganic filler | | | | | | | | |
| | UA-5105 | 10 | | | | | | | |
| | MU120 | 2 | 1 | 2.5 | 2.5 | 2.5 | 1.3 | | |
| | SO-A800 | 6 | | | | | | | |
| | SO-A805 | | 14.5 | 20 | 20 | 20 | 20 | | |
| | CR125 | | | 2 | 2 | 2 | | | |
| | CR-10 | | | | | | | | |
| | CR-10-3 | | 10 | | | | | | |
| | Solvent | | | | | | | | |
| | Methylcarbitol | 13.2 | | | | | | | |
| | Glycosolve DM | | 8.5 | | | | | | |
| | PGDA | | 10 | | | | | | |
| | PGMEA | | | 18 | 18 | 18 | | | |
| | Conductive beads | | | | | | | | |
| | Micropearl AU-205 | | | | | | | 5.26 parts | 7.52 parts |
| | Subtotal | 100.0 | 100.0 | 100.0 | 100.0 | 100.0 | 100.0 | 105.26 parts | 107.52 parts |
| | Gap controller | | | | | | | | |
| | 6 μm glass short fiber | 2 | 2 | 2 | 2 | 2 | 2 | | |
| Total | | 102 | 102 | 102 | 102 | 102 | 102 | 105.26 parts | 107.52 parts |

Note: Micropearl AU-205

Manufactured by Sekisui Fine Chemical Co. Ltd., gold-plated polystyrene beads/average particle diameter 5μm; maximum particle diameter 6.5μm; minimum particle diameter 4μm

Table 14

| | Example | | | | | | | |
|---|---|---|---|---|---|---|---|---|
| | 21 | 22 | 23 | 24 | 25 | 26 | 27 | 28 |
| Single layer hot press aptitude | Suited | Suited | Suited | Suited | Suited | Suited | Suited | Suited |
| Storage stability | ○ | ○ | ○ | ○ | ○ | ○ | ○ | ○ |
| Coating workability | △ | △ | △ | ○ | ○ | ○ | ○ | ○ |
| B stage aptitude | ◎ | ◎ | ◎ | ◎ | ◎ | ○ | ○ | ○ |
| Free ion | ◎ | ◎ | ◎ | ◎ | ◎ | ◎ | ◎ | ◎ |
| Cured matter hardness | ◎ | ○ | ◎ | ◎ | ◎ | ○ | ◎ | ○ |
| Storage elastic modulus in hot state | ○ | ○ | ○ | ○ | ○ | ○ | ○ | ○ |
| Moisture permeability 60°C/80°C | ◎/◎ | ◎/◎ | ○/◎ | ○/◎ | ○/○ | ○/○ | ○/○ | ◎/◎ |
| Water absorption coefficient 30 min | 0.26 | 0.21 | 0.56 | 0.41 | 0.39 | 0.48 | 1.42 | 0.44 |
| Water absorption coefficient 3 hrs | 0.27 | 0.22 | 0.58 | 0.43 | 0.4 | 0.49 | 1.33 | 0.43 |
| Water absorption coefficient 5 hrs | 0.27 | 0.22 | 0.6 | 0.43 | 0.41 | 0.5 | 1.32 | 0.42 |
| Tg | 148 | 120 | 139 | 146 | 145 | 137 | 127 | 145 |
| Curing initiation temperature | 57 | 63 | 54 | 73 | 73 | 75 | 101 | 57 |
| Exothermic initiation peak temperature | 151 | 155 | 148 | 160 | 159 | 161 | 161 | 151 |
| Linear expansion coefficient | 42 ppm | 48 ppm | 45 ppm | 42 ppm | 43 ppm | 44 ppm | 45 ppm | 51 ppm |

Table 14 (continued)

| | Example | | | | | | | |
|---|---|---|---|---|---|---|---|---|
| | 21 | 22 | 23 | 24 | 25 | 26 | 27 | 28 |
| Bonding-sealing test<br>Presence of disturbed seal line<br>Presence of through-bubbles/ inferior sealing | None<br>None | None<br>None | None<br>None | None<br>None | None<br>None | None<br>None | None<br>None | None<br>None |
| Peeling test of cell by wedge | ○ | ◎ | ○ | ○ | ○ | ○ | ◎ | ◎ |
| Interaction with liquid crystal | ◎ | ◎ | ◎ | ◎ | ◎ | ◎ | ◎ | ◎ |
| Non-bleeding property test | ◎ | ◎ | ◎ | ○ | ○ | ○ | ○ | ○ |
| Sealing durability test<br>250 hrs<br>500 hrs<br>1000 hrs | <br>◎<br>◎<br>◎ | <br>◎<br>◎<br>◎ | <br>◎<br>◎<br>◎ | <br>◎<br>◎<br>○ | <br>◎<br>◎<br>○ | <br>◎<br>◎<br>◎ | <br>◎<br>◎<br>◎ | <br>◎<br>◎<br>◎ |
| Vertical conductivity<br>Anisotropic conductivity | None<br>None | None<br>None | None<br>None | None<br>None | None<br>None | None<br>None | <1 Ω<br>Good | <1 Ω<br>Good |

It is apparent that the composition for a liquid crystal display cell sealant of the present invention has the characteristics that the water absorption coefficient determined after dipping the cured matter in boiling water for 30 minutes is as low as 2 % or less as apparent in Example 1 to Example 28. Further,

1. the storage stability and the coating workability are good,
2. the temporary bonding property after pre-curing is high,
3. the composition is suited to bonding by a single layer hot press, and is excellent in the non-bleeding property, the non-seal leak property, linearity of the seal lines and the accurate gap width-controlling property,
4. the adhesion reliability is excellent,
5. the cured matter thereof is excellent in a low moisture permeability at 80°C,
6. the presence of electroconductive ions to be transferred from the composition is controlled low, and therefore
7. the bonding durability at a high temperature and long time display stability of the resulting liquid crystal display cell under a high temperature and high humidity environment can be secured.

In particular, it is apparent that a liquid crystal display element produced by using the composition for a liquid crystal display cell sealant of the present invention has high functionality in which sealing function durability exceeds 1000 hours.

On the other hand, as apparent in Comparative Example 1 or Comparative Example 2, the composition for a liquid crystal display cell sealant containing a lot of free ions is lacking in display function durability, and the epoxy resin composition comprising dihydrazide as a principal curing agent has the problem that it has a high water absorption coefficient exceeding 2 %. Further, Comparative Example 3 is an example in which the curing accelerator according to the present invention is not added as a component of the composition for a liquid crystal display cell sealant of the present invention, and only the non-cured or fragile cured matter can be obtained. Further, Comparative Example 4 is an example in which 2-ethyl-4-methylimidazole well known as a curing accelerator is used, and the sealant thereof is lacking in a pot life aptitude and has a fatal problem on coating workability. Further, Comparative Example 5 is an example in which triphenylphosiphine well known as a curing accelerator is used, and it has been apparent that as is the case with Comparative Example 4, the pot life is very short and it has a fatal problem on coating workability.

Comparative Example 6 or Comparative Example 7 is an example in which a blending amount of the curing agent is too small or too large, and it is apparent that inferior curing or inferior adhesion is shown in both cases and that they are not substantially suited to production of a liquid crystal display cell. Further, Comparative Example 8 or Comparative Example 9 is an example in which the curing agent is not added or added in an excess amount, and it is apparent that the former is inferior in curing and lacking in an adhesive property and that the latter provides only a hard and fragile cured matter and is notably lacking in a gap-controlling property and an adhesion-providing property.

That is, a liquid crystal display element using the sealant for a liquid crystal display cell of the present invention or a liquid crystal display element produced using the composition for a liquid crystal display cell sealant is characterized in that long time display stability can be secured under high temperature and high humidity environment.

Industrial applicability

The composition for a liquid crystal display cell sealant of the present invention makes it possible to produce a liquid crystal display panel which maintains stably functions of a liquid crystal display element for a long period of time even under high temperature and high humidity environment and can meet a single layer type press adhesion method. A liquid crystal display element produced using this can preferably be used as a display used for watches, desk-top calculators, TV sets, cellular phones, various mobile appliances, personal computers, electronic notebooks, vehicles and the like.

Applicability of the composition for a liquid crystal display cell sealant of the present invention having an anisotropic conductive function includes, for example, an anisotropic conductive adhesive or an anisotropic conductive film which electrically connects between a metal terminal on a finely processed circuit board and a semiconductor element and between fine metal terminals on an IC-loaded board thereof. Further, it can widely be used as a sealant for forming an organic EL element, a sealant for forming a flat panel display using an in·brain type electrophoretic system, a sealant for forming a paper-like display using film type liquid crystal, a sealant for producing an organic solar battery panel, an electrical insulating coating material and the like.

## Claims

**1.** A sealant for a liquid crystal display cell comprising a cured matter of a composition for a liquid crystal display cell sealant, wherein said cured matter has a water absorption coefficient of 2 mass % or less.

**2.** The sealant for a liquid crystal display cell as described in claim 1, wherein the moisture permeability in passing through the cured film having a thickness of 100 μm at 80°C is 200 g/$m^2$·24 hours or less.

**3.** The sealant for a liquid crystal display cell as described in claim 1 or 2, wherein the liquid crystal brought into contact with the sealant at 145°C for one hour in a proportion of one mass part of the liquid crystal to 0.1 mass part of the sealant has a specific resistance value which is 250 times or less as large as a specific resistance value of the liquid crystal before brought into contact therewith.

**4.** The sealant for a liquid crystal display cell as described in claims 1 to 3, which comprises a cured matter of an epoxy resin cured with a curing agent comprising at least one selected from polyphenol compounds, polyphenol resins and esterified products thereof.

**5.** The sealant for a liquid crystal display cell as described in claim 4, wherein a curing accelerator comprising at least one selected from alkylurea derivatives and phosphazene compounds is used.

**6.** A composition for a liquid crystal display cell sealant comprising an epoxy resin (1), a curing agent (2) comprising at least one selected from polyphenol compounds, polyphenol resins and esterified products thereof and a curing accelerator (3) comprising at least one selected from alkylurea derivatives and phosphazene compounds.

**7.** The composition for a liquid crystal display cell sealant as described in claim 6, comprising 20 to 88.9 mass parts of the epoxy resin (1), 10 to 50 mass parts of the curing agent (2) comprising at least one selected from polyphenol compounds, polyphenol resins and esterified products thereof and 0.1 to 20 mass parts of the curing accelerator (3) comprising at least one selected from alkylurea derivatives and phosphazene compounds.

**8.** The composition for a liquid crystal display cell sealant as described in claim 6 or 7, wherein an aqueous solution obtained by admixing the composition with the same mass of purified water as that of the composition has an ionic conductivity of 1 mS/m or less.

**9.** The composition for a liquid crystal display cell sealant as described in claim 6 or 7, wherein a cured matter of the composition has a water absorption coefficient of 2 mass % or less.

**10.** The composition for a liquid crystal display cell sealant as described in claim 6 or 7, wherein a moisture permeability in passing through a cured film of the composition having a thickness of 100 μm at 80°C is 200 g/$m^2$·24 hours or less.

**11.** The composition for a liquid crystal display cell sealant as described in claim 6 or 7, wherein the liquid crystal brought into contact with the sealant at 145°C for one hour in a proportion of one mass part of the liquid crystal to 0.1 mass part of the sealant has a specific resistance value which is 250 times or less as large as a specific resistance value of the liquid crystal before brought into contact therewith.

**12.** The composition for a liquid crystal display cell sealant as described in claim 6 or 7, further comprising a rubber-like polymer fine particle which has a softening point of 0°C or lower and in which primary particles thereof have an average particle diameter of 5 μm or less in a proportion of 1 to 25 mass % based on the composition for a liquid crystal display cell sealant.

**13.** The composition for a liquid crystal display cell sealant as described in claim 6 or 7, wherein the curing agent is at least one selected from phenol novolak resins, phenol aralkyl resins, naphthol novolak resins, naphthol aralkyl resins, alicyclic compound-modified phenol novolak resins, alicyclic compound-modified naphthol novolak resins, polycyclic aromatic compound-modified novolak resins, polyphenol monomers, polyvinylphenols, vinylphenol copolymers, polyisopropenylphenols, polyisopropenylphenol copolymers, esterified phenol novolak resins, esterified phenol aralkyl resins, esterified naphthol novolak resins, esterified naphthol aralkyl resins, esterified alicyclic compound-modified phenol novolak resins, esterified alicyclic compound-modified naphthol novolak resins, esterified polycyclic aromatic compound-modified novolak resins, esterified polyphenol monomers, esterified polyvinylphenols, esterified vinylphenol copolymers, esterified polyisopropenylphenols and esterified polyisopropenylphenol copolymers.

**14.** The composition for a liquid crystal display cell sealant as described in claim 6 or 7, wherein the alkylurea derivative is at least one selected from 3-(p-chlorophenyl)-1,1-dimethylurea, 3-(o,p-dichlorophenyl)-1,1-dimethylurea, 2,4-[bis(1,1-dimethylurea)]toluene and 2,6-[bis(1,1-dimethylurea)]toluene.

**15.** The composition for a liquid crystal display cell sealant as described in claim 6 or 7, wherein the phosphazene compound is at least one compound represented by Formula (12):

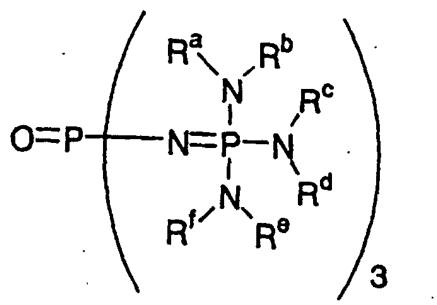

(12)

wherein $R^a$ to $R^f$ each represent a hydrogen atom, a linear, branched or cyclic alkyl group having 1 to 10 carbon atoms or an aryl or aralkyl group having 6 to 10 carbon atoms, and all of them may be the same or different.

**16.** A composition for a liquid crystal display cell sealant further comprising 1 to 15 mass parts of a conductive bead based on 100 mass parts of the composition as described in claim 6 or 7.

**17.** A liquid crystal display element prepared by using the sealant for a liquid crystal display cell as described in any of claims 1 to 5.

**18.** A liquid crystal display element obtained by using the composition for a liquid crystal display cell sealant as described in any of claims 6 to 16.

**19.** A production process for a liquid crystal display element comprising any of TN liquid crystal, STN liquid crystal, ferrodielectric liquid crystal and anti-ferrodielectric liquid crystal, comprising the steps of:

printing or dispenser-coating the composition for a liquid crystal display cell sealant as described in any of claims 6 to 16 on a bonding and sealing part of a glass-made or plastic-made substrate for a liquid crystal cell and precuring it at a temperature of 50 to 120°C,
then adjusting the position and superposing the other paired substrate thereon to temporarily fix them,
subjecting the paired substrates to hot cramping treatment at 80 to 200°C to bond and fix the above paired substrates in a homogeneous thickness falling in a range of 1 to 7 μm to form a liquid crystal display cell, and
then charging a liquid crystal material into the above cell and sealing the injection port with a photocuring type liquid crystal sealant composition or a two-liquid type liquid crystal sealant composition.

**20.** A production process for a liquid crystal display element comprising any of TN liquid crystal, STN liquid crystal, ferrodielectric liquid crystal and anti-ferrodielectric liquid crystal, comprising the steps of:

printing or dispenser-coating the composition for a liquid crystal display cell sealant as described in any of claims 6 to 16 on a bonding and sealing part of a glass-made or plastic-made substrate for a liquid crystal cell and precuring it at a temperature of 50 to 120°C,
then putting dropwise the liquid crystal thereon and superposing the other paired substrate thereon so that air is not shut therein and adjusting the position to temporarily fix them,
subjecting the paired substrates to hot cramping treatment at 80 to 150°C to bond and fix the above paired substrates in a homogeneous thickness falling in a range of 1 to 7 μm, and
then sealing the respiratory port with a photocuring type liquid crystal sealant composition or a two-liquid type liquid crystal sealant composition.

**21.** A liquid crystal display element obtained by the production process for a liquid crystal display element as described in claim 19 or 20.

## INTERNATIONAL SEARCH REPORT

International application No.
PCT/JP00/08814

A. CLASSIFICATION OF SUBJECT MATTER
Int.Cl$^7$ C08G59/62, C08G59/40, C08L63/00, G02F1/1339

According to International Patent Classification (IPC) or to both national classification and IPC

B. FIELDS SEARCHED

Minimum documentation searched (classification system followed by classification symbols)
Int.Cl$^7$ C08G59/62, C08G59/40, C08L63/00-10, G02F1/1339

Documentation searched other than minimum documentation to the extent that such documents are included in the fields searched

Electronic data base consulted during the international search (name of data base and, where practicable, search terms used)
WPI/L

C. DOCUMENTS CONSIDERED TO BE RELEVANT

| Category* | Citation of document, with indication, where appropriate, of the relevant passages | Relevant to claim No. |
|---|---|---|
| A | JP, 07-109405, A (Mitsui Toatsu Chemicals Inc.), 25 April, 1995 (25.04.95), Claims; Par. Nos. [0009] to [0010] (Family: none) | 1-21 |
| A | JP, 11-246743, A (Mitsui Chemicals, Ltd.), 14 September, 1999 (14.09.99), Claims (Family: none) | 1-21 |
| A | JP, 11-326923, A (Ricoh Company, Ltd.), 26 November, 1999 (26.11.99), Claims; Par. No. [0028] (Family: none) | 1-21 |
| A | EP, 839820, A2 (Daimler-Benz Aktiengesellschaft), 06 May, 1998 (06.05.98), Claims & JP, 10-168428, A Claims | 1-21 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 March, 2001 (06.03.01) | 13 March, 2001 (13.03.01) |
| Name and mailing address of the ISA/ Japanese Patent Office | Authorized officer |
| Facsimile No. | Telephone No. |

Form PCT/ISA/210 (second sheet) (July 1992)